# EUROPEAN PATENT APPLICATION

(11) **EP 4 675 357 A1**
(43) Date of publication of application: **07.01.2026**
(21) Application number: 25185205.9
(22) Date of filing: 25.06.2025
(51) Int. Cl.: G03F 7/09, C08F 220/32

(54) **COMPOSITION FOR FORMING RESIST UNDERLAYER FILM, PATTERNING PROCESS, AND RESIST UNDERLAYER FILM FORMATION PROCESS**

(30) Priority: 02.07.2024 JP 2024107048
(71) Applicant: Shin-Etsu Chemical Co., Ltd., Tokyo 100-0005 (JP)
(72) Inventor: Kobayashi, Naoki, Niigata (JP); Kori, Daisuke, Niigata (JP); Yano, Toshiharu, Niigata (JP)
(74) Representative: Schicker, Silvia

(57) **Abstract**

An object of the present invention is to provide a composition for forming a resist underlayer film, which serves as an antireflective film and which has excellent resistance to alkaline hydrogen peroxide water and favorable filling/planarization characteristics and dry etching characteristics, as well as a patterning process and a resist underlayer film formation process each using the composition. A composition for forming a resist underlayer film, the composition including: (A) a polymer compound having a structural unit (a1) represented by the following formula (A-1) and at least one structural unit (a2) selected from structural units represented by the following formulae (A-2) to (A-4); (B) a crosslinking agent represented by the following formula (B-1); and (C) an organic solvent.

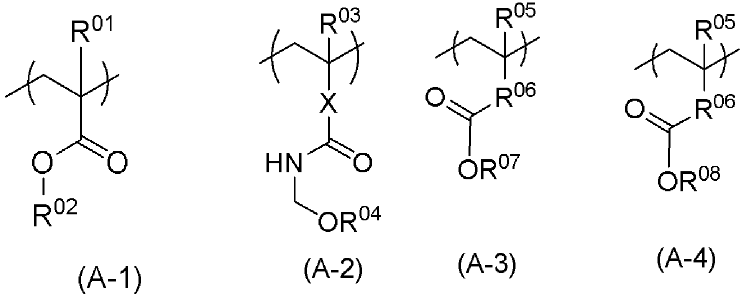

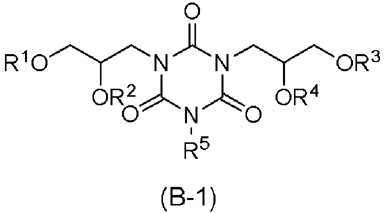

## Description

### TECHNICAL FIELD

The present invention relates to a composition for forming a resist underlayer film, for use in fine patterning by a multi-layer resist process in a process for manufacturing a semiconductor device, as well as a patterning process and a resist underlayer film formation process each using the composition for forming a resist underlayer film.

### BACKGROUND ART

Microfabrication by lithography using photoresists is performed in manufacturing of semiconductor devices. Such microfabrication is a processing process in which a photoresist thin film is formed on a semiconductor substrate such as a silicon wafer, irradiated with active light such as ultraviolet light with a mask pattern on which a device pattern is drawn, and developed to provide a photoresist pattern, and the substrate is subjected to etching treatment using the obtained photoresist pattern as a protective film, to form fine concavity and convexity corresponding to the pattern, on a surface of the substrate. Meanwhile, in recent years, high integration of devices has progressed and exposure light used has also been likely to be shortened in wavelength from KrF excimer lasers

(wavelength 248 nm) to ArF excimer lasers (wavelength 193 nm). However, the photolithography process causes the problem of reducing the dimension accuracy of the photoresist pattern by the influence of standing waves due to reflection of exposure light from the substrate and/or the influence of diffuse reflection of exposure light due to a stepped section on the substrate. In order to solve the problem, there is widely studied a process which imparts the function of an antireflective film (Bottom Anti-Reflective Coating, BARC) to a resist underlayer film provided between a photoresist and a substrate.

The resist underlayer film is often formed with a thermally crosslinkable composition in order to prevent intermixing with a photoresist to be applied thereon. As a result, the resist underlayer film formed is insoluble in an alkaline developer for use in photoresist development. Therefore, removal of an antireflective film prior to semiconductor substrate processing is needed to be performed by dry etching (for example, Patent Document 1).

However, a photoresist is also removed by dry etching at the same time of such removal of a resist underlayer film by dry etching. Therefore, a problem caused is that the thickness of a photoresist necessary for substrate processing is difficult to ensure. This problem is an important problem in particular when a photoresist for a thin film is used for the purpose of an enhancement in resolution. Therefore, there is a need for a resist underlayer film having a higher dry etching rate than a photoresist film.

An ion implantation step in semiconductor device manufacturing is a step of introducing an impurity into a semiconductor substrate, using a photoresist pattern as a template. The photoresist pattern used as a template in the ion implantation step has been heretofore wide in line width of the pattern and less affected by standing waves due to reflection of exposure light from a substrate and/or less affected by diffuse reflection of exposure light due to a stepped section on the substrate, and thus the problem due to reflection has been solved by using an antireflective film as a dye-containing photoresist or an upper layer of the photoresist (Patent Document 2). However, according to recent miniaturization, a photoresist for use in an ion implantation step has also been beginning to be needed to have a fine pattern and an antireflective film of a photoresist underlayer has been increasingly needed.

On the other hand, in recent years, manufacturing of a semiconductor device having a new structure such as a multigate structure has been actively studied, and accordingly a resist underlayer film has been increasingly demanded to have excellent planarization characteristics and filling characteristics equal to or more than conventional characteristics. For example, when an underlying substrate to be processed has a fine pattern structure body such as a hole, a trench, or a fin, the property of filling a pattern with a resist underlayer film without any gap (gap-filling) is needed. When the underlying substrate to be processed has a stepped section, or when a pattern dense portion and a pattern-free region are present on the same wafer, a film surface is needed to be planarized (planarization) with a resist underlayer film. An underlayer film surface can be planarized to suppress a variation in thickness of a resist middle layer film or a resist upper layer film formed thereon, and suppress a reduction in focus margin in lithography or margin in a subsequent processing step of a substrate to be processed. Furthermore, substrate processing by wet etching using a chemical reagent may also be needed, and in such a case, a resist underlayer film serving as a processing mask is demanded to also have resistance to a wet etching liquid.

Here, the background of a demand for a material corresponding to a wet etching process in terms of a multi-layer resist process is described in detail. Technologies of three-dimensional transistors, through wiring, and the like are used for cutting-edge semiconductor devices in order to enhance performances of such semiconductor devices. Also in a patterning step for use in formation of a structure in the semiconductor device, patterning by the above multi-layer resist process is performed. For example, there is studied a process including wet etching a substrate to be processed such as titanium nitride with alkaline hydrogen peroxide water, using a resist underlayer film as an etching mask.

As a resist underlayer film material for manufacturing a semiconductor device, which has a high dry etching rate and which can planarize a stepped substrate, for example, Patent Document 3 proposes a material having a polymer compound such as polyglycidyl methacrylate. As a resist underlayer film material for manufacturing a semiconductor device, which has a high dry etching rate, Patent Document 4 proposes a material having a copolymer produced with (meth)acrylic acid, glycidyl (meth)acrylate, and the like as monomers, and Patent Document 5 proposes a material including a copolymer produced with hydroxypropyl methacrylate and the like as monomers, and a crosslinking agent. Patent Document 6 proposes a resin composition containing any of a phenolic hydroxyl group, a carboxyl group, a sulfonic acid group or a sulfonylamide acid group. However, these known materials have the problem of being insufficient in resistance to alkaline hydrogen peroxide water.

As a resist underlayer film material having resistance to alkaline hydrogen peroxide water, Patent Document 7 proposes a material including a polymer or the like having a carboxyl group protected with an epoxy group and a vinyl ether compound (acetal-protected ester). As a resist underlayer film having excellent dry etching characteristics, favorable resistance to alkaline hydrogen peroxide water, and excellent planarization characteristics, Patent Document 8 proposes a material including a polymer or the like having a carboxyl group protected with an epoxy group and a tertiary alkyl group. However, these known materials have the problems of being insufficient in planarization characteristics, being unsuitable for patterning of a substrate to be processed having concavity and convexity or a stepped section particularly highly demanded in a cutting-edge process, and being still insufficient also in resistance to alkaline hydrogen peroxide water in consideration of practicality.

As described above, there are demands for a resist underlayer film material for manufacturing a semiconductor device, which not only has an antireflective function and high suitability for a wet etching process (namely, resistance to alkaline hydrogen peroxide water), but also has favorable filling/planarization characteristics and dry etching characteristics, and a patterning process using the resist underlayer film material.

### CITATION LIST

### PATENT LITERATURE

Patent Document 1: US 6156479 A
Patent Document 2: JP 2008-197606 A
Patent Document 3: JP S61-180241 A
Patent Document 4: JP H06-118656 A
Patent Document 5: JP 2002-502982 A
Patent Document 6: JP 2009-098651 A
Patent Document 7: WO 2015/030060 A1
Patent Document 8: JP 2016-185999 A

### SUMMARY OF INVENTION

### TECHNICAL PROBLEM

The present invention has been made in view of the circumstances, and an object thereof is to provide a composition for forming a resist underlayer film, which serves as an antireflective film and which has excellent resistance to alkaline hydrogen peroxide water and favorable filling/planarization characteristics and dry etching characteristics, as well as a patterning process and a resist underlayer film formation process each using the composition.

### SOLUTION TO PROBLEM

To achieve the object, the present invention provides
a composition for forming a resist underlayer film, the composition including:
   (A) a polymer compound having a structural unit (a1) represented by the following formula (A-1) and at least one structural unit (a2) selected from structural units represented by the following formulae (A-2) to (A-4);
   (B) a crosslinking agent represented by the following formula (B-1); and
   (C) an organic solvent; 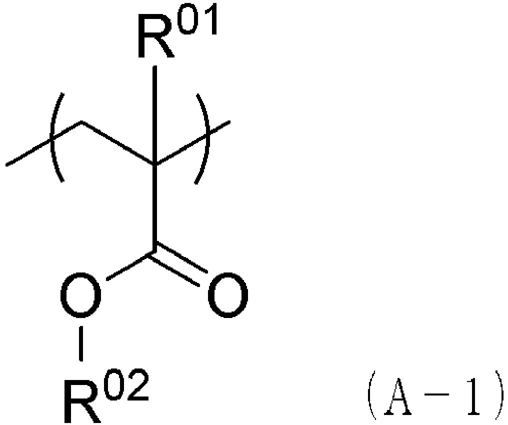
wherein R⁰¹ is a hydrogen atom or a methyl group, and R⁰² is a monovalent organic group containing a group selected from groups represented by the following formulae (R₂-1) to (R₂-3); 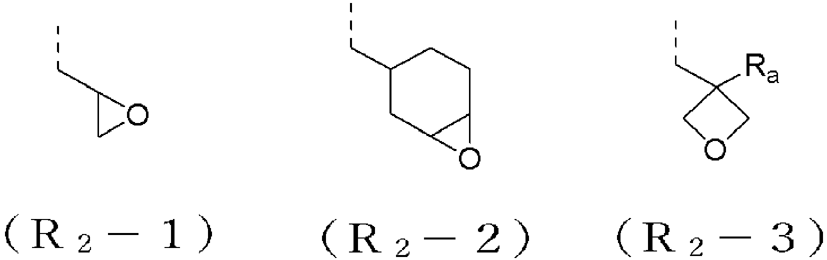
wherein Rₐ is a hydrogen atom or an alkyl group having 1 to 10 carbon atoms, and a dotted line represents a bond; 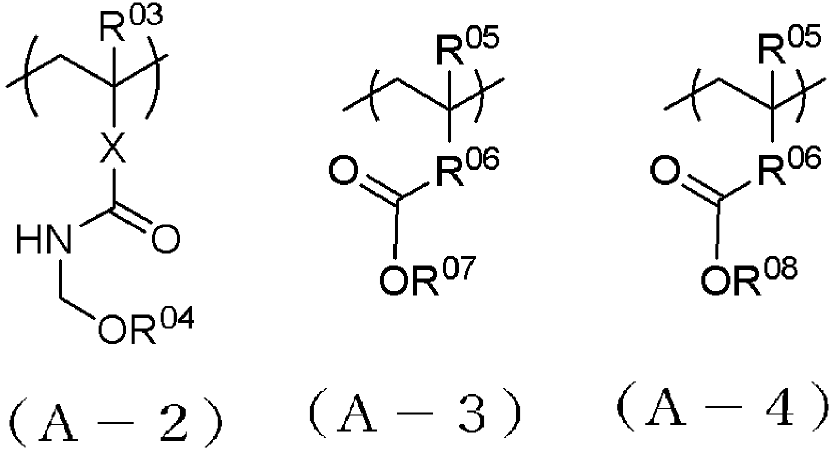
wherein, in the formula (A-2), X is an aromatic ring having 6 to 20 carbon atoms or a single bond, R⁰³ is a hydrogen atom or a methyl group, and R⁰⁴ is a hydrogen atom or a monovalent alkyl group having 1 to 10 carbon atoms and, when R⁰⁴ is the alkyl group, a hydrogen atom constituting the alkyl group is optionally replaced by a hydroxyl group; in the formula (A-3), R⁰⁵ is a hydrogen atom or a methyl group, R⁰⁶ is a single bond or a divalent linkage group containing an ester group and having 2 to 10 carbon atoms, and R⁰⁷ is a tertiary alkyl group having 4 to 20 carbon atoms or a tertiary alkenyl group having 5 to 20 carbon atoms; and in the formula (A-4), R⁰⁵ and R⁰⁶ have the same meanings as those in the formula (A-3), and R⁰⁸ is a hydrogen atom or a monovalent primary alkyl group having 1 to 10 carbon atoms; 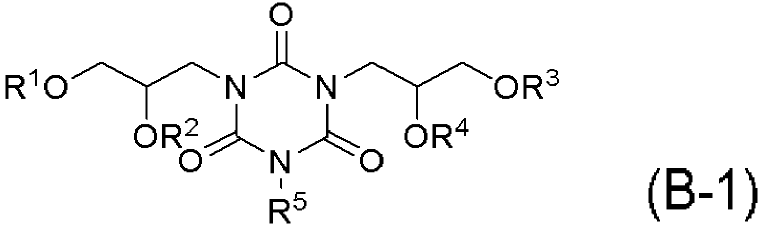
wherein R⁵ represents a methyl group, an ethyl group, a propyl group, an allyl group, a propargyl group or a group represented by the following (B-2), and R¹ and R³ each represent a benzoyl group, a toluoyl group, a naphthoyl group or an anthranoyl group; and R² and R⁴ each represent a hydrogen atom, an acetyl group, an acryloyl group or a methacryloyl group; and 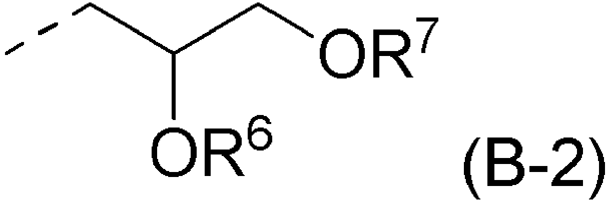
wherein R⁷ represents a benzoyl group, a toluoyl group, a naphthoyl group or an anthranoyl group; and R⁶ represents a hydrogen atom, an acetyl group, an acryloyl group or a methacryloyl group and, when R² and R⁴ are hydrogen atoms, R⁶ is also a hydrogen atom.

The composition for forming a resist underlayer film can have not only an antireflective function, but also favorable resistance to alkaline hydrogen peroxide water, excellent filling/planarization characteristics, and excellent dry etching characteristics.

Two or more of R¹, R³, and R⁷ in the formula (B-1) are each preferably a naphthoyl group or an anthranoyl group.

The composition for forming a resist underlayer film, including a crosslinking agent, can absorb exposure light such as a KrF excimer laser, and therefore can reduce the influence of standing waves due to reflection of exposure light from a substrate, or the influence of diffuse reflection of exposure light due to an stepped part on a stepped substrate, and can enhance the resolution in lithography of a resist upper layer film.

Any of R², R⁴, and R⁵ in the formula (B-1) preferably has an unsaturated bond which is not aromatic.

The composition for forming a resist underlayer film, including a crosslinking agent, can be enhanced in fluidity, and can have further excellent filling ability/planarization characteristics.

A content of the (B) crosslinking agent in the composition for forming a resist underlayer film is preferably in a range of 1 to 50 parts by mass based on 100 parts by mass of the (A) polymer compound.

The composition for forming a resist underlayer film, in which the content of the crosslinking agent is in this range, can have, in addition to an antireflective function, favorable resistance to alkaline hydrogen peroxide water, excellent filling/planarization characteristics, and excellent dry etching characteristics. In addition, the occurrence of a sublimate during heating and curing can be suppressed to suppress contamination of an apparatus by the sublimate. Furthermore, the occurrence of coating defects can be suppressed, and further excellent filling/planarization characteristics can be achieved.

The (A) polymer compound preferably has a structural unit (a1) represented by the formula (A-1) and at least two structural units (a2) selected from structural units represented by the formulae (A-2) to (A-4).

When the repeating unit is contained, etching characteristics, for example, the etching rate and a patterned shape after etching can be tailored to a customer demand without degradation of any optical characteristics of the composition for forming a resist underlayer film, including the polymer compound.

Preferably, a content rate of the structural unit (a1) is 20% by mol or more and 90% by mol or less and a content rate of a total amount of the structural units (a2) is 10% by mol or more and 80% by mol or less relative to all repeating units in the (A) polymer compound.

The content rates can allow the composition for forming a resist underlayer film, including the polymer compound as a base resin, to be further excellent in resistance to alkaline hydrogen peroxide water, thermal curing characteristics, filling/planarization characteristics, and dry etching characteristics.

A weight average molecular weight of the (A) polymer compound is preferably 1,000 to 20,000.

When the weight average molecular weight of the component (A) is 1,000 or more, not only film formability is favorable, but also there is no risk of contamination of an apparatus due to increase of a sublimate during heating and curing. When the weight average molecular weight is 20,000 or less, no coating defects occur and fluidity is also favorable, and therefore planarization/filling characteristics are also sufficient.

A dispersity represented by weight average molecular weight/number average molecular weight of the (A) polymer compound is preferably 3.0 or less.

When the dispersity of the polymer compound is in this range, excellent film formability is obtained, and the occurrence of a sublimate during heating and curing can be suppressed to prevent contamination of an apparatus.

The composition for forming a resist underlayer film of the present invention preferably contains at least one selected from (D) an acid generator and (E) a surfactant.

The above additive(s) can be added to the composition for forming a resist underlayer film of the present invention, in order to promote a crosslinking reaction due to heat or the like, and/or enhance coatability with spin coating, curability, planarization/filling characteristics, and the resolution during patterning in multi-layer lithography.

The composition for forming a resist underlayer film preferably provides a resist underlayer film exhibiting resistance to ammonia-containing hydrogen peroxide water.

The composition for forming a resist underlayer film can allow for formation of a resist underlayer film having favorable resistance to alkaline hydrogen peroxide water, and therefore can also be applied to a wet etching process using alkaline hydrogen peroxide water.

The present invention provides a patterning process on a substrate to be processed, the process including the steps of:
(I-1) applying the above-described composition for forming a resist underlayer film to the substrate to be processed, and thereafter performing heat treatment, to form a resist underlayer film;
(I-2) forming a resist upper layer film on the resist underlayer film using a composition for forming a resist upper layer film;
(I-3) subjecting the resist upper layer film to patten exposure and then development with a developer, to form a circuit pattern on the resist upper layer film; and
(I-4) transferring a pattern by dry etching to the resist underlayer film using a resist upper layer film on which the circuit pattern is formed as a mask.

The present invention also provides a patterning process on a substrate to be processed, the process including the steps of:
(II-1) applying the above-described composition for forming a resist underlayer film to the substrate to be processed, and thereafter performing heat treatment, to form a resist underlayer film;
(II-2) forming a silicon atom-containing resist middle layer film on the resist underlayer film;
(II-3) forming a resist upper layer film on the silicon atom-containing resist middle layer film using a composition for forming a resist upper layer film;
(II-4) subjecting the resist upper layer film to patten exposure and then development with a developer, to form a circuit pattern on the resist upper layer film;
(II-5) transferring a pattern by dry etching to the silicon atom-containing resist middle layer film using a resist upper layer film on which the circuit pattern is formed as a mask; and
(II-6) transferring a pattern by dry etching to the resist underlayer film using a silicon atom-containing resist middle layer film to which the pattern is transferred as a mask.

The present invention further provides a patterning process on a substrate to be processed, the process including the steps of:
(III-1) applying the above-described composition for forming a resist underlayer film to the substrate to be processed, and thereafter performing heat treatment, to form a resist underlayer film;
(III-2) forming an inorganic hard mask selected from a silicon oxide film, a silicon nitride film, and a silicon oxynitride film, on the resist underlayer film;
(III-3) forming an organic antireflective film on the inorganic hard mask;
(III-4) forming a resist upper layer film on the organic antireflective film using a composition for forming a resist upper layer film;
(III-5) subjecting the resist upper layer film to patten exposure and then development with a developer, to form a circuit pattern on the resist upper layer film;
(III-6) transferring a pattern by dry etching to the organic antireflective film and the inorganic hard mask using a resist upper layer film on which the circuit pattern is formed as a mask; and
(III-7) transferring a pattern by dry etching to the resist underlayer film using an inorganic hard mask to which the pattern is transferred as a mask.

Thus, the patterning process of the present invention can form a fine pattern by a multi-layer resist process (two-layer resist process, three-layer resist process, or four-layer resist process), and can form a resist underlayer film, to fill a stepped section on the substrate to be processed, and/or planarize the substrate to be processed.

The above-described patterning process can further have a step of transferring a pattern, by wet etching with alkaline hydrogen peroxide water, to the substrate to be processed using a resist underlayer film to which the pattern is transferred as a mask, after the step (I-4), the step (II-6), or the step (III-7).

The resist underlayer film formed using the composition for forming a resist underlayer film of the present invention has favorable resistance to alkaline hydrogen peroxide water, and therefore pattern transfer to the substrate to be processed can be performed by wet etching with alkaline hydrogen peroxide water as described above.

The above-described patterning process can have a step of performing an ion implantation using a resist underlayer film to which the pattern is transferred as a mask, to perform pattern-processing of the substrate to be processed, after the step (I-4), the step (II-6), or the step (III-7).

The patterning process is suitable particularly for ion implantation processing of a substrate having concavity and convexity on its surface.

A composition for forming a resist underlayer film having a dry etching rate higher than a dry etching rate of the resist upper layer film is preferably used as the composition for forming a resist underlayer film.

The composition for forming a resist underlayer film can be used to allow for removal of the resist underlayer film used as a mask, by dry etching, without any residue, and therefore a semiconductor device with few defects can be manufactured.

Here, a substrate which has a structure body or a stepped section having a height of 30 nm or more is preferably used as the substrate to be processed.

The resist underlayer film formed using the composition for forming a resist underlayer film of the present invention has excellent filling/planarization characteristics, and therefore a gap-free and planar resist underlayer film can be formed even on a substrate having a structure body or a stepped section having a height of 30 nm or more.

The present invention provides a process for forming a resist underlayer film for use in a process for manufacturing a semiconductor device, the process including spin-coating a substrate to be processed, with the above-described composition for forming a resist underlayer film, and heat-treating the substrate coated with the composition for forming a resist underlayer film, at a temperature of 100°C or more and 300°C or less for a period in a range of 10 to 600 seconds, to form a resist underlayer film.

The resist underlayer film formation process can form a resist underlayer film having favorable resistance to alkaline hydrogen peroxide water, excellent filling/planarization characteristics, and excellent dry etching characteristics. In addition, the baking temperature and time can be appropriately adjusted in the above ranges, thereby allowing planarization/filling characteristics and curing characteristics suitable for the intended use to be obtained.

### ADVANTAGEOUS EFFECTS OF INVENTION

As described above, the composition for forming a resist underlayer film of the present invention can allow for formation of a resist underlayer film having, in addition to an antireflective function, favorable resistance to alkaline hydrogen peroxide water, excellent filling/planarization characteristics, and excellent dry etching characteristics.

The patterning process of the present invention can form a fine pattern by a multi-layer resist process (two-layer resist process, three-layer resist process, or four-layer resist process), and can form a resist underlayer film, to fill a stepped section on the substrate to be processed, and/or planarize the substrate to be processed. Accordingly, the patterning process of the present invention is suitably used for a wet etching processing process, a planarization process by underlayer film formation, or an underlayer film removal process by dry etching, and is extremely useful as a patterning process for use in a multi-layer resist process applied to fine patterning for manufacturing a semiconductor device.

Furthermore, the resist underlayer film formation process of the present invention can form a resist underlayer film having favorable resistance to alkaline hydrogen peroxide water, excellent filling/planarization characteristics, and excellent dry etching characteristics.

### BRIEF DESCRIPTION OF DRAWINGS

FIG. 1 includes illustrative views of one example of the patterning process by a three-layer resist process of the present invention;
FIG. 2 includes illustrative views of an evaluation method of filling characteristics in Examples and Comparative Examples; and
FIG. 3 includes illustrative views of an evaluation method of planarization characteristics in Examples and Comparative Examples.

### DESCRIPTION OF EMBODIMENTS

As described above, there have been demanded a composition for forming a resist underlayer film, having a favorable antireflective function, excellent resistance to alkaline hydrogen peroxide water, favorable filling/planarization characteristics, and dry etching characteristics, and a patterning process and a resist underlayer film formation process each using the composition.

The present inventor has made researches about various compositions for forming resist underlayer films and various patterning processes in order that wet etching processing can be realized, desirably, furthermore filling/planarization by underlayer film formation and dry etching removal of an underlayer film can be simultaneously realized in multi-layer lithography using a resist underlayer film. As a result, the inventor has found that a composition for forming a resist underlayer film, containing a polymer compound of a specified structure and a crosslinking agent of a specified structure, as main components, and a patterning process using the composition are very effective, thereby leading to completion of the present invention.

Specifically, the present invention relates to
a composition for forming a resist underlayer film, the composition including:
   (A) a polymer compound having a structural unit (a1) represented by the following formula (A-1) and at least one structural unit (a2) selected from structural units represented by the following formulae (A-2) to (A-4);
   (B) a crosslinking agent represented by the following formula (B-1); and
   (C) an organic solvent; 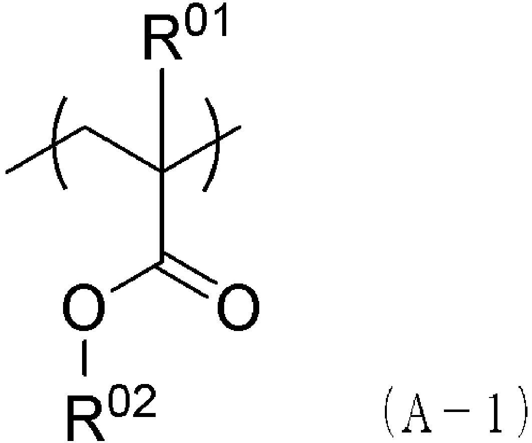
wherein R⁰¹ is a hydrogen atom or a methyl group, and R⁰² is a monovalent organic group containing a group selected from groups represented by the following formulae (R₂-1) to (R₂-3); 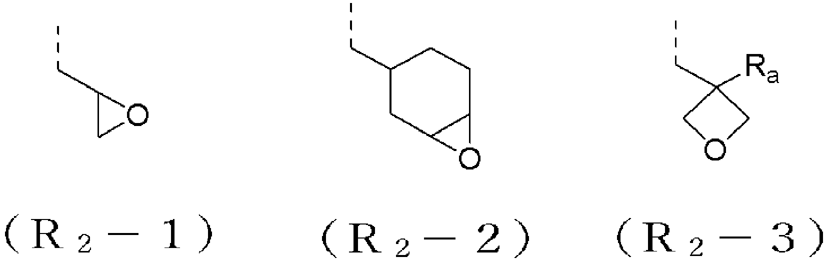
wherein Rₐ is a hydrogen atom or an alkyl group having 1 to 10 carbon atoms, and a dotted line represents a bond; 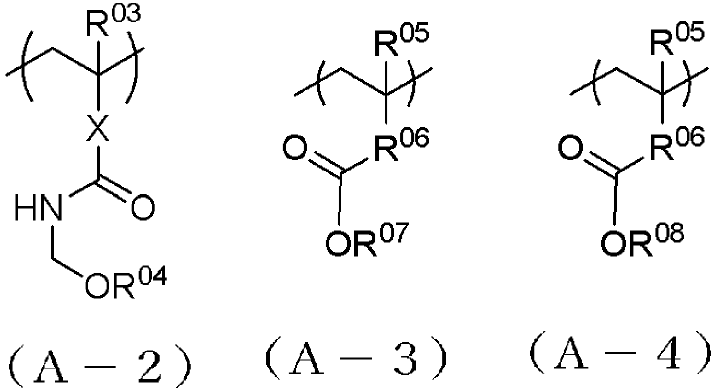
wherein, in the formula (A-2), X is an aromatic ring having 6 to 20 carbon atoms or a single bond, R⁰³ is a hydrogen atom or a methyl group, and R⁰⁴ is a hydrogen atom or a monovalent alkyl group having 1 to 10 carbon atoms and, when R⁰⁴ is the alkyl group, a hydrogen atom constituting the alkyl group is optionally replaced by a hydroxyl group; in the formula (A-3), R⁰⁵ is a hydrogen atom or a methyl group, R⁰⁶ is a single bond or a divalent linkage group containing an ester group and having 2 to 10 carbon atoms, and R⁰⁷ is a tertiary alkyl group having 4 to 20 carbon atoms or a tertiary alkenyl group having 5 to 20 carbon atoms; and in the formula (A-4), R⁰⁵ and R⁰⁶ have the same meanings as those in the formula (A-3), and R⁰⁸ is a hydrogen atom or a monovalent primary alkyl group having 1 to 10 carbon atoms; 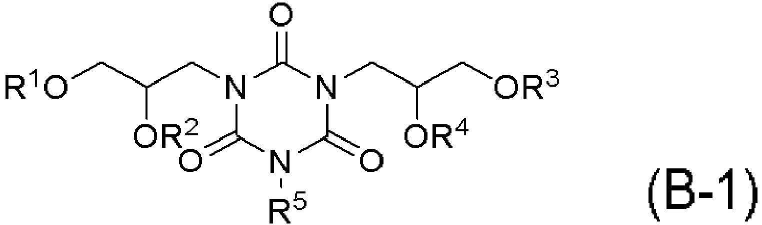
wherein R⁵ represents a methyl group, an ethyl group, a propyl group, an allyl group, a propargyl group or a group represented by the following (B-2), and R¹ and R³ each represent a benzoyl group, a toluoyl group, a naphthoyl group or an anthranoyl group; and R² and R⁴ each represent a hydrogen atom, an acetyl group, an acryloyl group or a methacryloyl group; and 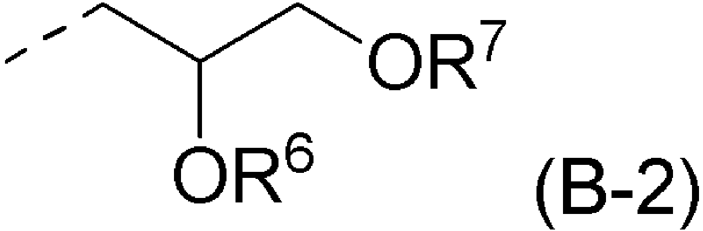
wherein R⁷ represents a benzoyl group, a toluoyl group, a naphthoyl group or an anthranoyl group; and R⁶ represents a hydrogen atom, an acetyl group, an acryloyl group or a methacryloyl group and, when R² and R⁴ are hydrogen atoms, R⁶ is also a hydrogen atom.

Hereinafter, the present invention is described in further detail, but the present invention is not limited thereto.

### [Resist underlayer film material]

The composition for forming a resist underlayer film of the present invention is a composition for forming a resist underlayer film, for use in a multi-layer resist process, the composition including:
(A) a polymer compound having a structural unit (a1) represented by the following formula (A-1) and furthermore at least one structural unit (a2) represented by the following formulae (A-2) to (A-4);
(B) a crosslinking agent represented by the following formula (B-1); and
(C) an organic solvent; 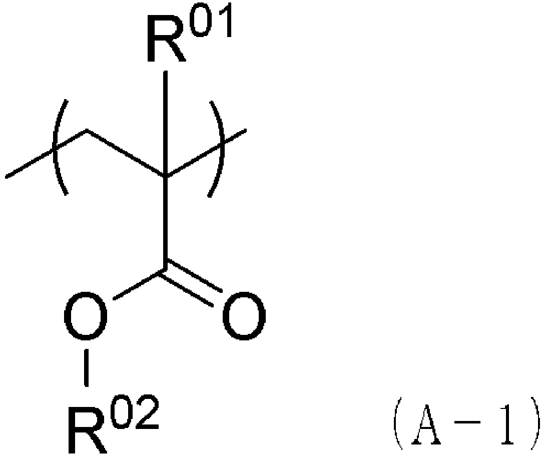
   wherein R⁰¹ is a hydrogen atom or a methyl group, and R⁰² is a monovalent organic group containing a group selected from the following formulae (R₂-1) to (R₂-3); 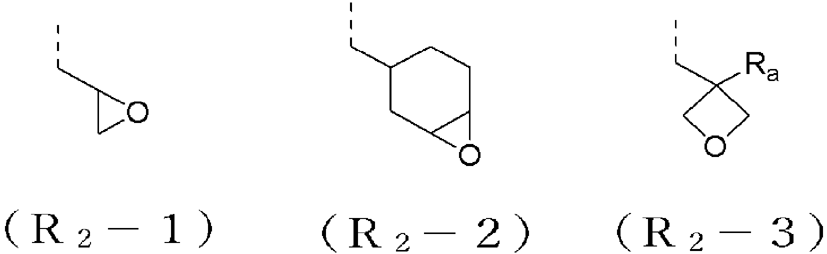
   wherein Rₐ is a hydrogen atom or an alkyl group having 1 to 10 carbon atoms, and a dotted line represents a bond; 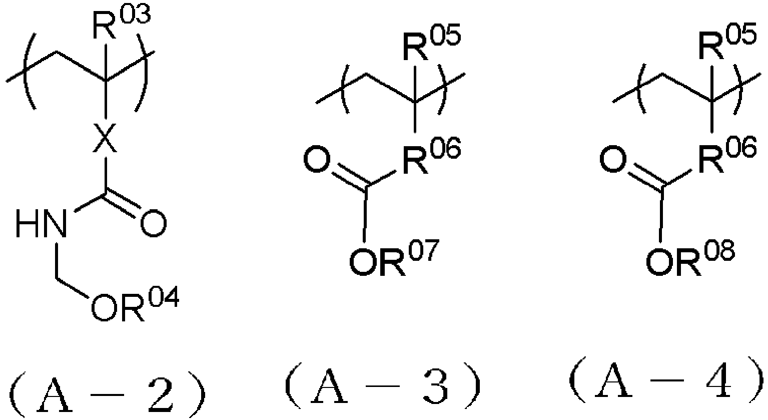
   wherein, in the formula (A-2), X is an aromatic ring having 6 to 20 carbon atoms or a single bond, R⁰³ is a hydrogen atom or a methyl group, and R⁰⁴ is a hydrogen atom or a monovalent alkyl group having 1 to 10 carbon atoms and, when R⁰⁴ is the alkyl group, a hydrogen atom constituting the alkyl group is optionally replaced by a hydroxyl group; in the formula (A-3), R⁰⁵ is a hydrogen atom or a methyl group, R⁰⁶ is a single bond or a divalent linkage group containing an ester group and having 2 to 10 carbon atoms, and R⁰⁷ is a tertiary alkyl group having 4 to 20 carbon atoms or a tertiary alkenyl group having 5 to 20 carbon atoms; and in the formula (A-4), R⁰⁵ and R⁰⁶ have the same meanings as those in the formula (A-3), and R⁰⁸ is a hydrogen atom or a monovalent primary alkyl group having 1 to 10 carbon atoms; 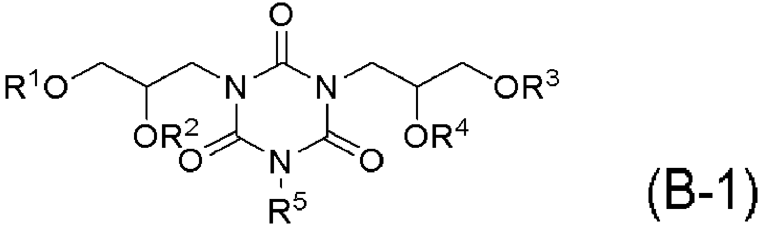
   wherein R⁵ represents a methyl group, an ethyl group, a propyl group, an allyl group, a propargyl group or a group represented by the following (B-2), and R¹ and R³ each represent a benzoyl group, a toluoyl group, a naphthoyl group or an anthranoyl group; and R² and R⁴ each represent a hydrogen atom, an acetyl group, an acryloyl group or a methacryloyl group; and 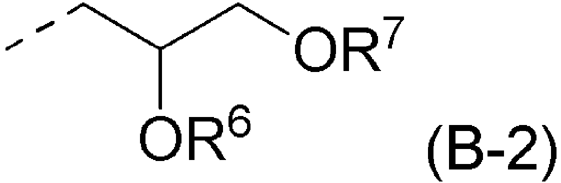
   wherein R⁷ represents a benzoyl group, a toluoyl group, a naphthoyl group or an anthranoyl group; and R⁶ represents a hydrogen atom, an acetyl group, an acryloyl group or a methacryloyl group and, when R² and R⁴ are hydrogen atoms, R⁶ is also a hydrogen atom.

### [(A) Polymer compound]

The (A) polymer compound is a polymer compound having a structural unit (a1) represented by the formula (A-1), and at least one structural unit (a2) selected from structural units represented by the formulae (A-2) to (A-4). The repeating unit structure (a1) represented by the formula (A-1) not only imparts sufficient thermal curability to the polymer, but also imparts the effect of preventing intermixing with an upper layer film. The repeating unit structure is considered to also provide certain contribution to resistance to alkaline hydrogen peroxide water.

In the formula (A-1), R⁰¹ is a hydrogen atom or a methyl group. When R⁰¹ is a hydrogen atom, the polymer compound (A-1) is excellent in fluidity, and therefore may be excellent in planarization/filling characteristics or may be decreased in carbon content and thus excellent in etching rate. In this regard, when R⁰¹ is a methyl group, coatability in film formation, with the resist underlayer film material of the present invention, may be excellent. R⁰² is a monovalent organic group containing a group selected from the groups represented by the formulae (R₂-1) to (R₂-3).

The (A) polymer compound may have only one kind of the repeating unit (a) represented by the formula (A-1), or two or more kinds thereof. The repeating unit represented by the formula (A-1) is specifically the following.

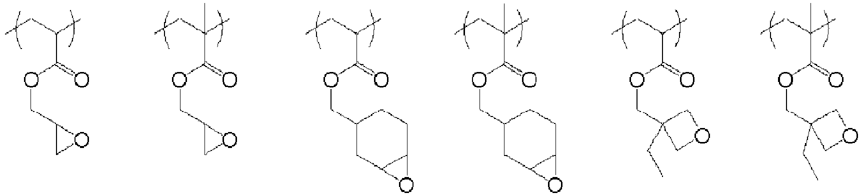

The (A) polymer compound preferably has a repeating unit structure (a1) represented by the formula (A-1), and furthermore at least one structural unit (a2) represented by the formulae (A-2) to (A-3).

In the formula (A-2), X is an aromatic ring having 6 to 20 carbon atoms or a single bond. X is more preferably a benzene ring, a naphthalene ring or a single bond. A structure having a relatively low molecular weight, as described above, increases the number of hydrogen bond donors per unit molecular weight, and imparts excellent coatability of a hydrophobic surface.

In the formula (A-2), R⁰³ is a hydrogen atom or a methyl group. Herein, when X is an aromatic ring, R⁰³ is more preferably a hydrogen atom from the viewpoint of polymerization reactivity in raw material synthesis. When X is a single bond, polymerization reactivity in raw material synthesis is sufficient even if R⁰³ is a hydrogen atom or a methyl group, and such structure selection can suitably adjust polymerization reactivity.

In the formula (A-2), R⁰⁴ is a hydrogen atom or a monovalent alkyl group having 1 to 10 carbon atoms and, when R⁰⁴ is the alkyl group, a hydrogen atom constituting the alkyl group is optionally replaced by a hydroxyl group. R⁰⁴ is more preferably a hydrogen atom or a linear or branched alkyl group having 1 to 6 carbon atoms, further preferably a hydrogen atom or a linear or branched alkyl group having 1 to 4 carbon atoms.

Specific examples of R⁰⁴ in the formula (A-2) can include a methyl group, an ethyl group, a n-propyl group, an isopropyl group, a n-butyl group, a sec-butyl group, a tert-butyl group, a n-pentyl group, a neopentyl group, a n-hexyl group, a n-heptyl group, a n-octyl group, a n-nonyl group, n-decyl group, a cyclopentyl group, a cyclohexyl group, and an organic group in which a hydrogen atom constituting the alkyl group is replaced by a hydroxyl group.

In the formula (A-2), an OR⁰⁴ structure is detached during baking, to produce a carbocation. This carbocation is reacted and bonded with other structure and thus crosslinking progresses. A structure in which the molecular weight of R⁰⁴ is low can be adopted to suppress film shrinkage during baking, and to suppress the occurrence of a coating error during baking. In this regard, a structure in which the molecular weight of R⁰⁴ is high can make a resin structure bulky and thus increase the resin viscosity during coating, to suppress the occurrence of a coating error during spin drying. R⁰⁴ is more preferably a hydrogen atom or a linear or branched alkyl group having 1 to 6 carbon atoms, further preferably a hydrogen atom or a linear or branched alkyl group having 1 to 4 carbon atoms from the viewpoint of ease of the occurrence of a coating error during spin drying or during baking.

Specific examples of the repeating unit represented by the formula (A-2) can preferably include the following structures. R⁰³ is the same as described above.

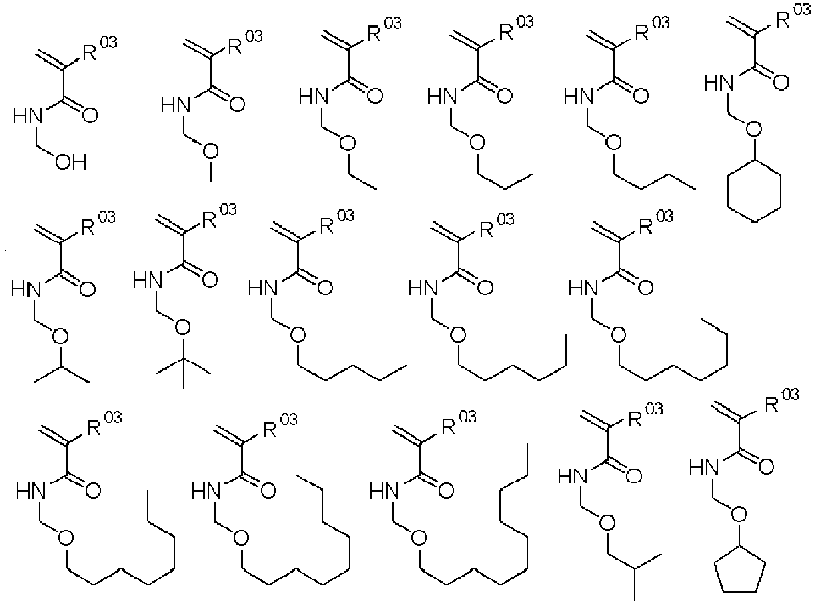

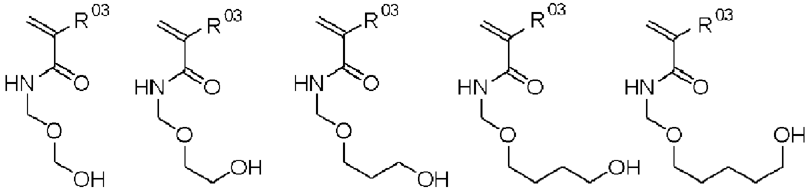

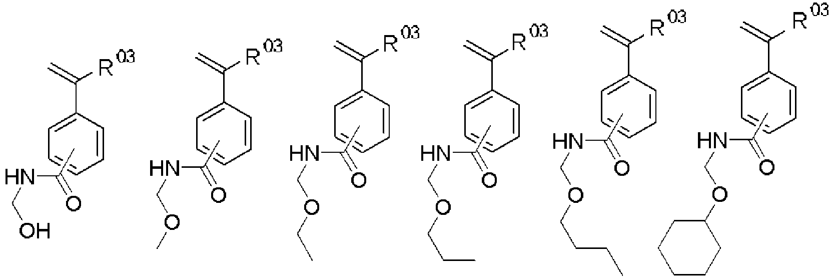

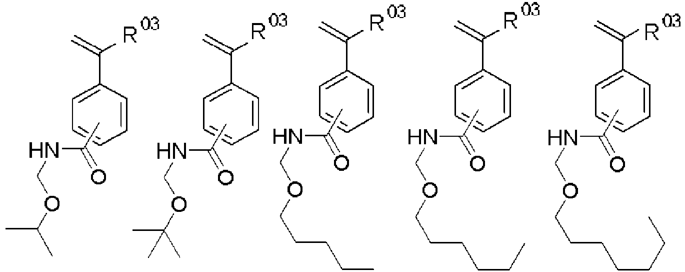

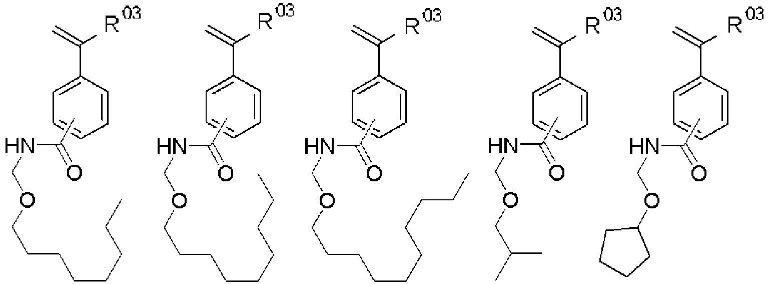

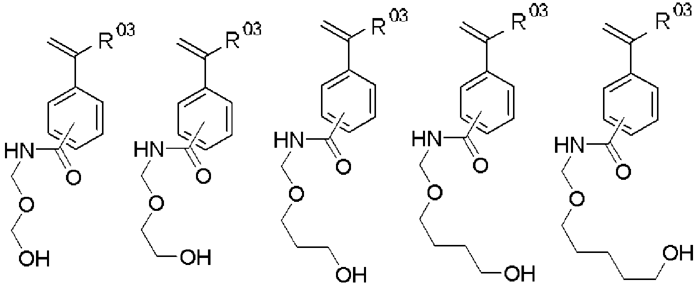

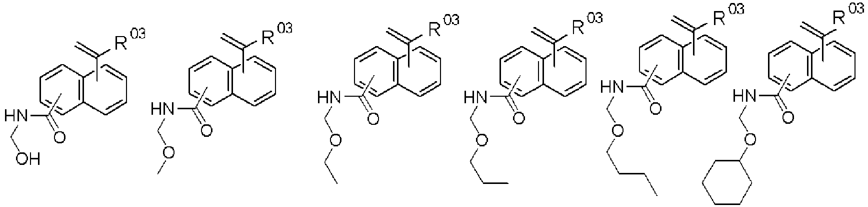

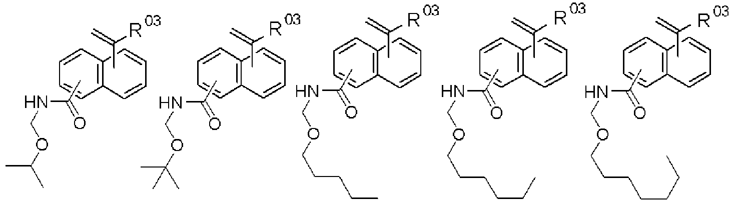

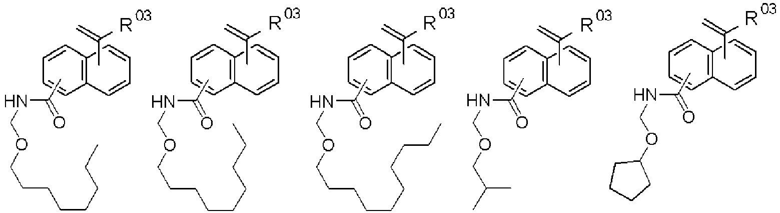

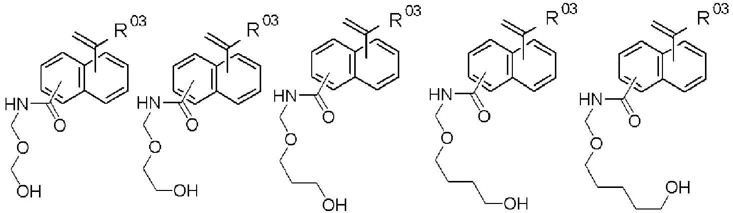

The structural unit represented by the formula (A-2) functions as an adhesion group of a crosslinking group and an underlayer. A nitrogen-hydrogen bond serving as a hydrogen bond donor is contained, and therefore this efficiently forms a hydrogen bond even on a hydrophobic underlayer film, thereby suppressing the occurrence of a coating error. In this regard, this structural unit itself has crosslinkability, and therefore this unit, even if introduced in a large amount into a resin, does not cause loss in film curability.

In the formula (A-3), R⁰⁵ is a hydrogen atom or a methyl group. R⁰⁵ is preferably a hydrogen atom.

In the formula (A-3), R⁰⁶ is a single bond or a divalent linkage group containing an ester group and having 2 to 10 carbon atoms. Specific examples of R⁰⁶ can include a single bond, -CO₂CH₂-, -CO₂CH₂CH₂-, - CO₂CH₂CH₂CH₂-, -CO₂CH(CH₃)-, -CO₂CH₂CH₂CH₂CH₂-, - CO₂CH₂CH₂CH₂CH₂CH₂-, -CO₂CH₂CH₂CH₂CH₂CH₂CH₂CH₂CH₂-, - CO₂CH₂CH₂O-, -CO₂CH₂CH₂OCH₂CH₂O-, and - CO₂CH₂CH₂OCH₂CH₂OCH₂CH₂O. Among them, in particular, - CO₂CH₂-, -CO₂CH₂CH₂-, -CO₂CH₂CH₂CH₂-, -CO₂CH₂CH₂CH₂CH₂-, or - CO₂CH₂CH₂CH₂CH₂CH₂- is preferred.

In the formula (A-3), R⁰⁷ is a tertiary alkyl group having 4 to 20 carbon atoms or a tertiary alkenyl group having 5 to 20 carbon atoms. Specific examples of R⁰⁷ can include the following structures, but not limited thereto. A dotted line represents a bond.

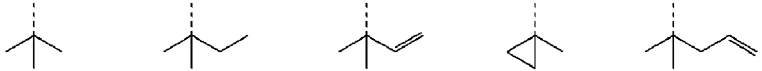

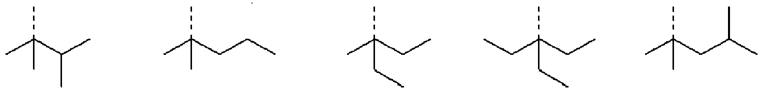

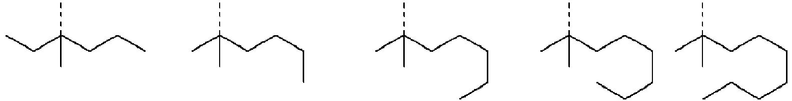

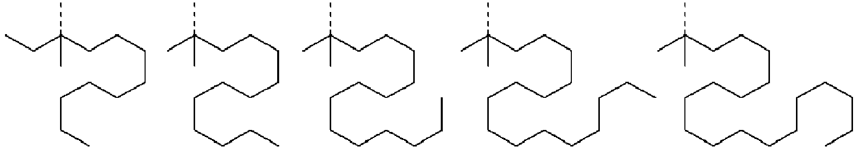

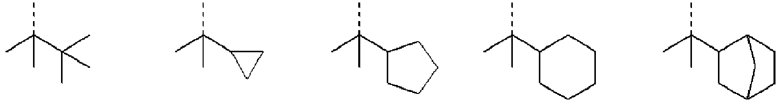

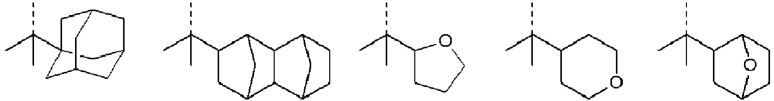

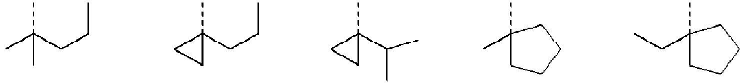

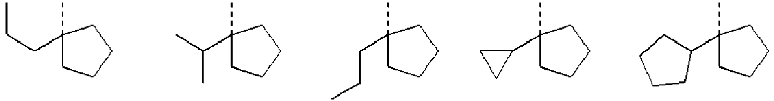

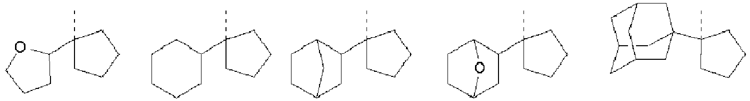

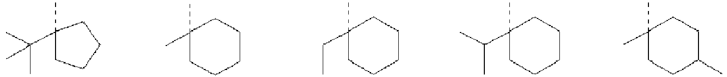

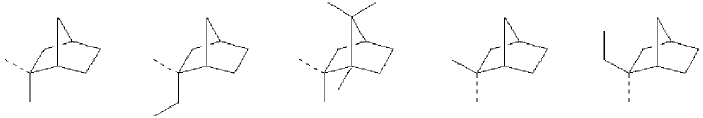

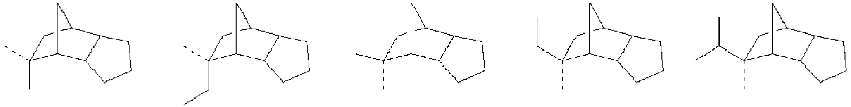

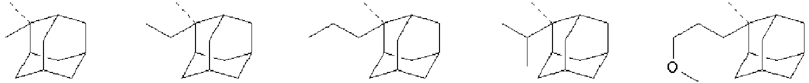

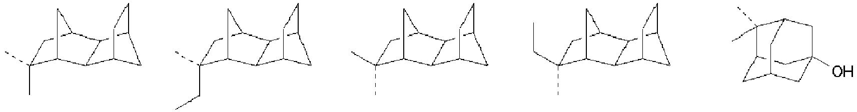

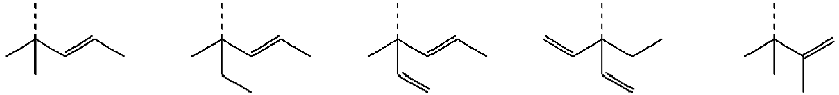

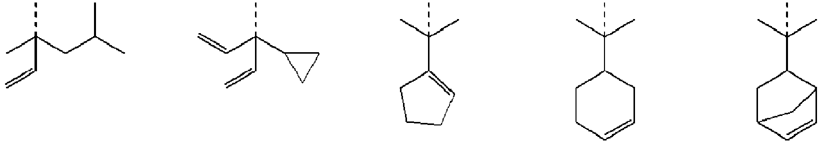

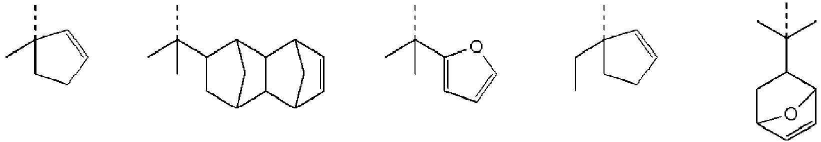

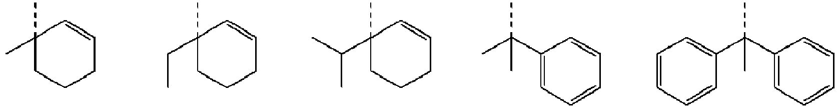

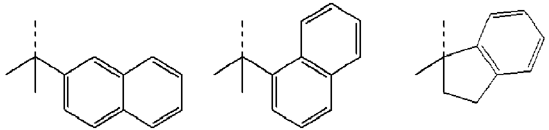

When a resist underlayer film is formed from a polymer compound containing the repeating unit represented by the formula (A-3), a elimination decomposition reaction of a tertiary alkyl group R⁰⁷ progresses by the action of an acid generated by heat and/or an acid generator described below, to generate carboxylic acid. The polarity of this carboxylic acid improves adhesiveness with a resist pattern, improves the rectangularity of a pattern, and/or prevents residue generation in a space portion of a pattern.

In addition, the carboxylic acid generated from (A-3) may be taken with the repeating unit represented by the formula (A-1), to allow a ring-opening addition reaction to occur, thereby forming a crosslinked structure of hydroxy ester. A typical example of the reaction is shown below. In the following formula, a state in which R⁰⁷ in the repeating unit (A-3) is detached and formed into carboxylic acid is designated as (A-3'), and a state in which a crosslinked structure of hydroxy ester is formed by a ring-opening addition reaction with (A-1') as one example of the formula (A-1) is designated as (A-3''). Thus, a crosslinked structure of hydroxy ester is formed by the present crosslinking reaction.

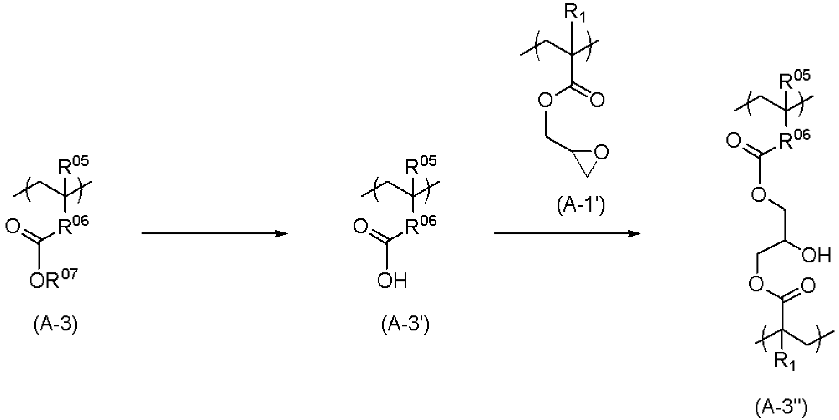

A crosslinking reaction for forming this crosslinked structure of hydroxy ester promotes curing of a resist underlayer film. A dense film can be formed by sufficient curing and intermixing between a resist underlayer film and a resist upper layer film can be prevented, thereby preventing a residue in a space portion of a pattern and providing a pattern high in rectangularity.

The crosslinked structure of hydroxy ester is a polar group and has interaction with a resist pattern, and therefore the presence of the repeating unit (A-3) also contributes to prevention of collapse of a resist pattern.

In the formula (A-4), R⁰⁵ and R⁰⁶ have the same meanings as those in the formula (A-3), and R⁰⁸ is a hydrogen atom or a monovalent primary alkyl group having 1 to 10 carbon atoms. R⁰⁸ is more preferably a hydrogen atom or a linear or branched alkyl group having 1 to 6 carbon atoms, further preferably a hydrogen atom or a linear or branched alkyl group having 1 to 4 carbon atoms.

Specific examples of R⁰⁸ in the formula (A-4) can include a methyl group, an ethyl group, a n-propyl group, an isopropyl group, a n-butyl group, a sec-butyl group, a tert-butyl group, a n-pentyl group, a neopentyl group, a n-hexyl group, a n-heptyl group, a n-octyl group, a n-nonyl group, and a n-decyl group.

The (A) polymer compound contains the structural unit represented by the formula (A-4), thereby enabling fluidity of the polymer compound to be enhanced, and allowing the composition for forming a resist underlayer film to be excellent in filling/planarization characteristics.

In the present invention, the content rate of the structural unit (a1) relative to all the repeating units in the (A) polymer compound is preferably 20% by mol or more and 90% by mol or less, more preferably 25% or more and 80% or less. When the content rate is 20% or more, curing ability is sufficient. When the content rate is 90% or less, etching characteristics are sufficient.

The content rate of the structural unit (a2) relative to all the repeating units is preferably 10% by mol or more and 80% by mol or less, more preferably 20% or more and 75% or less. When the content rate is 10% or more, the resolution during upper layer resist lithography is sufficient, and when the content rate is 80% or less, filling/planarization characteristics are sufficient.

The (A) polymer compound preferably does not contain an aromatic group having a high molecular weight, such as a naphthalene or anthracene structure, in the repeating units from the viewpoint of filling/planarization characteristics, in order to ensure fluidity of the polymer compound. If a naphthalene or anthracene structure is introduced into the repeating units of the (A) polymer compound from the viewpoint of imparting an antireflective function, filling and planarization characteristics are deteriorated. In this regard, in the present invention, both an antireflective function and filling/planarization characteristics can be satisfied by introduction of an aromatic compound unit (ultraviolet absorption group) into a crosslinking group component. Furthermore, a specified crosslinking group component can be combined at a certain proportion with the polymer compound, thereby allowing also resistance to alkaline hydrogen peroxide water to be satisfied.

The (A) polymer compound preferably has a weight average molecular weight of 1,000 to 20,000. The weight average molecular weight is based on a value measured by gel permeation chromatography (tetrahydrofuran solvent, polystyrene standard). The weight average molecular weight of the (A) polymer compound is preferably 1,000 to 20,000, more preferably 1,500 to 15,000, further preferably 2,000 to 10,000. When the weight average molecular weight of the component (A) is 1,000 or more, not only film formability is favorable, but also there is no risk of contamination of an apparatus due to increase of a sublimate during heating and curing. When the weight average molecular weight is 20,000 or less, no coating defects occur and fluidity is also favorable, and therefore planarization/filling characteristics are also sufficient.

The dispersity by GPC of the (A) polymer compound in the resist underlayer film material in the present invention is preferably 3.0 or less, more preferably 2.0 or less. The composition for forming a resist underlayer film, when containing the (A) polymer compound, causes less occurrence of a sublimate during resist underlayer film formation, can allow apparatus contamination to be suppressed, and is excellent in practicality.

The (A) polymer compound preferably has a structural unit (a1) represented by the formula (A-1) and at least two structural units (a2) selected from structural units represented by the formulae (A-2) to (A-4).

When the repeating unit is contained, etching characteristics, for example, the etching rate and a patterned shape after etching can be tailored to a customer demand without degradation of any optical characteristics of the composition for forming a resist underlayer film, including the polymer compound.

Specific examples of the (A) polymer compound in the composition for forming a resist underlayer film of the present invention can include the following polymers, but not limited thereto. In the formulae, Me represents a methyl group and ^{t}Bu represents a t-butyl group, and the same applies to the following.

(A1) to (A6) shown in Synthesis Examples in Examples are also exemplified as specific examples.

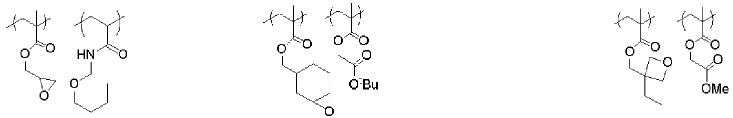

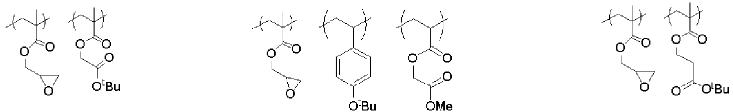

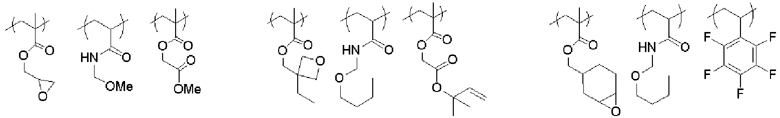

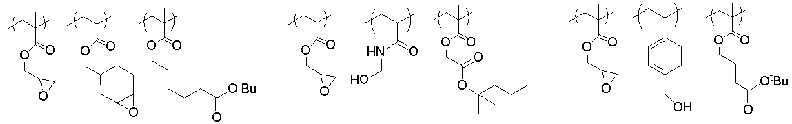

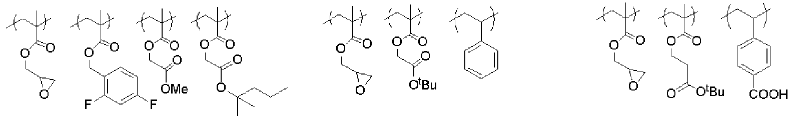

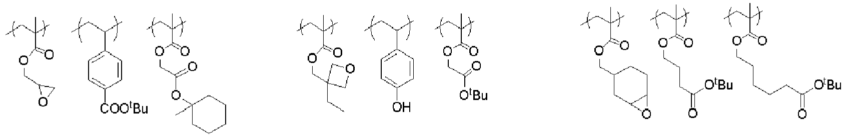

One process for synthesizing the (A) polymer compound is a process including mixing a monomer having a polymerizable unsaturated bond corresponding to each repeating unit, and adding a radical initiator in a solvent to perform heating polymerization, and thus the polymer compound can be obtained. Polymerization conditions can be variously selected depending on a monomer used, an objective molecular weight, and the like, and are not particularly limited, and specific examples of a solvent used during polymerization can include toluene, benzene, tetrahydrofuran, diethyl ether, dioxane, 2-butanone, methyl isobutyl ketone, propylene glycol monomethyl ether acetate, cyclohexanone, γ-butyrolactone, ethyl acetate, and butyl acetate. Examples of the polymerization initiator can include 2,2'-azobisisobutyronitrile (AIBN), 2,2'-azobis(2,4-dimethylvaleronitrile), dimethyl 2,2-azobis(2-methylpropionate), benzoyl peroxide, and lauroyl peroxide, and a thiol compound such as octanethiol or 2-mercaptoethanol may be added as a chain transfer agent during polymerization. A polymerization reaction can be preferably performed by heating from 40°C to the boiling point of a reaction solvent. The reaction time is 0.5 to 100 hours, preferably 1 to 48 hours.

For example, any compound having a polymerizable double bond, represented by the following formulae (1a), (2a), (3a), and (4a), can be used as a monomer, to perform the above-described polymerization, thereby synthesizing a polymer compound having any repeating unit represented by the formulae (A-1), (A-2), (A-3) and (A-4) . 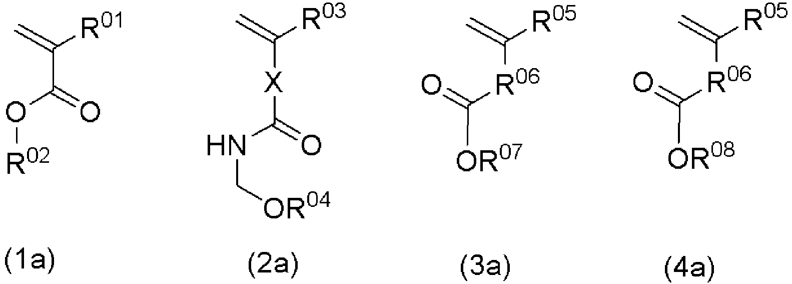 In the formulae (1a), (2a), (3a), and (4a), R⁰¹ to R⁰⁸, and X have the same meanings as described above.

During polymerization, all raw materials may be mixed and then heated, or to some raw materials heated in advance, the remaining raw materials may be then added individually or in combination, in one portion or portionwise. For example, a polymerization process including heating only a polymerization solvent in advance and gradually adding a monomer solution and an initiator solution separately is particularly preferred because a relatively homogeneous polymer compound is obtained and an abnormal reaction such as a runaway reaction can be prevented.

The polymerization liquid obtained as described above may be directly compounded to the composition for forming a resist underlayer film, or may be, if necessary, purified with a common process such as crystallization, liquid separation, filtration, or concentration, to remove the remaining monomer, the remaining solvent, a reaction by-product, and other impurities. When the (A) polymer compound is purified, a crystallization process including adding a poor solvent such as water, water-containing alcohol, or saturated hydrocarbon to the polymerization liquid, and collecting the resulting precipitate by filtration, or a liquid separation process including separating and removing the poor solvent layer is suitable, and among them, the liquid separation process is particularly suitable. A case where the polymer compound is purified by the liquid separation process is preferred from the viewpoint of prevention of contamination of a film formation apparatus because a low-molecular weight component in the polymerization liquid can be efficiently removed and therefore the occurrence of a sublimate is decreased during formation of a resist underlayer film from the composition for forming a resist underlayer film, including the polymer compound.

### [(B) Crosslinking agent]

The crosslinking agent used in the composition for forming a resist underlayer of the present invention has a structure represented by the formula (B-1): 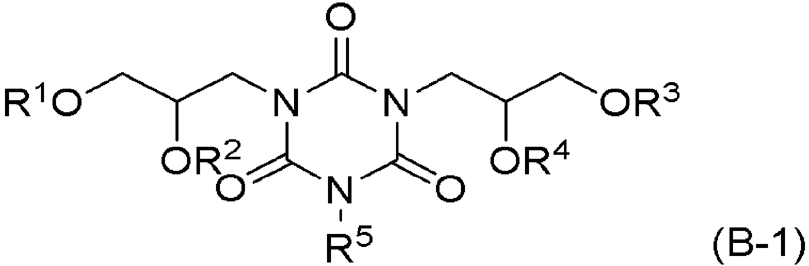 wherein R⁵ represents a methyl group, an ethyl group, a propyl group, an allyl group, a propargyl group or a group represented by the following (B-2), and R¹ and R³ each represent a benzoyl group, a toluoyl group, a naphthoyl group or an anthranoyl group; and R² and R⁴ each represent a hydrogen atom, an acetyl group, an acryloyl group or a methacryloyl group; and 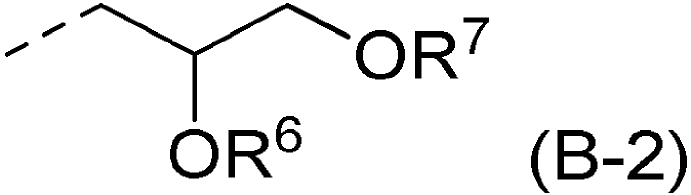 wherein R⁷ represents a benzoyl group, a toluoyl group, a naphthoyl group or an anthranoyl group; and R⁶ represents a hydrogen atom, an acetyl group, an acryloyl group or a methacryloyl group and, when R² and R⁴ are hydrogen atoms, R⁶ is also a hydrogen atom.

The composition for forming a resist underlayer film, including the crosslinking agent, can absorb ultraviolet light to suppress reflection particularly in a lithography process with a ultraviolet laser such as an ArF laser or a KrF laser, and exhibits favorable adhesiveness to a resist pattern formed thereon. The composition can also have, in addition to the above antireflective function, favorable resistance to alkaline hydrogen peroxide water, excellent filling/planarization characteristics, and excellent dry etching characteristics.

A benzoyl group, a toluoyl group, a naphthoyl group, and an anthranoyl group in R¹ and R³ in the formula (B-1) are each a group absorbing ultraviolet light (hereinafter, also referred to as "ultraviolet absorption group"). A crosslinking agent containing a benzoyl group or a toluoyl group is preferred for ArF (193 nm) exposure and a crosslinking agent containing a naphthoyl group or an anthranoyl group is preferred for KrF (248 nm) exposure, in consideration of the absorption wavelength.

In the present invention, a benzoyl group, a toluoyl group, a naphthoyl group and an anthranoyl group are introduced into not the (A) polymer compound, but the (B) crosslinking agent as a monomolecular compound from the viewpoint that fluidity is ensured in order to express high-level filling/planarization characteristics.

A substituent on an aromatic ring of a benzoyl group, a toluoyl group, a naphthoyl group, and an anthranoyl group is preferably a non-polar substituent such as an alkyl group, further preferably no substituent.

For example, a polar group such as an amide group or a hydroxyl group is introduced as a substituent to increase the polarity of a monomolecular compound (B-1). This increase leads to an increase in viscosity during formation of an underlayer film, and leads to degradation of filling/planarization characteristics. When a hydroxyl group or the like high in reactivity with a crosslinkable unit contained in the polymer compound is present, the temperature at which a curing reaction occurs is lowered and the advantage by thermal flow cannot be enjoyed, and these lead to degradation of filling/planarization characteristics.

Two or more of R¹, R³, and R⁷ in the formula (B-1) are each preferably a benzoyl group, a toluoyl group, a naphthoyl group or anthranoyl group, and are each preferably any of a naphthoyl group and an anthranoyl group from the viewpoint of suppression of reflection light from the substrate.

R² and R⁴ in the formula (B-1) are each preferably any of a hydrogen atom, an acetyl group, an acryloyl group or a methacryloyl group, and more preferably any of an acetyl group, an acryloyl group or a methacryloyl group from the viewpoint of filling/planarization.

R⁵ in the formula (B-1) represents any of a methyl group, an ethyl group, a propyl group, an allyl group and a propargyl group, or the formula (B-2).

Any of R², R⁴, and R⁵ in the formula (B-1) preferably has an unsaturated bond which is not aromatic.

The composition for forming a resist underlayer film, including the crosslinking agent, can be enhanced in fluidity, and can have further excellent filling ability/planarization characteristics.

R⁵ in the formula (B-1) is more preferably any of a methyl group, an ethyl group, a propyl group, an allyl group and a propargyl group, further preferably any of an allyl group and a propargyl group from the viewpoint of filling/planarization.

In the formula (B-2), R⁷ represents any of a benzoyl group, a toluoyl group, a naphthoyl group, and an anthranoyl group. R¹, R³, and R⁷ are preferably the same substituents.

In the formula (B-2), R⁶ represents a hydrogen atom, an acetyl group, an acryloyl group or a methacryloyl group and, when R² and R⁴ are hydrogen atoms, R⁶ is also a hydrogen atom.

Specific examples of the compound represented by the formula (B-1) can include the following compounds.

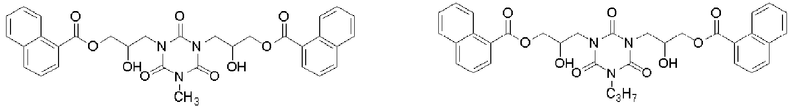

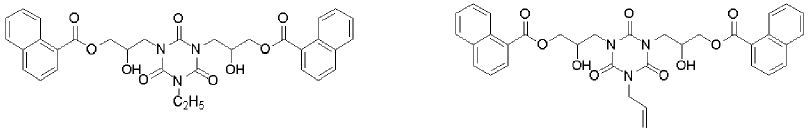

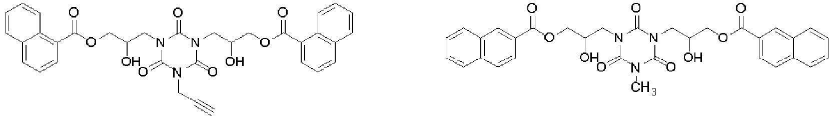

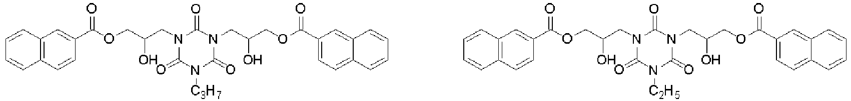

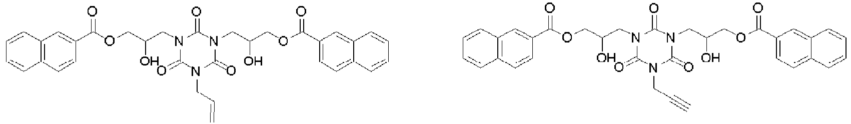

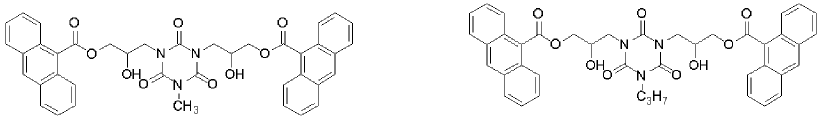

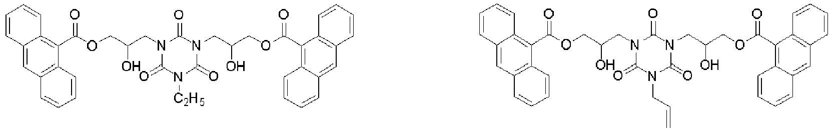

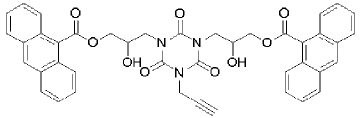

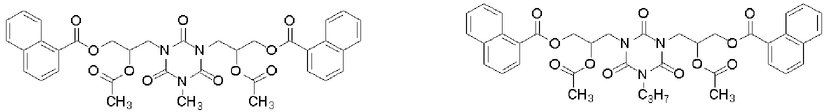

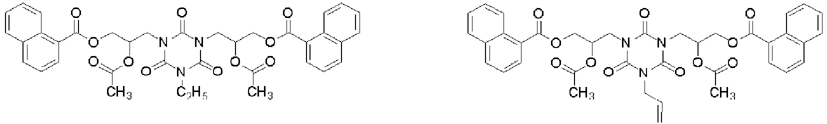

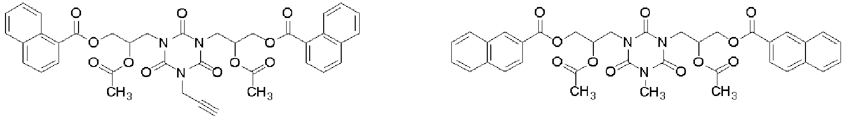

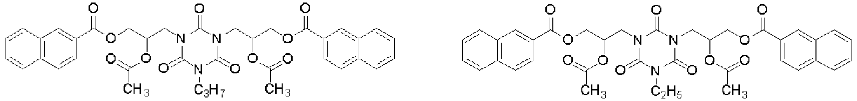

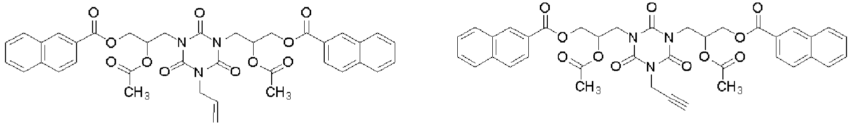

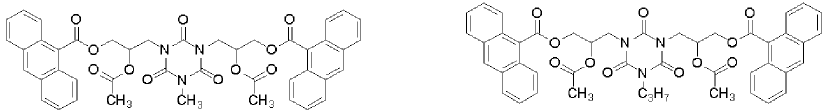

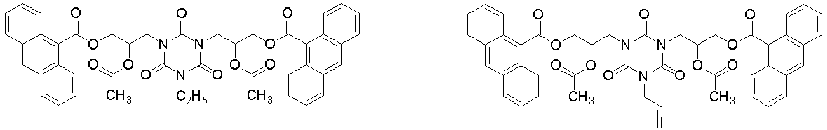

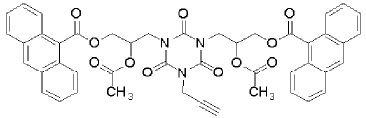

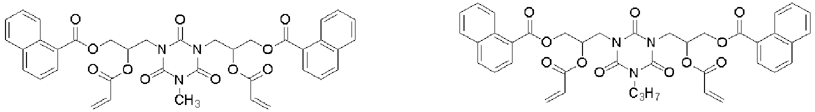

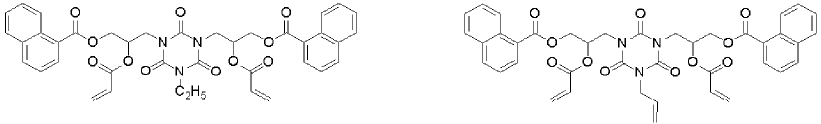

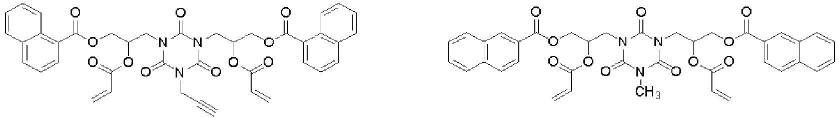

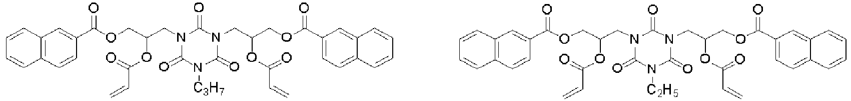

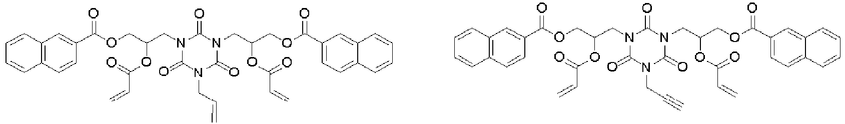

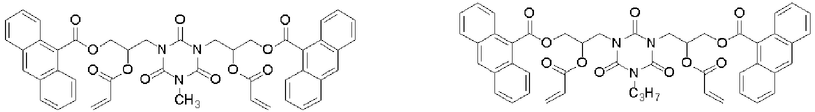

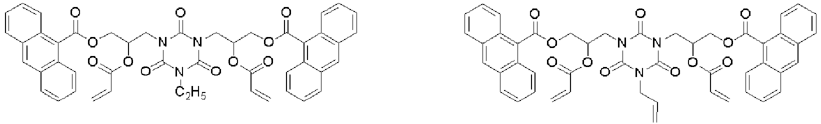

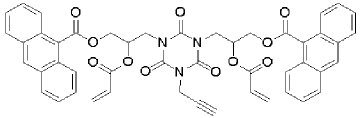

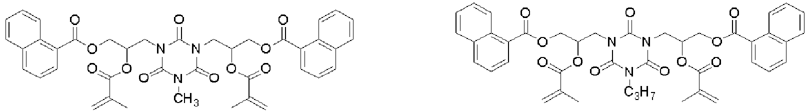

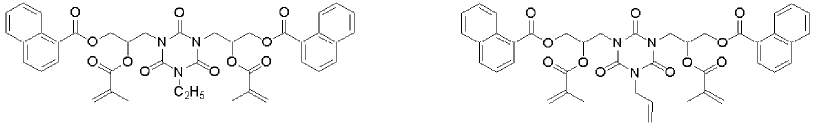

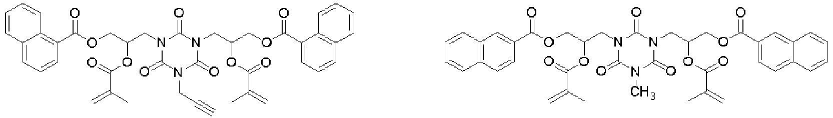

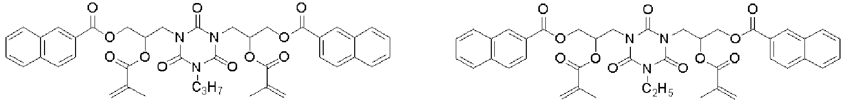

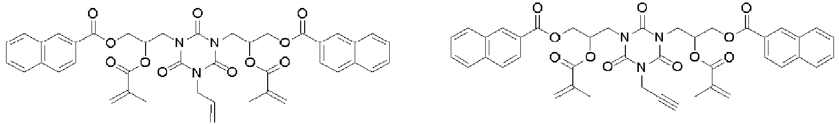

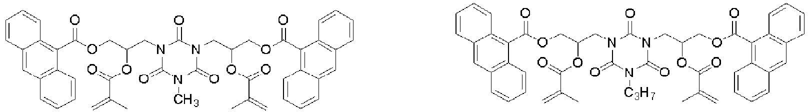

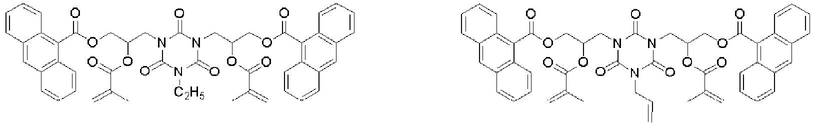

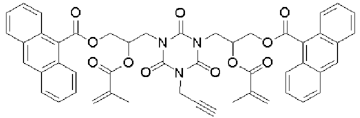

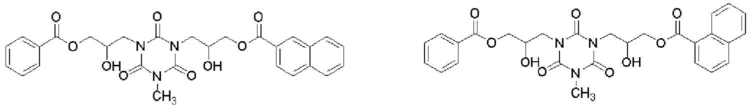

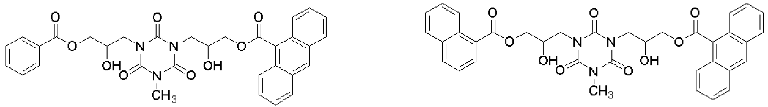

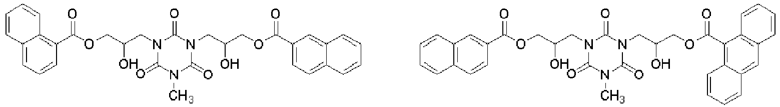

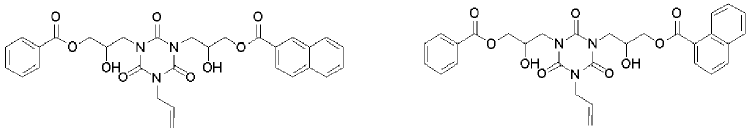

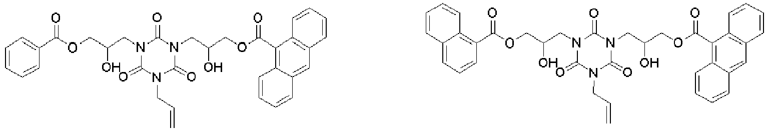

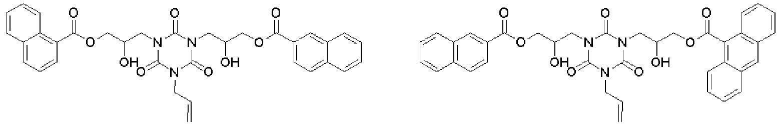

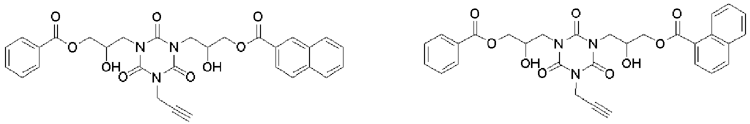

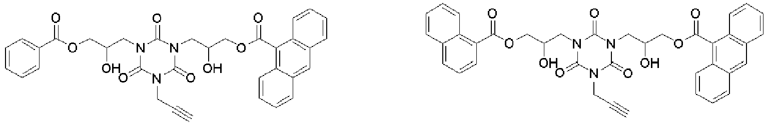

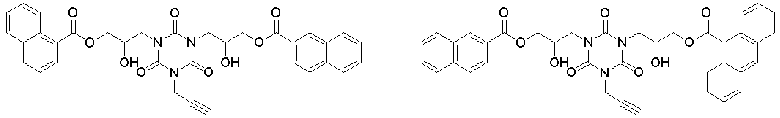

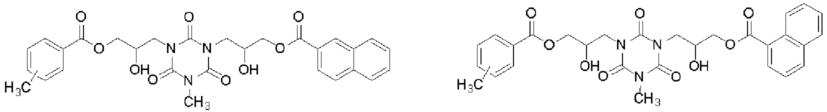

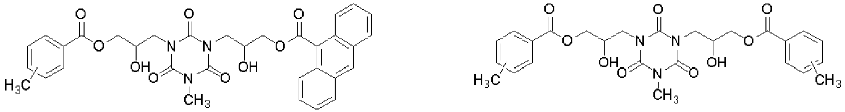

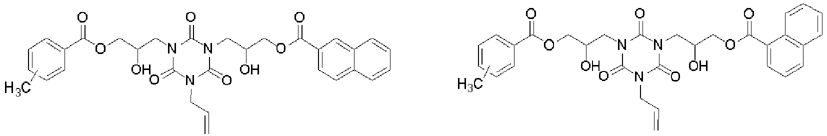

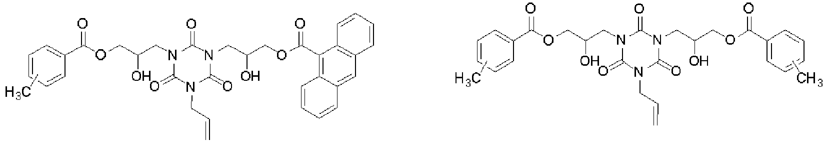

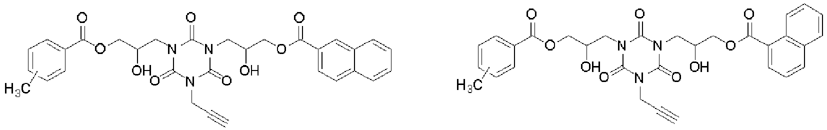

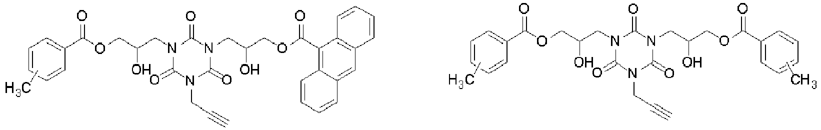

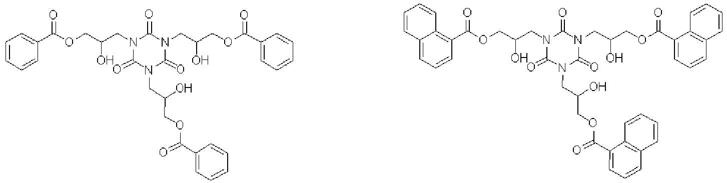

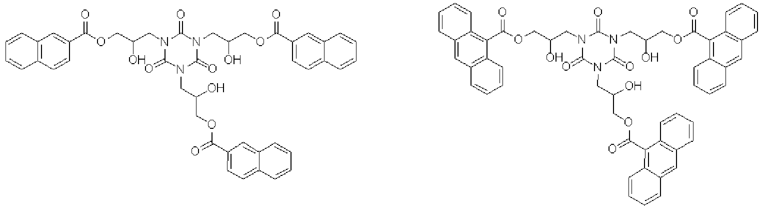

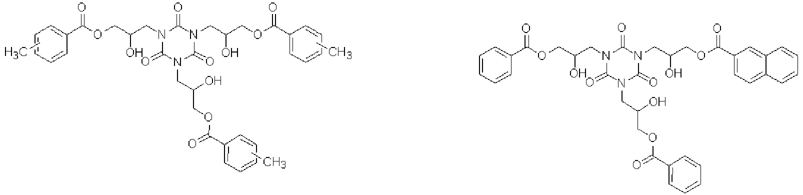

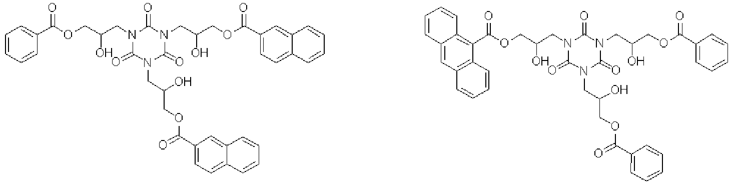

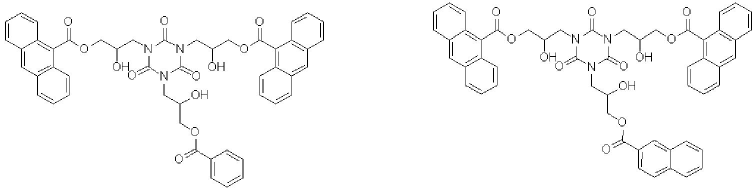

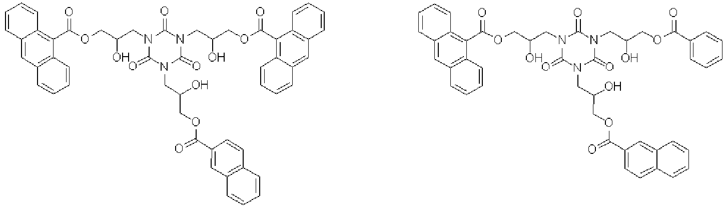

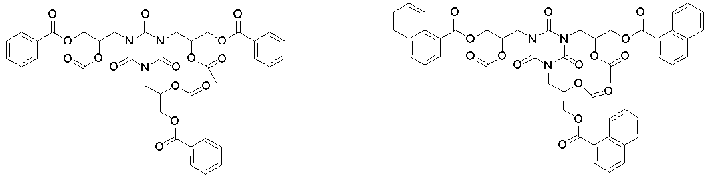

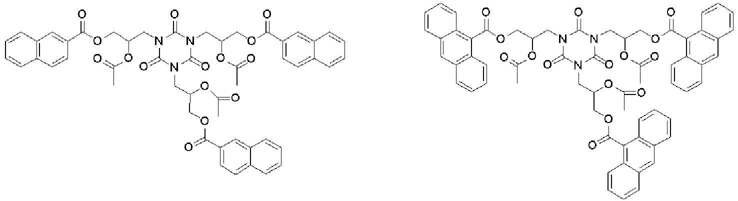

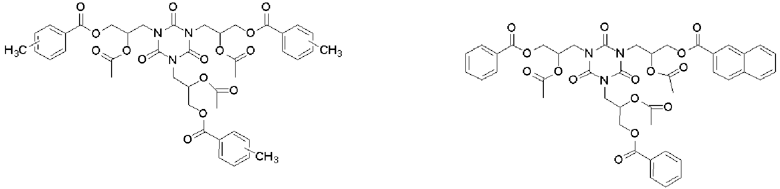

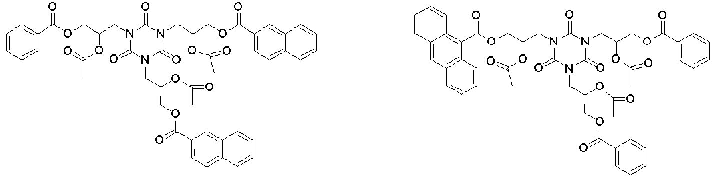

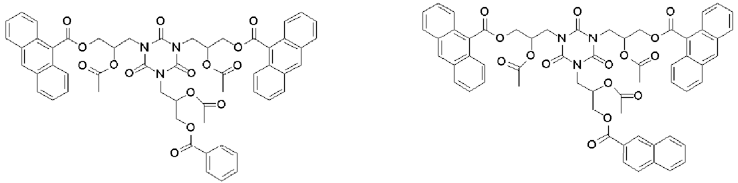

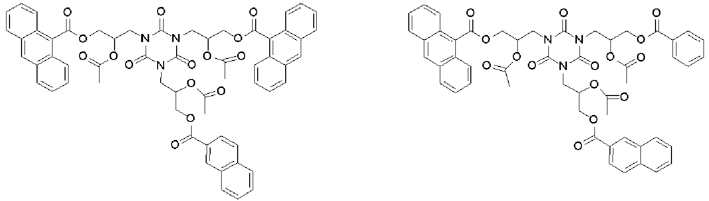

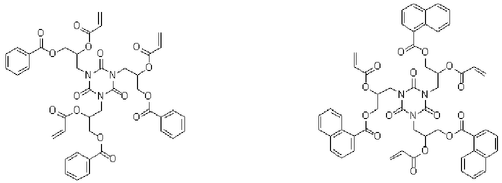

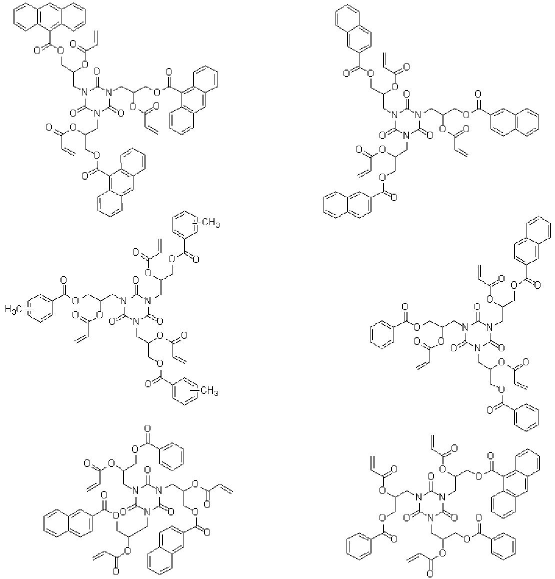

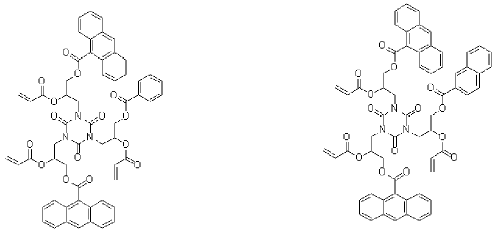

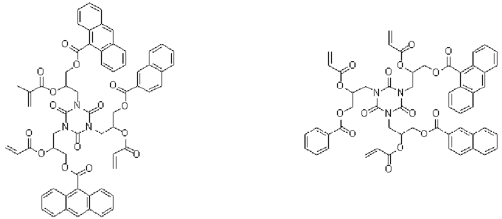

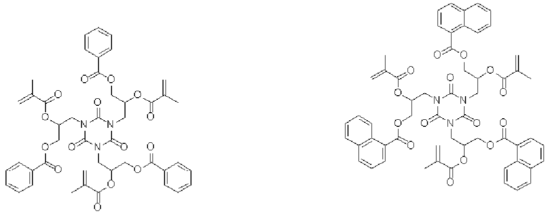

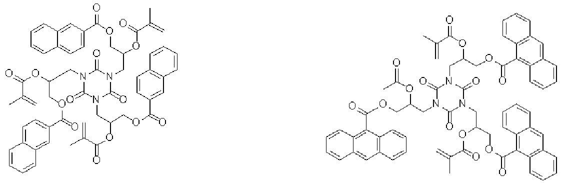

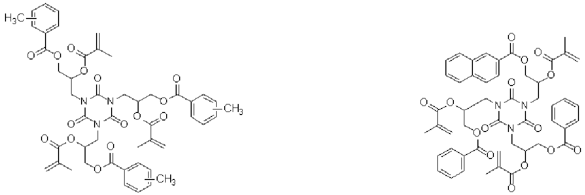

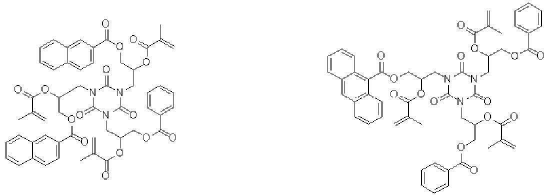

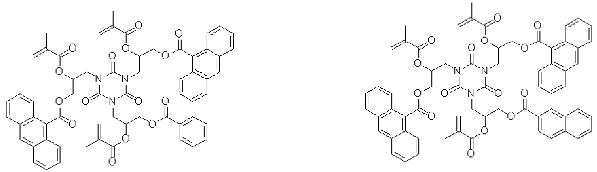

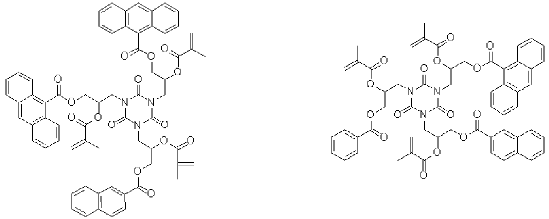

The molecular weight of the (B) crosslinking agent is preferably 500 to 1500, more preferably 600 to 1500, and a molecular weight falling within this range can allow filling ability and planeness to be imparted, and furthermore does not cause any outgas due to a too low molecular weight or any degradation of filling ability and/or planeness due to a too high molecular weight.

The molecular weight distribution of the (B) crosslinking agent (ratio Mw/Mn of weight average molecular weight Mw and number average molecular weight Mn in terms of polystyrene by gel permeation chromatography method) is preferably 1.00 ≤ Mw/Mn ≤ 1.25, and critically, the molecular weight distribution is 1.00 in the case of a monomolecular compound, but is difficult to exhibit a value of 1.00 because the molecular weight distribution depends on not only measurement conditions of an apparatus for measurement thereof, but also the polarity of a molecule used in the crosslinking agent, and furthermore a compound having a plurality of end group structures can also be used. Therefore, the above molecular weight distribution range is used as a preferred range in the present invention as a numerical value supposing that the crosslinking agent is a single molecule in order to indicate that the crosslinking agent is not a high-molecular weight body.

The amount of the (B) crosslinking agent compounded is preferably 1 to 50 parts by mass, more preferably 5 to 40 parts by mass based on 100 parts by mass of the (A) polymer compound.

When the amount of the (B) crosslinking agent compounded is 1 part by mass or more, the crosslinking agent, when used in the composition for forming a resist underlayer film, can absorb ultraviolet light particularly in a lithography process with a ultraviolet laser such as an ArF laser or a KrF laser, to suppress reflection. In addition, not only the above antireflective function, but also favorable resistance to alkaline hydrogen peroxide water, and excellent filling/planarization characteristics are exhibited.

When the amount of the (B) crosslinking agent compounded is 50 parts by mass or less, the crosslinking agent, when used in the composition for forming a resist underlayer film, exhibits favorable adhesiveness to a resist pattern. In addition, filling/planarization characteristics can be enhanced without deterioration in etching rate.

### [(C) Solvent]

The component (C) in the composition for forming a resist underlayer film of the present invention is an organic solvent. The (C) organic solvent usable in the resist underlayer film material of the present invention is not particularly limited as long as it can dissolve the (A) polymer compound and the (B) crosslinking agent, and may be an organic solvent which can also dissolve (D) an acid generator and (E) a surfactant described below. Specifically, a solvent described in paragraphs (0091) to (0092) in JP 2007-199653 A can be added. In particular, propylene glycol monomethyl ether acetate, propylene glycol monomethyl ether, propylene glycol monoethyl ether, propylene glycol monopropyl ether, 2-heptanone, cyclopentanone, cyclohexanone, 1-octanol, 2-ethylhexanol, 1-nonanol, 1-decanol, 1-undecanol, ethylene glycol, 1,2-propylene glycol, 1,3-butylene glycol, 2,4-pentane diol, 2-methyl-2,4-pentane diol, 2,5-hexane diol, 2,4-heptane diol, 2-ethyl-1,3-hexane diol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butane diol diacetate, 1,3-butylene glycol diacetate, 1,6-hexane diol diacetate, γ-butyrolactone, and a mixture of two or more kinds thereof are preferably used. The amount of the organic solvent compounded is desirably adjusted depending on the set thickness of the resist underlayer film, and is usually in the range of 500 to 10,000 parts by mass based on 100 parts by mass of the (A) polymer compound.

### [(D) Acid generator]

The (D) acid generator can be added to the composition for forming a resist underlayer film of the present invention in order to further promote a crosslinking reaction due to heat or the like. Examples of the acid generator include an acid generator which generates an acid by thermal decomposition, and an acid generator which generates an acid by light irradiation, and any of the acid generators can be added.

Examples of the (D) acid generator usable in the composition for forming a resist underlayer film of the present invention include
i. an onium salt also including the following formula (P1a-1), (P1a-2), (P1a-3) or (P1b):
ii. a diazomethane derivative also including the following formula (P2):
iii. a glyoxime derivative also including the following formula (P3):
iv. a bissulfone derivative also including the following formula (P4):
v. a sulfonate ester of a N-hydroxyimide compound, also including the following formula (P5):
vi. a β-ketosulfonic acid derivative,
vii. a disulfone derivative,
viii. a nitrobenzylsulfonate derivative, and
ix. a sulfonate ester derivative.

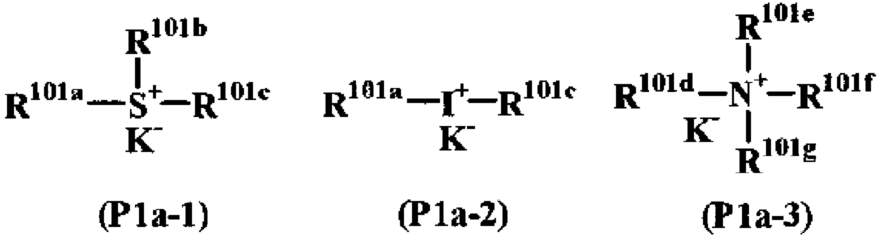

In the formulae, R^{101a}, R^{101b}, and R^{101c} each independently represent a linear, branched or cyclic alkyl group, alkenyl group, oxoalkyl group or oxoalkenyl group having 1 to 12 carbon atoms; an aryl group having 6 to 20 carbon atoms; or an aralkyl group or an aryloxoalkyl group having 7 to 12 carbon atoms. Some or all of hydrogen atoms in these groups are each optionally replaced by an alkoxy group or the like. R^{101b} and R^{101c} may form a ring, and in a case where the ring is formed, R^{101b} and R^{101c} each represent an alkylene group having 1 to 6 carbon atoms. K⁻ represents a non-nucleophilic counterion. R^{101d}, R^{101e}, R^{101f}, and R^{101g} are hydrogen atoms, or are defined as in R^{101a}, R^{101b}, and R^{101c}_{.} R^{101d} and R^{101e}, and R^{101d}, R^{101e} and R^{101f} may form a ring, and in a case where the ring is formed, R^{101d} and R^{101e}, and R¹⁰¹, R^{101e} and R^{101f} represent an alkylene group having 3 to 10 carbon atoms, or represent a heteroaromatic ring having a nitrogen atom in the formula, in the ring.

R^{101a}, R^{101b}, R^{101c}, R^{101d}, R^{101e}, R^{101f}, and R^{101g} described above may be the same as or different from one another, and specific examples of the alkyl group include a methyl group, an ethyl group, a propyl group, an isopropyl group, a n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, and an adamantyl group. Examples of the alkenyl group include a vinyl group, an allyl group, a propenyl group, a butenyl group, a hexenyl group, and a cyclohexenyl group. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, and a 2-(4-methylcyclohexyl)-2-oxoethyl group. Examples of the oxoalkenyl group include a 2-oxo-4-cyclohexenyl group and a 2-oxo-4-propenyl group. Examples of the aryl group include a phenyl group and a naphthyl group, and alkoxyphenyl groups such as a p-methoxyphenyl group, a m-methoxyphenyl group, an o-methoxyphenyl group, an ethoxyphenyl group, a p-tert-butoxyphenyl group and a m-tert-butoxyphenyl group; alkylphenyl groups such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups such as a methylnaphthyl group and an ethylnaphthyl group, and alkoxynaphthyl groups such as a methoxynaphthyl group and an ethoxynaphthyl group; dialkylnaphthyl groups such as a dimethylnaphthyl group and a diethylnaphthyl group; and dialkoxynaphthyl groups such as a dimethoxynaphthyl group and a diethoxynaphthyl group. Examples of the aralkyl group include a benzyl group, a phenylethyl group, and a phenethyl group. Examples of the aryloxoalkyl group include 2-aryl-2-oxoethyl groups such as a 2-phenyl-2-oxoethyl group, a 2-(1-naphthyl)-2-oxoethyl group, and a 2-(2-naphthyl)-2-oxoethyl group. Examples of the non-nucleophilic counterion of K⁻ include halide ions such as a chloride ion and a bromide ion, fluoroalkylsulfonates such as triflate, 1,1,1-trifluoroethanesulfonate, and nonafluorobutanesulfonate; arylsulfonates such as tosylate, benzenesulfonate, 4-fluorobenzenesulfonate, and 1,2,3,4,5-pentafluorobenzenesulfonate; alkylsulfonates such as mesylate and butanesulfonate; imide acids such as bis(trifluoromethylsulfonyl)imide, bis(perfluoroethylsulfonyl)imide and bis(perfluorobutylsulfonyl)imide, methide acids such as tris(trifluoromethylsulfonyl)methide and tris(perfluoroethylsulfonyl)methide, and furthermore a sulfonate represented by the following formula (K-1) and fluoro-replaced at the α-position and a sulfonate represented by the following formula (K-2) and fluoro-replaced at the α- and β-positions. 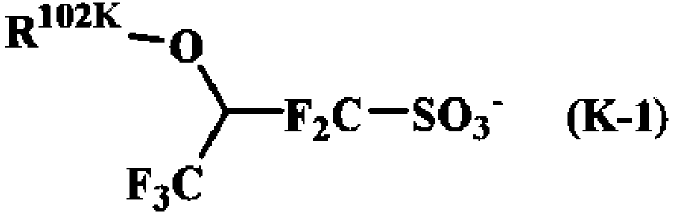 R^{103K}-F₂C-F₂C-SO3⁻ (K-2)

In the formula (K-1), R^{102K} is a hydrogen atom, a linear, branched or cyclic alkyl group having 1 to 20 carbon atoms, an acyl group, an alkenyl group having 2 to 20 carbon atoms, or an aryl group or an aryloxy group having 6 to 20 carbon atoms. In the formula (K-2), R^{103K} is a hydrogen atom, a linear, branched or cyclic alkyl group having 1 to 20 carbon atoms, an alkenyl group having 2 to 20 carbon atoms, or an aryl group having 6 to 20 carbon atoms.

Examples of the heteroaromatic ring having a nitrogen atom in the formula, in the ring, as R^{101d}, R^{101e}, R^{101f}, or R^{101g}, include imidazole derivatives (for example, imidazole, 4-methylimidazole, and 4-methyl-2-phenylimidazole), pyrazole derivatives, furazan derivatives, pyrroline derivatives (for example, pyrroline and 2-methyl-1-pyrroline), pyrrolidine derivatives (for example, pyrrolidine, N-methylpyrrolidine, pyrrolidinone, and N-methylpyrrolidone), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, and dimethylaminopyridine etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline and 3-quinolinecarbonitrile), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

The (P1a-1) and the (P1a-2) have the effect of both a photo-acid generator and a thermal acid generator, and the (P1a-3) acts as a thermal acid generator. 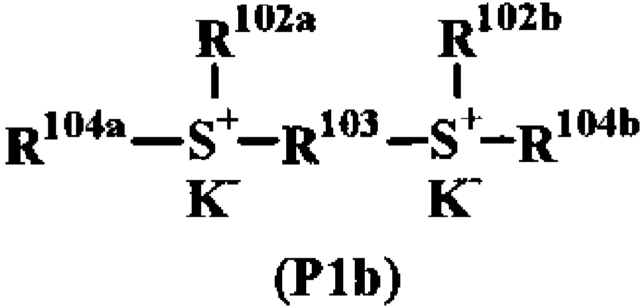 wherein R^{102a} and R^{102b} each represent a linear, branched or cyclic alkyl group having 1 to 8 carbon atoms; R¹⁰³ represents a linear, branched or cyclic alkylene group having 1 to 10 carbon atoms; R^{104a} and R^{104b} each represent a 2-oxoalkyl group having 3 to 7 carbon atoms; and K⁻ represents a non-nucleophilic counterion.

Specific examples of the alkyl group of R^{102a} and R^{102b} include a methyl group, an ethyl group, a propyl group, an isopropyl group, a n-butyl group, a sec-butyl group, a tert-butyl group, a pentyl group, a hexyl group, a heptyl group, an octyl group, a cyclopentyl group, a cyclohexyl group, a cyclopropylmethyl group, a 4-methylcyclohexyl group, and a cyclohexylmethyl group. Examples of the alkylene group of R¹⁰³ include a methylene group, an ethylene group, a propylene group, a butylene group, a pentylene group, a hexylene group, a heptylene group, an octylene group, nonylene group, a 1,4-cyclohexylene group, a 1,2-cyclohexylene group, a 1,3-cyclopentylene group, a 1,4-cyclooctylene group, and a 1,4-cyclohexanedimethylene group. Examples of the 2-oxoalkyl group of R^{104a} and R^{104b} include a 2-oxopropyl group, a 2-oxocyclopentyl group, a 2-oxocyclohexyl group, and a 2-oxocycloheptyl group. Examples of K⁻ can include the same as those described with respect to the formulae (P1a-1), (P1a-2) and (P1a-3). 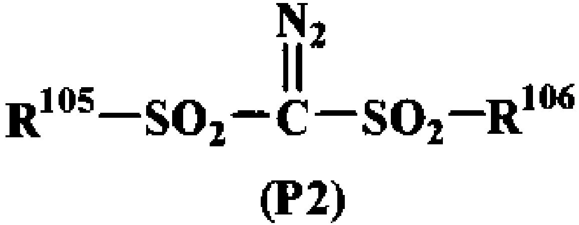 wherein R¹⁰⁵ and R¹⁰⁶ each represent a linear, branched or cyclic alkyl group or alkyl halide group having 1 to 12 carbon atoms, an aryl group or an aryl halide group having 6 to 20 carbon atoms, or an aralkyl group having 7 to 12 carbon atoms.

In R¹⁰⁵ and R¹⁰⁶, examples of the alkyl group include a methyl group, an ethyl group, a propyl group, an isopropyl group, a n-butyl group, a sec-butyl group, a tert-butyl group, a pentyl group, a hexyl group, a heptyl group, an octyl group, an amyl group, a cyclopentyl group, a cyclohexyl group, a cycloheptyl group, a norbornyl group, and an adamantyl group. Examples of the alkyl halide group include a trifluoromethyl group, a 1,1,1-trifluoroethyl group, a 1,1,1-trichloroethyl group, and a nonafluorobutyl group. Examples of the aryl group include a phenyl group, and alkoxyphenyl groups such as a p-methoxyphenyl group, a m-methoxyphenyl group, an o-methoxyphenyl group, an ethoxyphenyl group, a p-tert-butoxyphenyl group, and a m-tert-butoxyphenyl group, and alkylphenyl groups such as a 2-methylphenyl group, a 3-methylphenyl group, a 4-methylphenyl group, an ethylphenyl group, a 4-tert-butylphenyl group, a 4-butylphenyl group, and a dimethylphenyl group. Examples of the aryl halide group include a fluorophenyl group, a chlorophenyl group, and a 1,2,3,4,5-pentafluorophenyl group. Examples of the aralkyl group include a benzyl group and a phenethyl group. 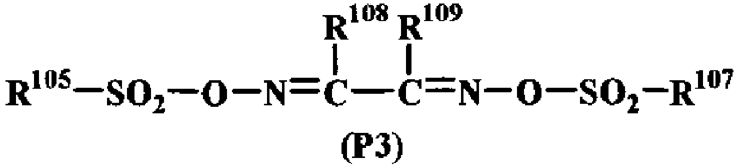 wherein R¹⁰⁷, R¹⁰⁸, and R¹⁰⁹ each represent a linear, branched or cyclic alkyl group or alkyl halide group having 1 to 12 carbon atoms, an aryl group or an aryl halide group having 6 to 20 carbon atoms, or an aralkyl group having 7 to 12 carbon atoms; R¹⁰⁸ and R¹⁰⁹ are optionally bonded to each other to form a cyclic structure, and in a case where the cyclic structure is formed, R¹⁰⁸ and R¹⁰⁹ each represent a linear or branched alkylene group having 1 to 6 carbon atoms; and R¹⁰⁵ is the same as in the formula (P2).

Examples of the alkyl group, the alkyl halide group, the aryl group, the aryl halide group, and the aralkyl group of R¹⁰⁷, R¹⁰⁸, and R¹⁰⁹ include the same groups as those described with respect to R¹⁰⁵ and R¹⁰⁶. Examples of the alkylene group of R¹⁰⁸ and R¹⁰⁹ include a methylene group, an ethylene group, a propylene group, a butylene group, and a hexylene group. 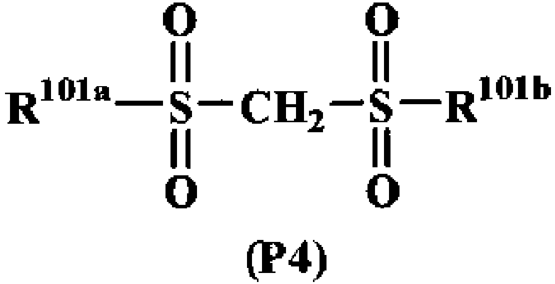 wherein R^{101a} and R^{101b} have the same meanings as those described above. 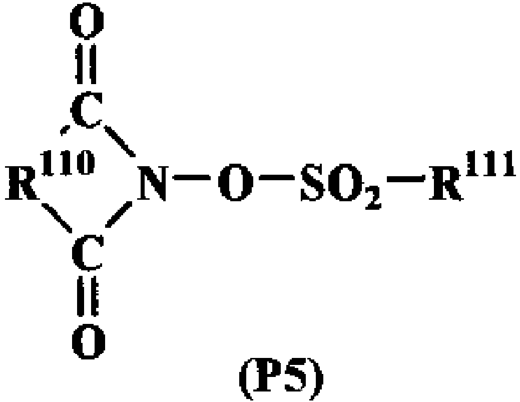 wherein R¹¹⁰ represents an arylene group having 6 to 10 carbon atoms, an alkylene group having 1 to 6 carbon atoms or an alkenylene group having 2 to 6 carbon atoms, and some or all of hydrogen atoms in these groups are each optionally further replaced by a linear or branched alkyl group or alkoxy group having 1 to 4 carbon atoms, a nitro group, an acetyl group, or a phenyl group; R¹¹¹ represents an linear, branched or substituted alkyl group, alkenyl group or alkoxyalkyl group having 1 to 8 carbon atoms, a phenyl group, or a naphthyl group, and some or all of hydrogen atoms in these groups are each optionally further replaced by an alkyl group or an alkoxy group having 1 to 4 carbon atoms; a phenyl group optionally replaced by an alkyl group or an alkoxy group having 1 to 4 carbon atoms, a nitro group or an acetyl group; a heteroaromatic group having 3 to 5 carbon atoms; or a chlorine atom or a fluorine atom.

With respect to R¹¹⁰, examples of the arylene group include a 1,2-phenylene group and a 1,8-naphthylene group, examples of the alkylene group include a methylene group, an ethylene group, a trimethylene group, a tetramethylene group, a phenylethylene group, and a norbornane-2,3-diyl group, and examples of the alkenylene group include a 1,2-vinylene group, a 1-phenyl-1,2-vinylene group, and a 5-norbornene-2,3-diyl group. With respect to R¹¹¹, examples of the alkyl group include the same as those with respect to R^{101a} to R^{101c}, examples of the alkenyl group include a vinyl group, a 1-propenyl group, an allyl group, a 1-butenyl group, a 3-butenyl group, an isoprenyl group, a 1-pentenyl group, a 3-pentenyl group, a 4-pentenyl group, a dimethylallyl group, a 1-hexenyl group, a 3-hexenyl group, a 5-hexenyl group, a 1-heptenyl group, a 3-heptenyl group, a 6-heptenyl group, and a 7-octenyl group, and examples of the alkoxyalkyl group include a methoxymethyl group, an ethoxymethyl group, a propoxymethyl group, a butoxymethyl group, a pentyloxymethyl group, a hexyloxymethyl group, a heptyloxymethyl group, a methoxyethyl group, an ethoxyethyl group, a propoxyethyl group, a butoxyethyl group, a pentyloxyethyl group, a hexyloxyethyl group, a methoxypropyl group, an ethoxypropyl group, a propoxypropyl group, a butoxypropyl group, a methoxybutyl group, an ethoxybutyl group, a propoxybutyl group, a methoxypentyl group, an ethoxypentyl group, a methoxyhexyl group, and a methoxyheptyl group.

Examples of the alkyl group having 1 to 4 carbon atoms, optionally further replaced, include a methyl group, an ethyl group, a propyl group, an isopropyl group, a n-butyl group, an isobutyl group, and a tert-butyl group, examples of the alkoxy group having 1 to 4 carbon atoms include a methoxy group, an ethoxy group, a propoxy group, an isopropoxy group, a n-butoxy group, an isobutoxy group, and a tert-butoxy group, examples of the phenyl group optionally replaced by an alkyl group or an alkoxy group having 1 to 4 carbon atoms, a nitro group or an acetyl group include a phenyl group, a tolyl group, a p-tert-butoxyphenyl group, a p-acetylphenyl group, and a p-nitrophenyl group, and examples of the heteroaromatic group having 3 to 5 carbon atoms include a pyridyl group and a furyl group.

Acid generators other than the above are specifically described below.
i. Examples of the onium salt can include onium salts such as tetramethylammonium trifluoromethanesulfonate, tetramethylammonium nonafluorobutanesulfonate, triethylammonium nonafluorobutanesulfonate, pyridinium nonafluorobutanesulfonate, triethylammonium camphorsulfonate, pyridinium camphorsulfonate, tetra-n-butylammonium nonafluorobutanesulfonate, tetraphenylammonium nonafluorobutanesulfonate, tetramethylammonium p-toluenesulfonate, diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, trinaphthylsulfonium trifluoromethanesulfonate, (2-norbornyl)methyl(2-oxocyclohexyl)sulfonium trifluoromethanesulfonate, ethylenebis[methyl(2-oxocyclopentyl)sulfonium trifluoromethanesulfonate], 1,2'-naphthalenecarbonylmethyl tetrahydrothiophenium triflate, triethylammonium nonaflate, tributylammonium nonaflate, tetraethylammonium nonaflate, tetrabutylammonium nonaflate, triethylammonium bis(trifluoromethylsulfonyl)imide, and triethylammonium tris(perfluoroethylsulfonyl)methide.
ii. Examples of the diazomethane derivative can include diazomethane derivatives such as bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-amylsulfonyl)diazomethane, bis(isoamylsulfonyl)diazomethane, bis(sec-amylsulfonyl)diazomethane, bis(tert-amylsulfonyl)diazomethane, 1-cyclohexylsulfonyl-1-(tert-butylsulfonyl)diazomethane, 1-cyclohexylsulfonyl-1-(tert-amylsulfonyl)diazomethane, and 1-tert-amylsulfonyl-1-(tert-butylsulfonyl)diazomethane.
iii. Examples of the glyoxime derivative can include glyoxime derivatives such as bis-O-(p-toluenesulfonyl)-α-dimethylglyoxime, bis-O-(p-toluenesulfonyl)-α-diphenylglyoxime, bis-O-(p-toluenesulfonyl)-α-dicyclohexylglyoxime, bis-O-(p-toluenesulfonyl)-2,3-pentanedioneglyoxime, bis-O-(p-toluenesulfonyl)-2-methyl-3,4-pentanedioneglyoxime, bis-O-(n-butanesulfonyl)-α-dimethylglyoxime, bis-O-(n-butanesulfonyl)-α-diphenylglyoxime, bis-O-(n-butanesulfonyl)-α-dicyclohexylglyoxime, bis-O-(n-butanesulfonyl)-2,3-pentanedioneglyoxime, bis-O-(n-butanesulfonyl)-2-methyl-3,4-pentanedioneglyoxime, bis-O-(methanesulfonyl)-α-dimethylglyoxime, bis-O-(trifluoromethanesulfonyl)-α-dimethylglyoxime, bis-O-(1,1,1-trifluoroethanesulfonyl)-α-dimethylglyoxime, bis-O-(tert-butanesulfonyl)-α-dimethylglyoxime, bis-O-(perfluorooctanesulfonyl)-α-dimethylglyoxime, bis-O-(cyclohexanesulfonyl)-α-dimethylglyoxime, bis-O-(benzenesulfonyl)-α-dimethylglyoxime, bis-O-(p-fluorobenzenesulfonyl)-α-dimethylglyoxime, bis-O-(p-tert-butylbenzenesulfonyl)-α-dimethylglyoxime, bis-O-(xylenesulfonyl)-α-dimethylglyoxime, and bis-O-(camphorsulfonyl)-α-dimethylglyoxime.
iv. Examples of the bissulfone derivative can include bissulfone derivatives such as bisnaphthylsulfonylmethane, bistrifluoromethylsulfonylmethane, bismethylsulfonylmethane, bisethylsulfonylmethane, bispropylsulfonylmethane, bisisopropylsulfonylmethane, bis-p-toluenesulfonylmethane, and bisbenzenesulfonylmethane.
v. Examples of the sulfonate ester derivative of an N-hydroxyimide compound include sulfonate ester derivatives of N-hydroxyimide compounds, such as N-hydroxysuccinimide methanesulfonate ester, N-hydroxysuccinimide trifluoromethanesulfonate ester, N-hydroxysuccinimide ethanesulfonate ester, N-hydroxysuccinimide 1-propanesulfonate ester, N-hydroxysuccinimide 2-propanesulfonate ester, N-hydroxysuccinimide 1-pentanesulfonate ester, N-hydroxysuccinimide 1-octanesulfonate ester, N-hydroxysuccinimide p-toluenesulfonate ester, N-hydroxysuccinimide p-methoxybenzenesulfonate ester, N-hydroxysuccinimide 2-chloroethanesulfonate ester, N-hydroxysuccinimide benzenesulfonate ester, N-hydroxysuccinimide -2,4,6-trimethylbenzenesulfonate ester, N-hydroxysuccinimide 1-naphthalenesulfonate ester, N-hydroxysuccinimide 2-naphthalenesulfonate ester, N-hydroxy-2-phenylsuccinimide methanesulfonate ester, N-hydroxymaleimide methanesulfonate ester, N-hydroxymaleimide ethanesulfonate ester, N-hydroxy-2-phenylmaleimide methanesulfonate ester, N-hydroxyglutarimide methanesulfonate ester, N-hydroxyglutarimide benzenesulfonate ester, N-hydroxyphthalimide methanesulfonate ester, N-hydroxyphthalimide benzenesulfonate ester, N-hydroxyphthalimide trifluoromethanesulfonate ester, N-hydroxyphthalimide p-toluenesulfonate ester, N-hydroxynaphthalimide methanesulfonate ester, N-hydroxynaphthalimide benzenesulfonate ester, N-hydroxy-5-norbornene-2,3-dicarboxyimide methanesulfonate ester, N-hydroxy-5-norbornene-2,3-dicarboxyimide trifluoromethanesulfonate ester, and N-hydroxy-5-norbornene-2,3-dicarboxyimide p-toluenesulfonate ester.
vi. Examples of the β-ketosulfone derivative can include β-ketosulfone derivatives such as 2-cyclohexylcarbonyl-2-(p-toluenesulfonyl)propane and 2-isopropylcarbonyl-2-(p-toluenesulfonyl)propane.
vii. Examples of the disulfone derivative can include disulfone derivatives such as a diphenyldisulfone derivative and a dicyclohexyldisulfone derivative.
viii. Examples of the nitrobenzylsulfonate derivative can include nitrobenzylsulfonate derivatives such as 2,6-dinitrobenzyl p-toluenesulfonate and 2,4-dinitrobenzyl p-toluenesulfonate.
ix. Examples of the sulfonate ester derivative can include sulfonate ester derivatives such as 1,2,3-tris(methanesulfonyloxy)benzene, 1,2,3-tris(trifluoromethanesulfonyloxy)benzene, and 1,2,3-tris(p-toluenesulfonyloxy)benzene.

Among them, in particular, an onium salt such as triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, tris(p-tert-butoxyphenyl)sulfonium p-toluenesulfonate, trinaphthylsulfonium trifluoromethanesulfonate, cyclohexylmethyl(2-oxocyclohexyl)sulfonium trifluoromethanesulfonate, (2-norbornyl)methyl(2-oxocyclohexyl)sulfonium trifluoromethanesulfonate, or 1,2'-naphthalenecarbonylmethyl tetrahydrothiophenium triflate; a diazomethane derivative such as bis(benzenesulfonyl)diazomethane, bis(p-toluenesulfonyl)diazomethane, bis(cyclohexylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, or bis(tert-butylsulfonyl)diazomethane; a glyoxime derivative such as bis-O-(p-toluenesulfonyl)-α-dimethylglyoxime or bis-O-(n-butanesulfonyl)-α-dimethylglyoxime; a bissulfone derivative such as bisnaphthylsulfonylmethane; or a sulfonate ester derivative of an N-hydroxyimide compound, such as N-hydroxysuccinimide methanesulfonate ester, N-hydroxysuccinimide trifluoromethanesulfonate ester, N-hydroxysuccinimide 1-propanesulfonate ester, N-hydroxysuccinimide 2-propanesulfonate ester, N-hydroxysuccinimide 1-pentanesulfonate ester, N-hydroxysuccinimide p-toluenesulfonate ester, N-hydroxynaphthalimide methanesulfonate ester, or N-hydroxynaphthalimide benzenesulfonate ester is preferably used.

The above acid generators can be used singly or in combinations of two or more kinds thereof.

The amount of the acid generator added is preferably 0.05 to 50 parts by mass, more preferably 0.1 to 10 parts by mass based on 100 parts by mass of the base resin. When the amount is 0.05 parts by mass or more, the amount of an acid generated is sufficient and a crosslinking reaction sufficiently progresses, and when the amount is 50 parts by mass or less, there is a small risk of a mixing phenomenon caused due to acid movement to an upper layer resist.

### [(E) Surfactant]

The (E) surfactant can be added to the composition for forming a resist underlayer film of the present invention, in order to enhance coatability by spin coating. The surfactant used here can be, for example, a surfactant described in paragraphs [0142] to [0147] in JP 2009-269953 A.

The amount of the surfactant added is preferably 0.001 to 20 parts by mass, more preferably 0.01 to 10 parts by mass based on 100 parts by mass of the base resin.

As described above, the composition for forming a resist underlayer film of the present invention preferably contains at least one selected from (D) an acid generator and (E) a surfactant. The above additive(s) can be added to the composition for forming a resist underlayer film of the present invention, in order to promote a crosslinking reaction due to heat or the like, and/or enhance coatability with spin coating, curability, planarization/filling characteristics, and the resolution during patterning in multi-layer lithography.

The composition for forming a resist underlayer film of the present invention preferably provides a resist underlayer film exhibiting resistance to ammonia-containing hydrogen peroxide water. The composition for forming a resist underlayer film can allow for formation of a resist underlayer film having favorable resistance to alkaline hydrogen peroxide water, and therefore can also be applied to a wet etching process with alkaline hydrogen peroxide water.

Alkaline hydrogen peroxide water is generally used for washing a semiconductor wafer. In particular, a mixed liquid of 5 parts by mass of deionized water, 1 part by mass of 29% by mass ammonia water, and 1 part by mass of 30% by mass hydrogen peroxide water is called SC1 (Standard Clean-1), and serves as a standard chemical liquid for washing and removal of organic impurities and/or fine particles on a wafer surface. Moreover, alkaline hydrogen peroxide water can allow for stripping or etching processing of not only some metals and metal compounds, but also a silicon-containing resist middle layer film designed for wet stripping. The compositional ratio of alkaline hydrogen peroxide water used in such processing is not particularly limited, and a mixture of deionized water, hydrogen peroxide, and ammonia is typical. In this case, the concentration of the hydrogen peroxide is preferably 0.1 to 10% by mass, more preferably 0.2 to 5% by mass, and the concentration of the ammonia is preferably 0.1 to 10% by mass, more preferably 0.2 to 5% by mass. The treatment temperature is preferably 0 to 90°C, more preferably 20 to 80°C.

A test of resistance to alkaline hydrogen peroxide water of the resist underlayer film is here described. First, a film of the resist underlayer film material is formed on a silicon wafer cut to 3-cm square so as to have a thickness of about 100 nm according to film formation conditions described below. This wafer piece is immersed in 1.0% by mass hydrogen peroxide water containing 0.5% by mass of ammonia at 70°C for 5 minutes, and subsequently rinsed with deionized water, and thereafter the presence of stripping of the resist underlayer film from the wafer can be visually examined. In a case where one portion or the entire of the resist underlayer film is stripped and a silicon wafer surface is exposed, the resist underlayer film subjected to the test is determined to be insufficient in resistance to alkaline hydrogen peroxide water.

In other words, a resist underlayer film formed from the composition for forming a resist underlayer film of the present invention is preferably a resist underlayer film which is not observed to be striped when a silicon substrate on which the resist underlayer film is formed is immersed in 1.0% by mass hydrogen peroxide water containing 0.5% by mass of ammonia at 70°C for 5 minutes.

In the present invention, the thickness of the resist underlayer film is appropriately selected, and is 5 to 20,000 nm, in particular, preferably 50 to 15,000 nm. In the case of a resist underlayer film for a three-layer resist process, a resist middle layer film containing silicon and a resist upper layer film not containing silicon can be formed thereon. In the case of a resist underlayer film for a two-layer resist process, a resist upper layer film containing silicon or a resist upper layer film not containing silicon can be formed thereon.

### (Resist underlayer film formation process)

The present invention provides a resist underlayer film formation process including coating a substrate to be processed, with the above composition for forming a resist underlayer film, and heat-treating the composition for forming a resist underlayer film at a temperature of 100°C or more and 300°C or less for a period in a range of 10 seconds to 600 seconds, to form a cured film.

The resist underlayer film formation process can form a resist underlayer film having favorable resistance to alkaline hydrogen peroxide water, excellent filling/planarization characteristics, and excellent dry etching characteristics. In addition, the baking temperature and time can be appropriately adjusted in the above ranges, thereby allowing planarization/filling characteristics and curing characteristics suitable for the intended use to be obtained.

In the resist underlayer film formation process of the present invention, a substrate to be processed is coated with the above composition for forming a resist underlayer film by use of a spin coating method or the like, thereafter the solvent is evaporated, and baking is performed in order to prevent mixing with a resist upper layer film or a resist middle layer film, or in order to promote a crosslinking reaction. The spin coating method can be used to provide favorable filling/planarization characteristics.

The baking is performed within a temperature range of 100°C or more and 500°C or less, preferably 100°C or more and 300°C or less, more preferably 150°C or more and 300°C or less, for a period within a range of 10 seconds to 600 seconds, preferably 10 to 300 seconds. The baking temperature and time can be appropriately adjusted in the above ranges, thereby allowing planarization/filling characteristics and curing characteristics suitable for the intended use to be obtained. When the baking temperature is 100°C or more, curing is sufficient, and there is not any risk of the occurrence of mixing with an upper layer film or an middle layer film. When the baking temperature is 300°C or less, thermal decomposition of a base resin does not remarkably occur, and there is not any risk of a decrease in thickness or the occurrence of a heterogeneous film surface.

The substrate to be processed, used in the resist underlayer film formation process of the present invention, is also preferably a substrate having a structure body or a stepped section having a height of 30 nm or more. The resist underlayer film formation process of the present invention is particularly useful in the case of formation of a void-free planarized organic film particularly on a substrate having a structure body or a stepped section having a height of 30 nm or more.

### (Patterning process)

The present invention provides a patterning process using the above composition for forming a resist underlayer film. The patterning process of the present invention is suitably used for a silicon-containing two-layer resist process, a three-layer resist process using a silicon-containing middle layer film, a four-layer resist process using a silicon-containing middle layer film and an organic antireflective film, or a multi-layer resist process such as a two-layer resist process without silicon.

In other words, the present invention provides, as a patterning process by a two-layer resist process, a patterning process on a substrate to be processed, the process including the steps of:
(I-1) applying the above-described composition for forming a resist underlayer film to the substrate to be processed, and thereafter performing heat treatment, to form a resist underlayer film;
(I-2) forming a resist upper layer film on the resist underlayer film using a composition for forming a resist upper layer film;
(I-3) subjecting the resist upper layer film to patten exposure and then development with a developer, to form a circuit pattern on the resist upper layer film; and (I-4) transferring a pattern by dry etching to the resist underlayer film using a resist upper layer film on which the circuit pattern is formed as a mask.

The present invention also provides, as a patterning process by a three-layer resist process, a patterning process on a substrate to be processed, the process including the steps of:
(II-1) applying the above-described composition for forming a resist underlayer film to the substrate to be processed, and thereafter performing heat treatment, to form a resist underlayer film;
(II-2) forming a silicon atom-containing resist middle layer film on the resist underlayer film;
(II-3) forming a resist upper layer film on the silicon atom-containing resist middle layer film using a composition for forming a resist upper layer film;
(II-4) subjecting the resist upper layer film to patten exposure and then development with a developer, to form a circuit pattern on the resist upper layer film;
(II-5) transferring a pattern by dry etching to the silicon atom-containing resist middle layer film using a resist upper layer film on which the circuit pattern is formed as a mask; and
(II-6) transferring a pattern by dry etching to the resist underlayer film using a silicon atom-containing resist middle layer film to which the pattern is transferred as a mask.

The present invention also provides, as a patterning process by a four-layer resist process, a patterning process on a substrate to be processed, the process including the steps of:
(III-1) applying the above-described composition for forming a resist underlayer film to the substrate to be processed, and thereafter performing heat treatment, to form a resist underlayer film;
(III-2) forming an inorganic hard mask selected from a silicon oxide film, a silicon nitride film, and a silicon oxynitride film, on the resist underlayer film;
(III-3) forming an organic antireflective film on the inorganic hard mask;
(III-4) forming a resist upper layer film on the organic antireflective film using a composition for forming a resist upper layer film;
(III-5) subjecting the resist upper layer film to patten exposure and then development with a developer, to form a circuit pattern on the resist upper layer film;
(III-6) transferring a pattern by dry etching to the organic antireflective film and the inorganic hard mask using a resist upper layer film on which the circuit pattern is formed as a mask; and
(III-7) transferring a pattern by dry etching to the resist underlayer film using an inorganic hard mask to which the pattern is transferred as a mask.

The patterning process of the present invention is described below with, as an example, a three-layer resist process using a silicon atom-containing resist middle layer film (silicon-containing resist middle layer film), but not limited thereto.

In this case, a resist underlayer film is formed on a substrate to be processed, using the above composition for forming a resist underlayer film, a resist middle layer film is formed on the resist underlayer film, using a silicon atom-containing resist middle layer film material, a resist upper layer film is formed on the resist middle layer film, using a photoresist material, to provide a multi-layer resist film, a pattern circuit region of the resist upper layer film is subjected to exposure (pattern exposure) and then development with a developer, to form a pattern on the resist upper layer film, the resist middle layer film is etched using a resist upper layer film on which the pattern is formed as a mask, to transfer a pattern, the resist underlayer film is etched using a resist middle layer film to which the pattern is transferred as a mask, to transfer a pattern, and furthermore the substrate to be processed is processed using a resist underlayer film to which the pattern is transferred as a mask, to form a pattern on the substrate to be processed.

The resist underlayer film in the three-layer resist process can be formed by coating the substrate to be processed, with the above resist underlayer film material, by use of a spin coating method or the like, thereafter evaporating the solvent, and performing baking in order to prevent mixing with a resist upper layer film or a resist middle layer film, or in order to promote a crosslinking reaction. A spin coating method or the like can be thus used to provide favorable filling characteristics. This underlayer film formation can be performed by the resist underlayer film formation process of the present invention.

The silicon atom-containing resist middle layer film exhibits resistance to etching by an oxygen gas or a hydrogen gas, and therefore etching of the resist underlayer film performed using the resist middle layer film as a mask as described above is preferably performed using an etching gas mainly containing an oxygen gas or a hydrogen gas.

A polysilsesquioxane-based middle layer film can be suitably used as the silicon-containing resist middle layer film in the three-layer resist process. The polysilsesquioxane-based middle layer film can easily have the reflection prevention effect, and thus an advantage is that reflection light can be suppressed during pattern exposure of the resist upper layer film and the resolution is excellent. In particular, in the case of 193-nm exposure, a material containing many aromatic groups is used for a resist underlayer film, to increase the k value and increase substrate reflection, whereas reflection can be suppressed by a resist middle layer film, to provide 0.5% or less of substrate reflection. In the resist middle layer film having the reflection prevention effect, anthracene is preferably used for 248-nm or 157-nm exposure, or polysilsesquioxane which has a phenyl group or a light-absorption group having a silicon-silicon bond, as a pendant, and which is crosslinked by an acid or heat is preferably used for 193-nm exposure.

In this case, formation of a silicon-containing resist middle layer film by a spin coating method is simpler and more advantageous in terms of cost than that by a CVD method.

The resist upper layer film in the three-layer resist process may be of a positive- or negative-type, and the same as any photoresist composition commonly used can be used. In a case where a single-layer resist upper layer film is formed with the photoresist composition, a spin coating method is preferably used as in the case of formation of the resist underlayer film. After spin coating with the photoresist composition, pre-bake is performed preferably at 60 to 180°C for a period in a range of 10 to 300 seconds. Thereafter, exposure is performed and post-exposure bake (PEB) and development are performed according to ordinary processes, to obtain a resist pattern. The thickness of the resist upper layer film is not particularly limited, and is 30 to 500 nm, in particular, preferably 50 to 400 nm.

Examples of the exposure light can include high-energy rays at a wavelength of 300 nm or less, specifically, excimer lasers at 248 nm, 193 nm, and 157 nm, soft X-rays at 3 to 20 nm, electron beam, and X-rays.

Next, etching is performed using the resulting resist pattern as a mask. Etching of the resist middle layer film in the three-layer resist process is performed with a chlorofluorocarbon-based gas, using the resist pattern as a mask. Next, etching processing of the resist underlayer film is performed with an oxygen gas or a hydrogen gas, using the resist middle layer film pattern as a mask.

The next etching of the substrate to be processed can also be performed by an ordinary process, and, for example, when the substrate is SiO₂, SiN, or a silica-based low dielectric insulating film, etching mainly with a chlorofluorocarbon-based gas is performed, and when the substrate is p-Si, Al, or W, etching mainly with a chlorine- or bromine-based gas is performed. In a case where substrate processing is made by etching with a chlorofluorocarbon-based gas, the resist middle layer film (silicon-containing resist middle layer film) in the three-layer resist process is stripped at the same time as the substrate processing. In a case where the substrate is etched with a chlorine- or bromine-based gas, stripping of the silicon-containing resist middle layer film is needed to be separately performed by dry etching with a chlorofluorocarbon-based gas after the substrate processing.

The substrate to be processed is a substrate on which a layer to be processed is formed. The substrate is not particularly limited, a different material from that of the layer to be processed, such as Si, α-Si, p-Si, SiO₂, SiN, SiON, W, TiN, or Al is used. The layer to be processed, used here, is any of various Low-k films such as Si, SiO₂, SiON, SiN, p-Si, α-Si, W, TiN, W-Si, Al, Cu, and Al-Si, and stopper films thereof, and is usually formed at a thickness of 50 to 10,000 nm, in particularly, 100 to 5,000 nm.

The patterning process of the present invention can be here applied, thereby allowing for construction of not only a common processing process described above, but also various special processing process, and is industrially valuable.

First, while it is generally essential for stripping of silicon-containing resist middle layer films to perform stripping by dry etching as described above, the patterning process of the present invention can also allow for selection of wet stripping of only the silicon-containing resist middle layer film with alkaline hydrogen peroxide water because the resist underlayer film has resistance to alkaline hydrogen peroxide water. In other words, a step of removing the resist middle layer film to which the pattern is transferred, by wet etching with alkaline hydrogen peroxide water, after the step (II-6) may be added to the patterning process by a three-layer resist process of the present invention.

In a case where the substrate to be processed is W, TiN, or the like, the patterning process of the present invention can be applied to allow for selection of wet etching processing of the substrate with alkaline hydrogen peroxide water. In other words, a step of transferring a pattern to the substrate to be processed, by wet etching with alkaline hydrogen peroxide water using a resist underlayer film on which the pattern is transferred as a mask, after the step (I-4), step (II-6), or step (III-7), may be further added to the patterning processes by any of two-layer, three-layer, and four-layer resist processes of the present invention.

In one example of the process in such a case, first, a resist underlayer film is formed on a substrate to be processed, a resist middle layer film is, if necessary, formed thereon, and then a resist upper layer film is formed. Subsequently, a pattern is transferred to the resist underlayer film by patterning and then etching the resist upper layer film by an ordinary process. Finally, the substrate to be processed can be patterned by wet etching, using the resist underlayer film as a mask.

In the present invention, a step of transferring a pattern to the substrate to be processed, by dry etching using a resist underlayer film to which the pattern is transferred as a mask, after the step (I-4), the step (II-6), or the step (III-7), may be further added.

A step of performing an ion implantation using a resist underlayer film on which the pattern is transferred as a mask, to perform pattern-processing of the substrate to be processed, after the step (I-4), step (II-6), or step (III-7), may be further added to the patterning processes by any of two-layer, three-layer, and four-layer resist processes of the present invention. Here, a step of removing the resist middle layer film to which the pattern is transferred, by wet etching with alkaline hydrogen peroxide water, after the step of performing an ion implantation to perform pattern-processing of the substrate to be processed, may be further added.

The patterning process of the present invention is also suitable for processing a stepped substrate having a structure body or a stepped section having a height of 30 nm or more. Hereinafter, one example of the process is described.

First, a resist underlayer film is formed on a stepped substrate, to perform filling/planarization, a resist middle layer film is, if necessary, formed, and then a resist upper layer film is formed. Next, the resist upper layer film is patterned by an ordinary process, and subsequently the pattern is transferred to the resist underlayer film by etching. Next, the substrate can be pattern-processed by an ion implantation using the resist underlayer film as a mask. Stripping of the remaining resist middle layer film can be, if necessary, performed by any etching selected from dry etching and wet etching. Finally, the resist underlayer film can be removed by dry etching.

The composition for forming a resist underlayer film, used here, is preferably a composition for forming a resist underlayer film having a dry etching rate higher than a dry etching rate of the resist upper layer film. Use of the resist underlayer film material (namely, a high dry etching rate of a resist underlayer film formed) is more preferred because removal without any residue can be performed by dry etching also in a location in which such removal is generally difficult, such as a corner portion of a stepped section of the substrate.

The patterning process of the present invention can form a pattern on a substrate to be processed at least by forming a resist underlayer film on a substrate to be processed using the above composition for forming a resist underlayer film, forming an inorganic hard mask middle layer film selected from a silicon oxide film, a silicon nitride film, and a silicon oxynitride film, on the resist underlayer film, forming a resist upper layer film on the inorganic hard mask middle layer film using a photoresist material, to subject a pattern circuit region of the resist upper layer film to exposure and then development with a developer, to form a pattern on the resist upper layer film, etching the inorganic hard mask middle layer film using a resist upper layer film to which the pattern is formed as a mask, to transfer a pattern, etching the resist underlayer film using an inorganic hard mask middle layer film to which the pattern is transferred as a mask, to transfer a pattern, and processing the substrate to be processed, using a resist underlayer film to which the pattern is transferred as a mask.

When the inorganic hard mask middle layer film is formed on the resist underlayer film as described above, a silicon oxide film, a silicon nitride film, or a silicon oxynitride film (SiON film) is formed by a CVD process, an ALD process, or the like. A process for forming a nitride film is described in JP 2002-334869 A or WO 2004/066377. The thickness of the inorganic hard mask is 5 to 200 nm, preferably 10 to 100 nm, and in particular, a SiON film highly effective as an antireflective film is most preferably used.

The present invention can also be suitably used for a four-layer resist process using an organic antireflective film. In this case, a pattern is formed on a substrate to be processed at least by forming a resist underlayer film on a substrate to be processed using the above composition for forming a resist underlayer film, forming an inorganic hard mask middle layer film selected from a silicon oxide film, a silicon nitride film, and a silicon oxynitride film on the resist underlayer film, forming an organic antireflective film on the inorganic hard mask middle layer film, forming a resist upper layer film on the organic antireflective film using a photoresist material, to subject a pattern circuit region of the resist upper layer film to exposure and then development with a developer, to form a pattern on the resist upper layer film, etching the organic antireflective film and the inorganic hard mask middle layer film using a resist upper layer film on which the pattern is formed as a mask, to transfer a pattern, etching the resist underlayer film using an inorganic hard mask middle layer film to which the pattern is transferred as a mask, to transfer a pattern, and processing the substrate to be processed using a resist underlayer film to which the pattern is transferred as a mask.

A photoresist film may be formed as the resist upper layer film on the resist middle layer film, or as described above, the organic antireflective film (BARC) may be formed on the resist middle layer film by spin coating and a photoresist film may be formed thereon. In a case where a SiON film is used as the resist middle layer film, reflection can be suppressed by a two-layer antireflective film of the SiON film and the BARC film even in liquid-immersion exposure at a high NA of more than 1.0. Another advantage by formation of BARC is that the effect of reducing trailing of a photoresist pattern immediately above SiON is exerted.

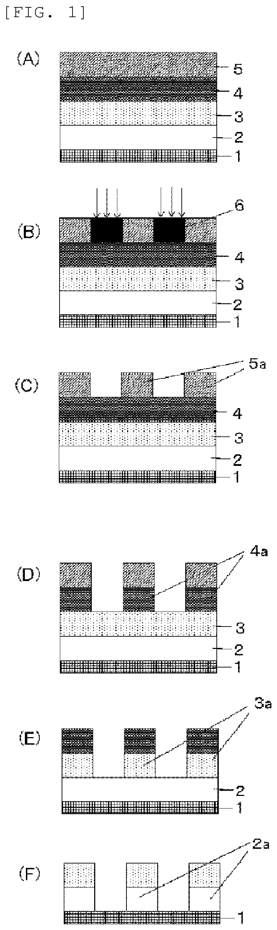

One example of the three-layer resist process is specifically shown with reference to FIG. 1, as follows.

In the case of the three-layer resist process, a resist underlayer film 3 is formed on a layer to be processed 2 stacked on a substrate 1, and thereafter a resist middle layer film 4 is formed thereon and a resist upper layer film 5 is formed thereon, as illustrated in FIG. 1(A).

Next, as illustrated in FIG. 1(B), a required portion 6 of the resist upper layer film is exposed, and subjected to PEB (post-exposure bake) and development, to form a resist pattern 5a (FIG. 1(C)). The resist middle layer film 4 is etched and processed using the resulting resist pattern 5a as a mask and using a CF-based gas, to form a resist middle layer film pattern 4a (FIG. 1(D)). After removal of the resist pattern 5a, the resist underlayer film 3 is subjected to oxygen-based or hydrogen-based plasma etching using the resulting resist middle layer film pattern 4a as a mask, to form a resist underlayer film pattern 3a (FIG. 1(E)). Furthermore, after removal of the resist middle layer film pattern 4a, the layer to be processed 2 is etched and processed using the resist underlayer film pattern 3a as a mask, to form a pattern 2a (FIG. 1(F)).

In a case where an inorganic hard mask middle layer film is adopted, the resist middle layer film 4 corresponds to the inorganic hard mask middle layer film, and in a case where BARC is laid, a BARC layer is provided between the resist middle layer film 4 and the resist upper layer film 5. BARC may be etched subsequently prior to etching of the resist middle layer film 4, or only BARC can be etched and then, for example, an etching apparatus can be exchanged, to etch the resist middle layer film 4.

Hereinafter, the present invention is described in detail, but the present invention is not limited thereto.

### EXAMPLE

The dispersity (Mw/Mn) was determined from the weight average molecular weight (Mw) and the number average molecular weight (Mn) in terms of polystyrene, as measured by gel permeation chromatography (GPC) performed with (THF) as an eluent.

Hereinafter, polymer compounds (A1) to (A6) synthesized in Synthesis Examples, and polymer compounds (R1) to (R4) for Comparative Examples are shown.

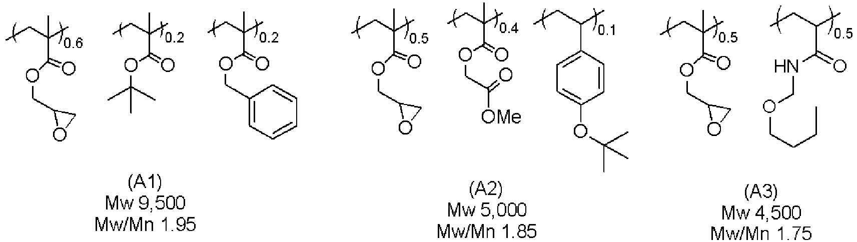

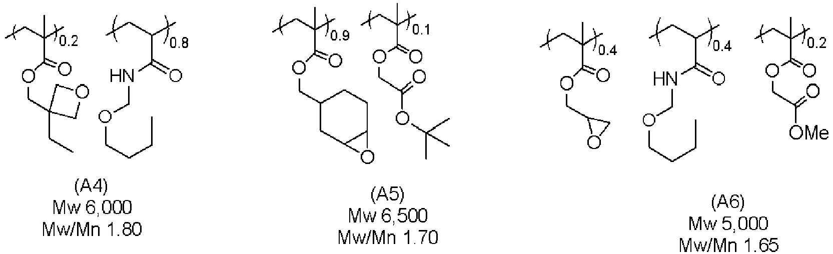

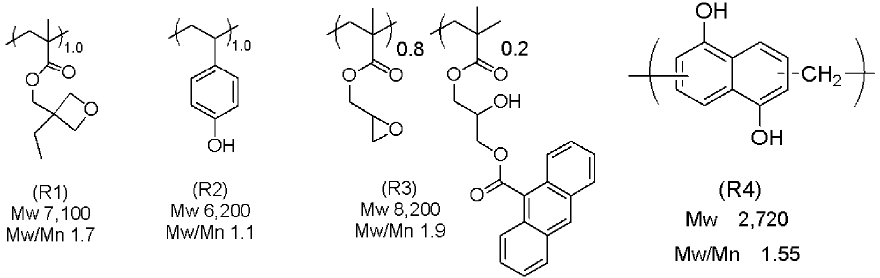

### [Synthesis Example 1] Synthesis of polymer compound (A1)

Heated and stirred was 38.9 g of propylene glycol monomethyl ether acetate (hereinafter, designated as "PGMEA") at 80°C under a nitrogen atmosphere. A mixture of 29.7 g of glycidyl methacrylate, 8.9 g of tert-butyl acrylate, 11.3 g of benzyl acrylate, and 38.9 g of PGMEA, and a mixture of 4.0 g of dimethyl 2,2-azobis(2-methylpropionate) and 38.9 g of PGMEA were simultaneously and separately added thereto over 4 hours. After further heating and stirring for 20 hours, the mixtures were cooled to room temperature to obtain an objective PGMEA solution of polymer compound (A1).

As a result of analysis, polymer compound (A1) had a weight average molecular weight (Mw) of 9,500 and a dispersity (Mw/Mn) of 1.95.

### [Synthesis Examples 2 to 9] Synthesis of polymer compounds (A2) to (A6), and polymer compounds (R1) to (R3) for Comparative Examples

Respective PGMEA solutions of polymer compounds (A2) to (A6) and polymer compounds (R1) to (R3) for Comparative Examples were obtained by the same method as in Synthesis Example 1 except that the types and molar ratios of raw material monomers used were changed according to structures of the polymer compounds. A synthesis process of (R4) was as follows.

### [Synthesis Example 10] Synthesis of polymer compound (R4) for Comparative Examples.

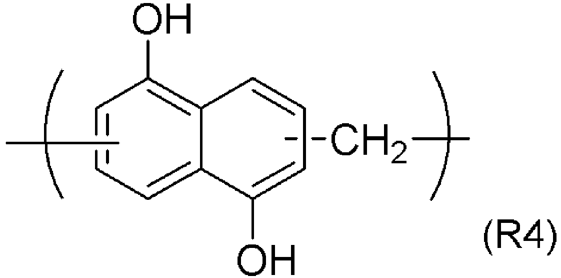

After 78.8 g of 2,7-dipropargyloxynaphthalene, 21.6 g of 37% formalin solution, and 250 g of 1,2-dichloroethane were formed into a homogeneous solution at a liquid temperature of 70°C under a nitrogen atmosphere, 5 g of methanesulfonic acid was slowly added thereto, and these were stirred at a liquid temperature of 80°C for 12 hours. After cooling to room temperature, 500 g of methyl isobutyl ketone was added, an organic layer was washed with 200 g of pure water five times, and thereafter the organic layer was dried under reduced pressure. Three hundred mL of THF was added to the residue, and a polymer was re-precipitated by 2,000 mL of hexane. The polymer precipitated was separated by filtration, and dried under reduced pressure, to obtain polymer compound (R4).

### [Preparation of compositions for forming resist underlayer film (UDL-1 to 14 and Comparative Examples UDL-1 to 8)]

Polymer compounds (A1) to (A6) within the scope of the component (A) in the present invention and (R1) to (R4) out of this scope; crosslinking agents (B1) to (B7) within the scope of the component (B) in the present invention, (X1), (B8) and (B9) out of this scope; and acid generators (AG1) to (AG3) were dissolved at proportions shown in Table 1, in a solvent containing 0.05% by mass of PF-6320 (in-house purified, manufactured by OMNOVA) as a surfactant, and filtered with a 0.1-µm fluororesin filter, to prepare compositions for forming a resist underlayer film (UDL-1 to 14, and Comparative Examples UDL-1 to 8). In Table 1, PGMEA represents propylene glycol monomethyl ether acetate.

**[Table 1]**

| Composition | Polymer compound | | Crosslinking agent | | Acid generator | Solvent | |
|---|---|---|---|---|---|---|---|
| | Type | parts by mass | Type | parts by mass | Type/parts by mass | Type | parts by mass |
| UDL-1 | (A1) | 100 | B1 | 20 | None | PGMEA | 800 |
| UDL-2 | (A1) | 100 | B2 | 20 | None | PGMEA | 800 |
| UDL-3 | (A1) | 100 | B3 | 20 | None | PGMEA | 800 |
| UDL-4 | (A1) | 100 | B4 | 20 | None | PGMEA | 800 |
| UDL-5 | (A1) | 100 | B5 | 20 | None | PGMEA | 800 |
| UDL-6 | (A1) | 100 | B6 | 20 | None | PGMEA | 800 |
| UDL-7 | (A1) | 100 | B7 | 20 | None | PGMEA | 800 |
| UDL-8 | (A2) | 100 | B3 | 20 | AG1(2) | PGMEA | 800 |
| UDL-9 | (A3) | 100 | B3 | 20 | AG1(2) | PGMEA | 800 |
| UDL-10 | (A4) | 100 | B3 | 20 | AG1(2) | PGMEA | 800 |
| UDL-11 | (A5) | 100 | B3 | 20 | AG1(2) | PGMEA | 800 |
| UDL-12 | (A6) | 100 | B3 | 20 | AG1(2) | PGMEA | 800 |
| UDL-13 | (A3) | 100 | B3 | 5 50 | AG2(2) | PGMEA | 800 |
| UDL-14 | (A3) | 100 | B3 | | AG3(2) | PGMEA | 800 |
| Comparative Example UDL-1 | (A1) | 100 | None | 0 | None | PGMEA | 800 |
| Comparative Example UDL-2 | (R1) | 100 | B1 | 20 | None | PGMEA | 800 |
| Comparative Example UDL-3 | (R2) | 100 | B2 | 20 | None | PGMEA | 800 |
| Comparative Example UDL-4 | (R3) | 100 | B3 | 20 | None | PGMEA | 800 |
| Comparative Example UDL-5 | (R4) | 100 | B3 | 20 | None | PGMEA | 800 |
| Comparative Example UDL-6 | (A1) | 100 | X1 | 20 | None | PGMEA | 800 |
| Comparative Example UDL-7 | (A1) | 100 | B8 | 20 | None | PGMEA | 800 |
| Comparative Example UDL-8 | (A1) | 100 | B9 | 20 | None | PGMEA | 800 |

In Table 1 above, the details of crosslinking agents (B1) to (B9) are as follows. (BR1) to (B7) are within the scope of the formula (B-1) in the present invention. (B8) and (B9) are out of this scope. The Mw and Mw/Mn of each of the compounds as measured by GPC (eluent THF) are shown.

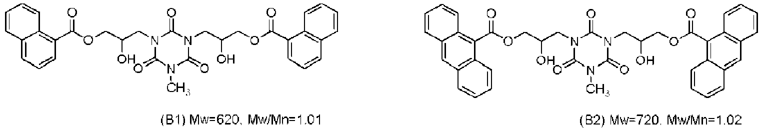

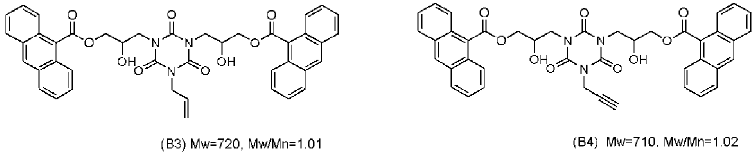

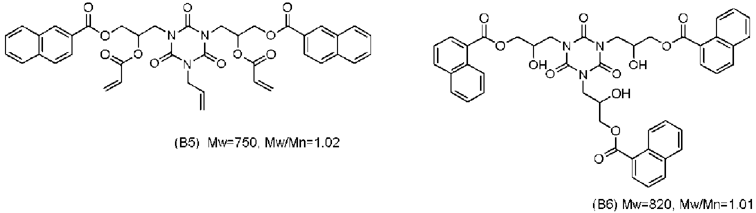

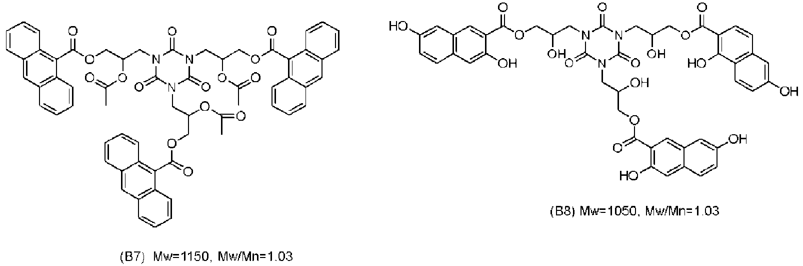

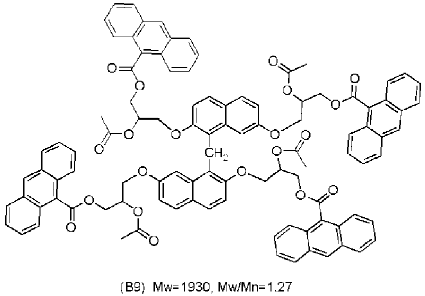

### [Synthesis of crosslinking agents (B1) to (B8)]

In Table 1 above, crosslinking agent (Bl) was synthesized as follows.

### Synthesis of crosslinking agent (B1)

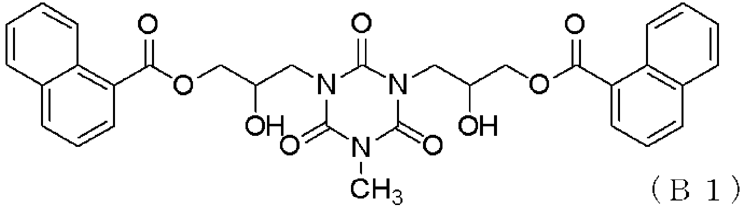

Under a nitrogen atmosphere, a three-necked flask equipped with a thermometer and a reflux tube was loaded with 10.0 g (39.2 mmol) of monomethyl diglycidyl isocyanurate (manufactured by Shikoku Chemicals Corporation), 13.5 g (78.4 mmol) of 1-naphthoic acid, and 50.0 g of PGME (1-methoxypropanol). After the temperature was raised to an internal temperature of 80°C and a homogeneous solution was formed, 0.89 g (3.9 mmol) of benzyltriethylammonium chloride was added, and a reaction was performed in an oil bath at 120°C for 6 hours. After the reaction was stopped, the reaction liquid was diluted with 200 ml of toluene and then transferred to a separating funnel, and washed with 50 g of an aqueous 3% NaHCO₃ solution, 50 g of an aqueous 3% nitric acid solution, and 50 ml of ultrapure water five times in the listed order. The organic phase was recovered, and concentrated to dryness, to obtain crosslinking agent (B1).

The weight average molecular weight (Mw) and the dispersity (Mw/Mn) were determined by GPC, and the following results were obtained.
(B1): Mw = 620, Mw/Mn = 1.01.

Crosslinking agents (B2) to (B4), (B6), and (B8) were obtained in the same manner by the same method as in (B1), except that epoxy compounds and carboxylic acid compounds corresponding to structural formulae were used as raw materials with respect to (B2) to (B4), (B6), and (B8) .

### Synthesis of crosslinking agent (B5)

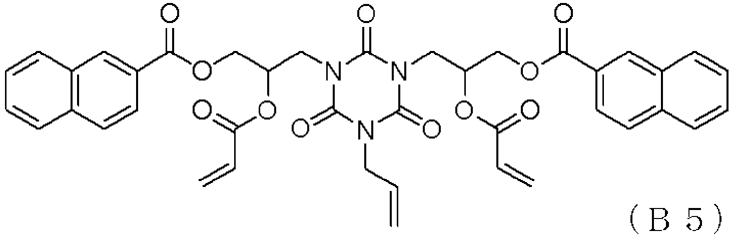

Under a nitrogen atmosphere, a three-necked flask equipped with a thermometer and a reflux tube was loaded with 10.0 g (35.6 mmol) of monoallyl diglycidyl isocyanurate (manufactured by Shikoku Chemicals Corporation), 12.2 g (71.1 mmol) of 2-naphthoic acid, 50.0 g of PGME (1-methoxypropanol). After the temperature was raised to an internal temperature of 80°C and a homogeneous solution was formed, 0.81 g (3.6 mmol) of benzyltriethylammonium chloride was added, and a reaction was performed in an oil bath at 120°C for 6 hours. After the reaction was stopped, the reaction liquid was diluted with 200 ml of toluene and then transferred to a separating funnel, and washed with 50 g of an aqueous 3% NaHCO₃ solution and 50 ml of ultrapure water four times in the listed order. The organic phase was recovered, and concentrated to dryness, 60 g of DMF (dimethylformamide) was further added to provide a homogeneous solution, and the homogeneous solution was recovered. The DMF solution recovered above and 14.4 g (142.2 mmol) of triethyl amine were added to a three-necked flask equipped with a thermometer and a reflux tube under a nitrogen atmosphere, and formed into a homogeneous solution at room temperature. After the temperature was raised to an internal temperature of 40°C and a homogeneous solution was formed, 9.7 g (106.6 mmol) of acrylic acid chloride was slowly added, and a reaction was performed in an oil bath at 40°C for 6 hours. After the reaction was stopped, 20 g of water was added to quench the reaction, the reaction liquid was diluted with 200 ml of MIBK (methyl isobutyl ketone) and then transferred to a separating funnel, and washed with 50 g of an aqueous 3% NaHCO₃ solution twice, 50 g of an aqueous 3% nitric acid solution twice, and 50 ml of ultrapure water five times in the listed order. The organic phase was recovered, and concentrated to dryness, to obtain crosslinking agent (B5). The weight average molecular weight (Mw) and the dispersity (Mw/Mn) were determined by GPC, and the following results were obtained.
(B5): Mw = 750, Mw/Mn = 1.02.

### Synthesis of crosslinking agent (B7)

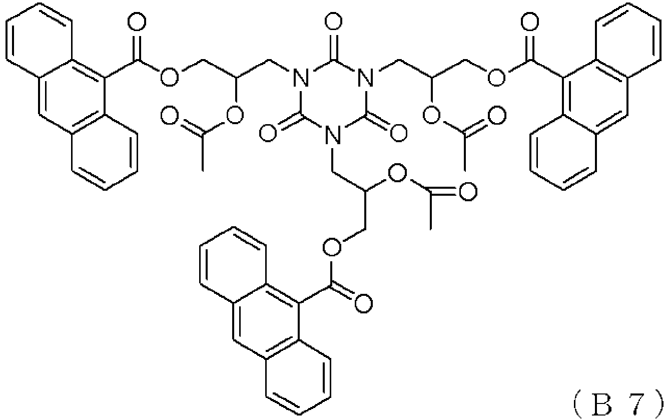

Under a nitrogen atmosphere, a three-necked flask equipped with a thermometer and a reflux tube was loaded with 10.0 g (33.6 mmol) of triglycidyl isocyanurate (manufactured by Nissan Chemical Corporation), 22.4 g (100.6 mmol) of 9-anthracene carboxylic acid, and 70.0 g of PGME (1-methoxypropanol). After the temperature was raised to an internal temperature of 80°C and a homogeneous solution was formed, 1.15 g (5.0 mmol) of benzyltriethylammonium chloride was added, and a reaction was performed in an oil bath at 120°C for 6 hours. After the reaction was stopped, the reaction liquid was diluted with 200 ml of toluene and then transferred to a separating funnel, and washed with 50 g of an aqueous 3% NaHCO₃ solution and 50 ml of ultrapure water four times in the listed order. The organic phase was recovered, and concentrated to dryness, 80 g of DMF (dimethylformamide) was further added to provide a homogeneous solution, and the homogeneous solution was recovered. The DMF solution recovered above and 13.3 g (167.6 mmol) of pyridine were added to a three-necked flask equipped with a thermometer and a reflux tube under a nitrogen atmosphere, and formed into a homogeneous solution at room temperature. After the temperature was raised to an internal temperature of 40°C and a homogeneous solution was formed, 13.7 g (134.1 mmol) of acetic anhydride was slowly added, and a reaction was performed in an oil bath at 40°C for 6 hours. After the reaction was stopped, 20 g of water was added to quench the reaction, the reaction liquid was diluted with 200 ml of MIBK (methyl isobutyl ketone) and then transferred to a separating funnel, and washed with 50 g of an aqueous 3% NaHCO₃ solution twice, 50 g of an aqueous 3% nitric acid solution twice, and 50 ml of ultrapure water five times in the listed order. The organic phase was recovered, and concentrated to dryness, to obtain crosslinking agent (B7). The weight average molecular weight (Mw) and the dispersity (Mw/Mn) were determined by GPC, and the following results were obtained.
(B7): Mw = 1150, Mw/Mn = 1.03.

### [Synthesis of crosslinking agent (B9) as comparative compound]

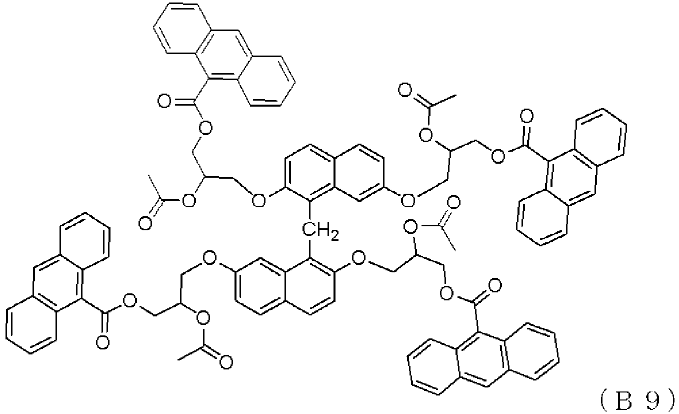

Under a nitrogen atmosphere, a three-necked flask equipped with a thermometer and a reflux tube was loaded with 10.0 g (corresponding to 60.6 mmol in terms of epoxy group) of HP-4700 (manufactured by DIC Corporation, epoxy equivalent 165 g/eq.), 13.5 g (60.6 mmol) of 9-anthracene carboxylic acid, and 70.0 g of PGME (1-methoxypropanol). After the temperature was raised to an internal temperature of 80°C and a homogeneous solution was formed, 0.69 g (3.0 mmol) of benzyltriethylammonium chloride was added, and a reaction was performed in an oil bath at 120°C for 6 hours. After the reaction was stopped, the reaction liquid was diluted with 200 ml of MIBK and then transferred to a separating funnel, and washed with 50 g of an aqueous 3% NaHCO₃ solution and 50 ml of ultrapure water four times in the listed order. The organic phase was recovered, and concentrated to dryness, 80 g of DMF (dimethylformamide) was further added to provide a homogeneous solution, and the homogeneous solution was recovered. The DMF solution recovered above and 6.2 g (78.8 mmol) of pyridine were added to a three-necked flask equipped with a thermometer and a reflux tube under a nitrogen atmosphere, and formed into a homogeneous solution at room temperature. After the temperature was raised to an internal temperature of 40°C and a homogeneous solution was formed, 7.4 g (72.7 mmol) of acetic anhydride was slowly added, and a reaction was performed in an oil bath at 40°C for 6 hours. After the reaction was stopped, 20 g of water was added to quench the reaction, the reaction liquid was diluted with 200 ml of MIBK and then transferred to a separating funnel, and washed with 50 g of an aqueous 3% NaHCO₃ solution twice, 50 g of an aqueous 3% nitric acid solution twice, and 50 ml of ultrapure water five times in the listed order. The organic phase was recovered, and concentrated to dryness, to obtain crosslinking agent (B9). The weight average molecular weight (Mw) and the dispersity (Mw/Mn) were determined by GPC, and the following results were obtained.
(B9): Mw = 1930, Mw/Mn = 1.27.

In Table 1 above, the details of acid generators (AG1) to (AG3) and crosslinking agent (X1) for Comparative Examples are as follows.

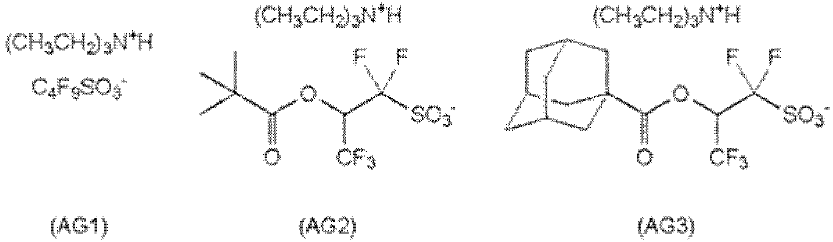

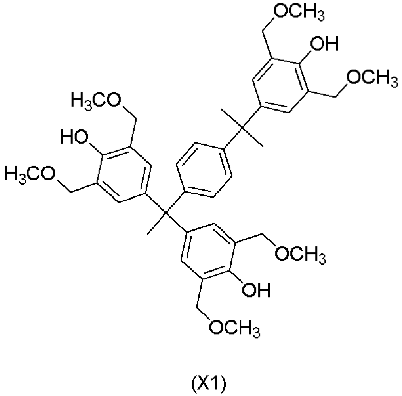

### [Solvent resistance and optical constant measurement (Examples 1-1 to 1-14 and Comparative Examples 1-1 to 1-8)]

The solvent resistance was evaluated by coating a silicon substrate with each of resist underlayer film materials (UDL-1 to 14 and Comparative Example UDL-1 to 8) prepared above, baking such each film material at a temperature described in Table **2,** for 60 seconds, then measuring the thickness, dispensing a PGMEA solvent thereon, leaving the resultant to stand for 30 seconds, subjecting the resultant to spin drying and baking at 100°C for 60 seconds, to evaporate the PGMEA solvent, and measuring the thickness again, to determine the difference in thickness before and after PGMEA treatment. Table 2 below also shows optical constants (refractive index **n,** extinction coefficient k) at a wavelength of 193 nm of a resist underlayer film after film formation, as determined with a spectroscopic ellipsometer (VASE) in which the incident angle is variable, manufactured by **J.A.** Woollam.

**[Table 2]**

| Example | Composition | Thickness after film formation | Thickne ss after solvent treatme nt | b/a×100 | Baking temperature | n/k |
|---|---|---|---|---|---|---|
| | | a(Å) | b(A) | (%) | °C | 248nm |
| Example 1-1 | UDL-1 | 2052 | 2051 | 100.0% | 250 | 1.54/0.16 |
| Example 1-2 | UDL-2 | 2049 | 2049 | 100.0% | 250 | 1.55/0.21 |
| Example 1-3 | UDL-3 | 2053 | 2052 | 100.0% | 250 | 1.54/0.23 |
| Example 1-4 | UDL-4 | 2055 | 2053 | 99.9% | 250 | 1.53/0.23 |
| Example 1-5 | UDL-5 | 2050 | 2048 | 99.9% | 250 | 1.53/0.17 |
| Example 1-6 | UDL-6 | 2051 | 2050 | 100.0% | 250 | 1.52/0.21 |
| Example 1-7 | UDL-7 | 2045 | 2044 | 100.0% | 250 | 1.54/0.29 |
| Example 1-8 | UDL-8 | 2043 | 2042 | 100.0% | 250 | 1.55/0.21 |
| Example 1-9 | UDL-9 | 2017 | 2017 | 100.0% | 250 | 1.52/0.30 |
| Example 1-10 | UDL-10 | 2022 | 2021 | 100.0% | 250 | 1.53/0.28 |
| Example 1-11 | UDL-11 | 2031 | 2030 | 100.0% | 250 | 1.57/0.30 |
| Example 1-12 | UDL-12 | 2046 | 2026 | 99.0% | 250 | 1.53/0.29 |
| Example 1-13 | UDL-13 | 2043 | 2043 | 100.0% | 250 | 1.54/0.14 |
| Example 1-14 | UDL-14 | 2059 | 2057 | 99.9% | 250 | 1.47/0.38 |
| Comparative Example 1-1 | Comparative Example UDL-1 | 2038 | 2035 | 99.9% | 250 | 1.55/0.00 |
| Comparative Example 1-2 | Comparative Example UDL-2 | 2020 | 2019 | 100.0% | 250 | 1.55/0.15 |
| Comparative Example 1-3 | Comparative Example UDL-3 | 2045 | 2043 | 99.9% | 250 | 1.78/0.25 |
| Comparative Example 1-4 | Comparative Example UDL-4 | 2028 | 2004 | 98.8% | 250 | 1.50/0.26 |
| Comparative Example 1-5 | Comparative Example UDL-5 | 2030 | 2030 | 100.0% | 250 | 1.62/0.44 |
| Comparative Example 1-6 | Comparative Example UDL-6 | 2065 | 2063 | 99.9% | 250 | 1.64/0.00 |
| Comparative Example 1-7 | Comparative Example UDL-7 | 2065 | 2063 | 99.9% | 250 | 1.52/0.23 |
| Comparative Example 1-8 | Comparative Example UDL-8 | 2032 | 2030 | 99.9% | 250 | 1.55/0.34 |

It has been found that each of the compositions for forming a resist underlayer film, for the resist underlayer film material of the present invention (each of UDL-1 to 14), is favorable in film formability and also causes almost no film reduction due to solvent treatment and provides a film favorable in solvent resistance. The optical constants, which depend on the thickness, the type of the upper layer film, and the like, exhibit approximately an n value of 1.5 to 1.9 and a k value of 0.1 to 0.5, and therefore light reflected from the substrate can be significantly suppressed and application as an underlayer film for photoresist patterning is possible. It has been found that, in the above Examples, all the optical constants are in suitable ranges and application as a resist underlayer film to photoresist patterning is possible.

### [Dry etching test with N₂/H₂-based gas (Examples 2-1 to 2-14 and Comparative Examples 2-1 to 2-9)]

The resist underlayer film formed as above and the resist upper layer film formed as below were subjected to a dry etching test with a N₂/H₂-based gas. The results were described in Table 4.

A resist upper layer film material (photoresist for ArF) used in patterning was prepared by dissolving a polymer (resin) represented by ArF single-layer resist polymer 1, PAG1 as an acid generator, and amine 1 as a basic compound in a solvent containing 0.1% by mass of FC-4430 (manufactured by 3M) at proportions in Table 3, and filtering the resultant with a 0.1-µm fluororesin filter.

**[Table 3]**

| Resist upper layer film material | Polymer (parts by mass) | Acid generator (parts by mass) | Basic compound (parts by mass) | Solvent (parts by mass) |
|---|---|---|---|---|
| PR-1 | ArF single-layer resist Polymer 1 (100) | PAG1 (8.5) | amine1 (0.6) | PGMEA (1,500) |

ArF single-layer resist polymer 1, PAG1, and amine 1 used are shown below. 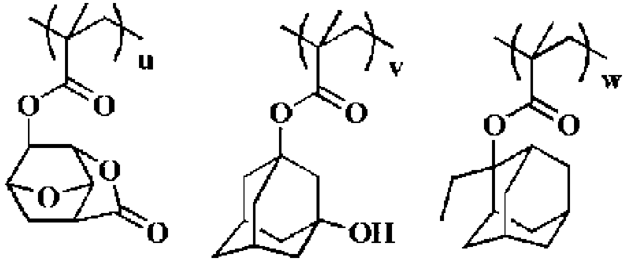
(ArF single-layer resist polymer 1)
(u=0.40, v=0.30, w=0.30, Mw7,800)
#1 ArF single-resist polymer 1

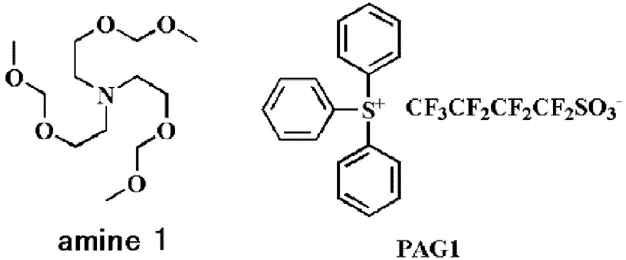

A silicon substrate was coated with the resist upper layer film material (PR-1) prepared above, and the resultant was baked at 120°C for 60 seconds, to form a photoresist film having a thickness of about 200 nm.

The dry etching test with a N₂/H₂-based gas was performed under the following conditions.

Etching conditions

| | |
|---|---|
| Chamber pressure | 2.7 Pa |
| RF power | 1,000 W |
| Flow rate of N₂ gas | 500 mL/min |
| Flow rate of H₂ gas | 30 mL/min |
| Time | 20 sec |

Table 4 shows the dry etching rate determined by dividing the difference in thickness before and after dry etching, as measured with an etching apparatus Telius manufactured by Tokyo Electron Ltd., by the etching time.

**[Table 4]**

| Example | Composition | E/R |
|---|---|---|
| | | nm/min |
| Example 2-1 | UDL-1 | 230 |
| Example 2-2 | UDL-2 | 225 |
| Example 2-3 | UDL-3 | 220 |
| Example 2-4 | UDL-4 | 220 |
| Example 2-5 | UDL-5 | 235 |
| Example 2-6 | UDL-6 | 220 |
| Example 2-7 | UDL-7 | 230 |
| Example 2-8 | UDL-8 | 235 |
| Example 2-9 | UDL-9 | 240 |
| Example 2-10 | UDL-10 | 250 |
| Example 2-11 | UDL-11 | 220 |
| Example 2-12 | UDL-12 | 245 |
| Example 2-13 | UDL-13 | 220 |
| Example 2-14 | UDL-14 | 260 |
| Comparative Example 2-1 | Comparative Example UDL-1 | 185 |
| Comparative Example 2-2 | Comparative Example UDL-2 | 240 |
| Comparative Example 2-3 | Comparative Example UDL-3 | 175 |
| Comparative Example 2-4 | Comparative Example UDL-4 | 200 |
| Comparative Example 2-5 | Comparative Example UDL-5 | 125 |
| Comparative Example 2-6 | Comparative Example UDL-6 | 195 |
| Comparative Example 2-7 | Comparative Example UDL-7 | 210 |
| Comparative Example 2-8 | Comparative Example UDL-8 | 200 |
| Comparative Example 2-9 | PR-1 | 150 |

It has been found from the above results that each of the resist underlayer films, with the resist underlayer film material of the present invention (each of UL-1 to 14), has a high dry etching rate as compared with the resist upper layer film (Comparative Example 2-9). It can be seen that the etching rate is remarkably enhanced as compared with that of Comparative Example 2-1 without crosslinking agents (B1) to (B6) of a specified structure in the present invention. From this, the composition for forming a resist underlayer film of the present invention is preferred because it can allow for suppression of the residue after resist underlayer film removal in particular in a processing process including such resist underlayer film removal by dry etching after substrate processing.

It has been found that, in Comparative Example 2-5, the dry etching rate is low as compared with that of the resist upper layer film and therefore a residue is easily generated in the case of removal of the resist underlayer film by dry etching. It is presumed that, in Comparative Example 2-4 (Comparative Example UDL-4), the etching rate is lowered because of use of polymer compound (R3) containing an anthracene ring as an ultraviolet absorption group in the repeating unit structure.

### [Evaluation of filling characteristics (Examples 3-1 to 3-14 and Comparative Examples 3-1 to 3-8)]

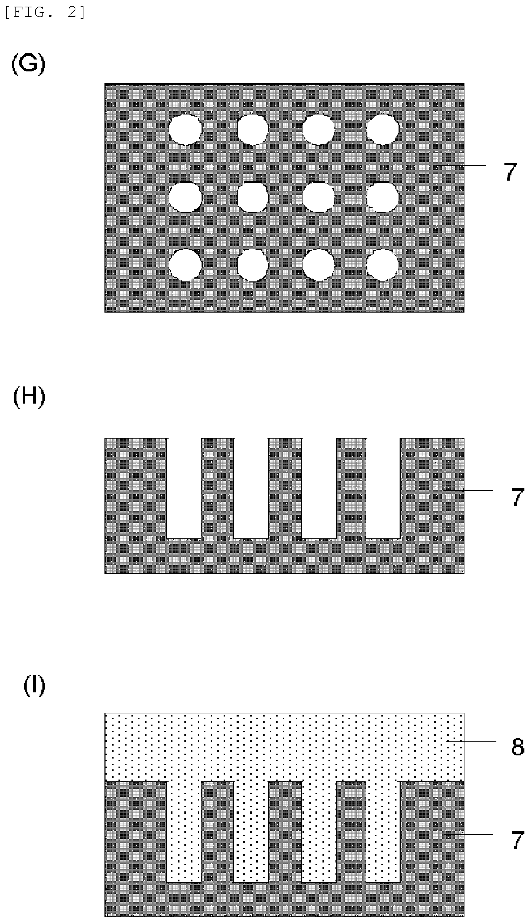

A SiO₂ wafer substrate having a dense hole pattern (hole diameter: 0.16 µm, hole depth: 0.50 µm, distance between the centers of two adjacent holes: 0.32 µm) was coated with each of the compositions for forming a resist underlayer film, and subjected to baking at a temperature of 250°C for 60 seconds, thereby forming a resist underlayer film. The substrate used was an underlying substrate 7 (SiO₂ wafer substrate) having a dense hole pattern as illustrated in FIG. 2(G) (plane view) and (H) (cross-sectional view). Each cross section shape of the wafer substrate obtained was observed with a scanning electron microscope (SEM), and whether or not filling with the resist underlayer film was made without any void (gap) in the hole interior was confirmed. The results are shown in Table 5. In a case where a resist underlayer film material inferior in filling characteristics is used, any void is generated in the hole interior in this evaluation. In a case where a resist underlayer film material favorable in filling characteristics is used, no void is generated in the hole interior and a resist underlayer film 8 is filled in this evaluation, as illustrated in FIG. 2(I).

**[Table 5]**

| Example | Composition | Filling ability |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Comparative Example 3-1 | Comparative Example UDL-1 | Poor |
| Comparative Example 3-2 | Comparative Example UDL-2 | Poor |
| Comparative Example 3-3 | Comparative Example UDL-3 | Poor |
| Comparative Example 3-4 | Comparative Example UDL-4 | Poor |
| Comparative Example 3-5 | Comparative Example UDL-5 | Poor |
| Comparative Example 3-6 | Comparative Example UDL-6 | Poor |
| Comparative Example 3-7 | Comparative Example UDL-7 | Poor |
| Comparative Example 3-8 | Comparative Example UDL-8 | Poor |

It has been found from the above results that a hole pattern can be filled without any void in Examples 3-1 to 3-14, as Examples, using the compositions for forming a resist underlayer film (UDL-1 to 14) each using any of the crosslinking agents (B1) to (B7) within the scope of the formula (B-1) in the present invention. In this regard, any void was observed in Comparative Example 3-1 using the composition for forming a resist underlayer containing no crosslinking agent (Comparative Example UDL-1) and Comparative Examples 3-6 to 3-8 using the compositions for forming resist underlayers

(Comparative Example UDL-6, Comparative Example UDL-7, and Comparative Example UDL-8) each including the crosslinking agent out of the scope of the formula (B-1) in the present invention. It is thus presumed that the crosslinking agent of a specified structure in the present invention contributes to fluidity of the composition for forming a resist underlayer film.

It is presumed that crosslinking agent (B8) has a hydroxyl group and is high in curability, to cause deterioration in heat fluidity during baking. It is presumed that crosslinking agent (B9) has a large number of aromatic structures, to cause deterioration in fluidity of the composition.

In the case of use of each of polymer compounds (R1) to (R4) out of the scope of the formula (A-1) in the present invention, as the component (A), any void was observed even in combination with any of (B1) to (B3) being crosslinking agents within the scope of the formula (B-1) in the present invention, as the component B (compositions for forming a resist underlayer film, Comparative Examples UDL-2 to 5). It is presumed that filling ability is degraded due to low fluidity of each of polymer compounds (R2) to (R4).

Although the detailed mechanism of the above results is not clear, it is presumed that the polymer compound has a structural unit (a1) represented by the formula (A-1) and furthermore at least one structural unit (a2) represented by any of formulae (A-2) to (A-4), thereby resulting in an improvement in fluidity, and furthermore is combined with the crosslinking agent of a specified structure of the formula (B-1), thereby allowing for formation of a resist underlayer film excellent in filling ability.

### [Evaluation of planarization characteristics (Examples 4-1 to 4-14 and Comparative Examples 4-1 to 4-8)]

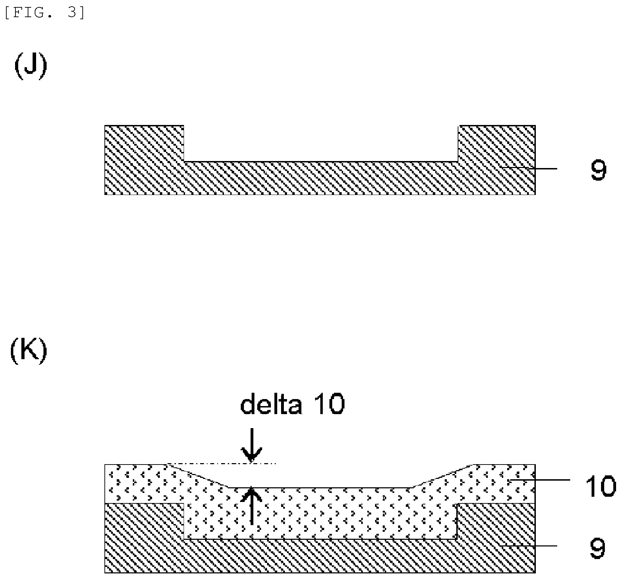

An underlying substrate 9 (SiO₂ wafer substrate) having a large and isolated trench pattern (FIG. 3(J), trench width 10 µm, trench depth 0.1 µm) was coated with each of the compositions for forming a resist underlayer film, and subjected to baking in a condition of 250°C, and thereafter the difference in thickness of a resist underlayer film 10 (delta 10 in FIG. 3(K)) between a trench portion and a non-trench portion was observed with an atomic force microscope (AFM). The results are shown in Table 6. It can be said in this evaluation that, as the difference in thickness is smaller, planarization characteristics are more favorable.

**[Table 6]**

| Example | Composition | Planeness |
|---|---|---|
| | | ΔA |
| Example 4-1 | UDL-1 | 50 |
| Example 4-2 | UDL-2 | 50 |
| Example 4-3 | UDL-3 | 45 |
| Example 4-4 | UDL-4 | 45 |
| Example 4-5 | UDL-5 | 45 |
| Example 4-6 | UDL-6 | 55 |
| Example 4-7 | UDL-7 | 60 |
| Example 4-8 | UDL-8 | 45 |
| Example 4-9 | UDL-9 | 40 |
| Example 4-10 | UDL-10 | 40 |
| Example 4-11 | UDL-11 | 50 |
| Example 4-12 | UDL-12 | 40 |
| Example 4-13 | UDL-13 | 50 |
| Example 4-14 | UDL-14 | 35 |
| Comparative Example 4-1 | Comparative Example UDL-1 | 70 |
| Comparative Example 4-2 | Comparative Example UDL-2 | 65 |
| Comparative Example 4-3 | Comparative Example UDL-3 | 90 |
| Comparative Example 4-4 | Comparative Example UDL-4 | 75 |
| Comparative Example 4-5 | Comparative Example UDL-5 | 110 |
| Comparative Example 4-6 | Comparative Example UDL-6 | 70 |
| Comparative Example 4-7 | Comparative Example UDL-7 | 85 |
| Comparative Example 4-8 | Comparative Example UDL-8 | 100 |

It has been found from the above results that the composition for forming a resist underlayer film of the present invention (each of UDL-1 to 14) exhibits a small difference in thickness of the resist underlayer film between a trench portion and a non-trench portion and is excellent in planarization characteristics as compared with the composition for forming a resist underlayer film of each of Comparative Examples (each of Comparative Examples UDL-1 to 8).

In view of the structure of the crosslinking agent, the compositions for forming a resist underlayer film (Examples UDL-3 to 5) including crosslinking agents (B3 to B5) each having an unsaturated carbon bond being not aromatic exhibited excellent planarization characteristics.

On the contrary, the compositions for forming a resist underlayer (Comparative Example UDL-2 to Comparative Example UDL-5) including polymer compounds (R1) to (R4) for comparison as the component (A) were inferior in planarization characteristics. It is presumed that each of (R2) to (R4) includes an aromatic ring in a repeating unit structure and thus is reduced in fluidity.

In addition, the results of planarization characteristics were insufficient in Comparative Examples including the composition for forming a resist underlayer not including any crosslinking agent corresponding to the component (B) (Comparative Example UDL-1), and Comparative Example UDL-6, Comparative Example UDL-7, and Comparative Example UDL-8 that are the compositions for forming a resist underlayer film using crosslinking agents (X1), (B8), and (B9), respectively, out of the scope of the formula (B-1) in the present invention, as the component (B). It is presumed that the crosslinking agent is high in curability to cause deterioration in heat fluidity during baking and degradation in planeness.

### [Evaluation of resistance to alkaline hydrogen peroxide water (Examples 5-1 to 5-14 and Comparative Examples 5-1 to 5-4)]

A film of the resist underlayer film material was formed on a silicon wafer cut to 3-cm square so as to have a thickness of about 100 nm, according to baking conditions at 250°C. This wafer piece was immersed in 1.0% by mass hydrogen peroxide water containing 0.5% by mass of ammonia at 70°C for 5 minutes, and subsequently rinsed with deionized water, and thereafter the presence of stripping of the resist underlayer film from the wafer was visually examined. In a case where one portion or the entire of the resist underlayer film is stripped and a silicon wafer surface is exposed, the resist underlayer film subjected to the test is determined to be insufficient in resistance to alkaline hydrogen peroxide water. The results are shown in Table 7.

**[Table 7]**

| Example | Composition | Examination results at 70°C for 5 min |
|---|---|---|
| Example 5-1 | UDL-1 | Not stripped |
| Example 5-2 | UDL-2 | Not stripped |
| Example 5-3 | UDL-3 | Not stripped |
| Example 5-4 | UDL-4 | Not stripped |
| Example 5-5 | UDL-5 | Not stripped |
| Example 5-6 | UDL-6 | Not stripped |
| Example 5-7 | UDL-7 | Not stripped |
| Example 5-8 | UDL-8 | Not stripped |
| Example 5-9 | UDL-9 | Not stripped |
| Example 5-10 | UDL-10 | Not stripped |
| Example 5-11 | UDL-11 | Not stripped |
| Example 5-12 | UDL-12 | Not stripped |
| Example 5-13 | UDL-13 | Not stripped |
| Example 5-14 | UDL-14 | Not stripped |
| Comparative Example 5-1 | Comparative Example UDL-1 | Fully stripped |
| Comparative Example 5-2 | Comparative Example UDL-2 | Fully stripped |
| Comparative Example 5-3 | Comparative Example UDL-3 | Fully stripped |
| Comparative Example 5-4 | Comparative Example UDL-4 | Fully stripped |

It has been found from the above results that the resist underlayer film materials (UDL-1 to 14) of Examples are excellent in resistance to alkaline hydrogen peroxide as compared with the resist underlayer film materials of Comparative Examples (Comparative UDL-1 to 4).

It has been revealed from the foregoing that the composition for forming a resist underlayer film, the patterning process, and the resist underlayer film formation process of the present invention can be suitably used in a multi-layer resist process for fine patterning in semiconductor device manufacturing, in particular, allow not only an antireflective function, but also favorable resistance to alkaline hydrogen peroxide water, excellent filling/planarization characteristics, and excellent dry etching characteristics to be exhibited, and therefore can also be applied to a multi-layer resist process including wet etching processing, and/or an ion implantation step, and are extremely industrially useful.

The present description includes the following inventions.
[1]: A composition for forming a resist underlayer film, the composition comprising:
   (A) a polymer compound having a structural unit (a1) represented by the following formula (A-1) and at least one structural unit (a2) selected from structural units represented by the following formulae (A-2) to (A-4);
   (B) a crosslinking agent represented by the following formula (B-1); and
   (C) an organic solvent; 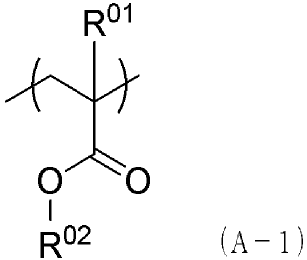 wherein R⁰¹ is a hydrogen atom or a methyl group, and R⁰² is a monovalent organic group containing a group selected from groups represented by the following formulae (R₂-1) to (R₂-3); 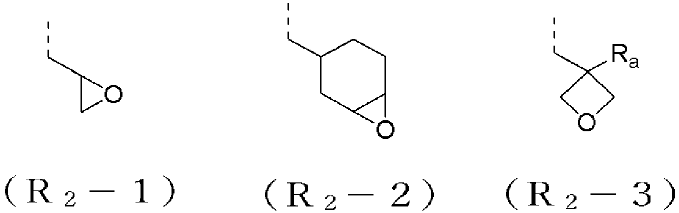 wherein Rₐ is a hydrogen atom or an alkyl group having 1 to 10 carbon atoms, and a dotted line represents a bond; 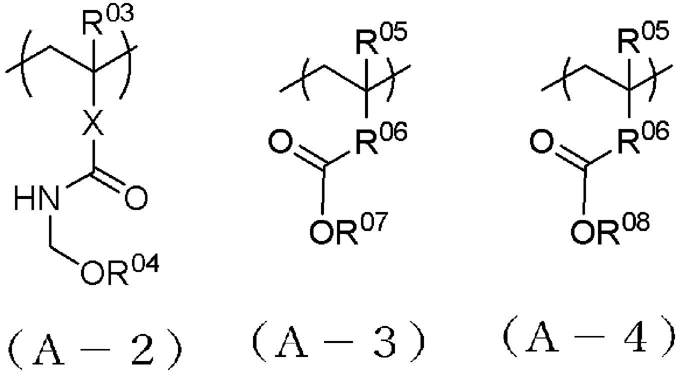 wherein, in the formula (A-2), X is an aromatic ring having 6 to 20 carbon atoms or a single bond, R⁰³ is a hydrogen atom or a methyl group, and R⁰⁴ is a hydrogen atom or a monovalent alkyl group having 1 to 10 carbon atoms and, when R⁰⁴ is the alkyl group, a hydrogen atom constituting the alkyl group is optionally replaced by a hydroxyl group; in the formula (A-3), R⁰⁵ is a hydrogen atom or a methyl group, R⁰⁶ is a single bond or a divalent linkage group containing an ester group and having 2 to 10 carbon atoms, and R⁰⁷ is a tertiary alkyl group having 4 to 20 carbon atoms or a tertiary alkenyl group having 5 to 20 carbon atoms; and in the formula (A-4), R⁰⁵ and R⁰⁶ have the same meanings as those in the formula (A-3), and R⁰⁸ is a hydrogen atom or a monovalent primary alkyl group having 1 to 10 carbon atoms; 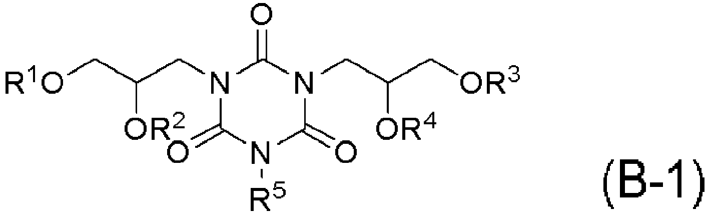 wherein R⁵ represents a methyl group, an ethyl group, a propyl group, an allyl group, a propargyl group or a group represented by the following (B-2), and R¹ and R³ each represent a benzoyl group, a toluoyl group, a naphthoyl group or an anthranoyl group; and R² and R⁴ each represent a hydrogen atom, an acetyl group, an acryloyl group or a methacryloyl group; and 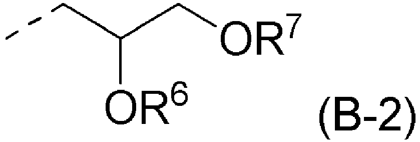 wherein R⁷ represents a benzoyl group, a toluoyl group, a naphthoyl group or an anthranoyl group; and R⁶ represents a hydrogen atom, an acetyl group, an acryloyl group or a methacryloyl group and, when R² and R⁴ are hydrogen atoms, R⁶ is also a hydrogen atom.
[2]: The composition for forming a resist underlayer film according to [1], wherein two or more of R¹, R³, and R⁷ in the formula (B-1) are each a naphthoyl group or an anthranoyl group.
[3]: The composition for forming a resist underlayer film according to [1] or [2], wherein any of R², R⁴, and R⁵ in the formula (B-1) has an unsaturated bond which is not aromatic.
[4]: The composition for forming a resist underlayer film according to any one of claims [1] to [3], wherein a content of the (B) crosslinking agent in the composition for forming a resist underlayer film is in a range of 1 to 50 parts by mass based on 100 parts by mass of the (A) polymer compound.
[5]: The composition for forming a resist underlayer film according to any one of [1] to [4], wherein the (A) polymer compound has a structural unit (a1) represented by the formula (A-1) and at least two structural units (a2) selected from structural units represented by the formulae (A-2) to (A-4).
[6]: The composition for forming a resist underlayer film according to any one of [1] to [5], wherein a content rate of the structural unit (a1) is 20% by mol or more and 90% by mol or less and a content rate of a total amount of the structural units (a2) is 10% by mol or more and 80% by mol or less relative to all repeating units in the (A) polymer compound.
[7]: The composition for forming a resist underlayer film according to any one of [1] to [6], wherein a weight average molecular weight of the (A) polymer compound is 1,000 to 20,000.
[8]: The composition for forming a resist underlayer film according to any one of [1] to [7], wherein a dispersity represented by weight average molecular weight/number average molecular weight of the (A) polymer compound is 3.0 or less.
[9]: The composition for forming a resist underlayer film according to any one of [1] to [8], wherein the composition contains at least one selected from (D) an acid generator and (E) a surfactant.
[10]: The composition for forming a resist underlayer film according to any one of [1] to [9], wherein the composition for forming a resist underlayer film provides a resist underlayer film exhibiting resistance to ammonia-containing hydrogen peroxide water.
[11]: A patterning process on a substrate to be processed, the process comprising the steps of:
   (I-1) applying the composition for forming a resist underlayer film according to any one of [1] to [10] to the substrate to be processed, and thereafter performing heat treatment, to form a resist underlayer film;
   (I-2) forming a resist upper layer film on the resist underlayer film using a composition for forming a resist upper layer film;
   (I-3) subjecting the resist upper layer film to patten exposure and then development with a developer, to form a circuit pattern on the resist upper layer film; and
   (I-4) transferring a pattern by dry etching to the resist underlayer film using a resist upper layer film on which the circuit pattern is formed as a mask.
[12]: A patterning process on a substrate to be processed, the process comprising the steps of:
   (II-1) applying the composition for forming a resist underlayer film according to any one of [1] to [10] to the substrate to be processed, and thereafter performing heat treatment, to form a resist underlayer film;
   (II-2) forming a silicon atom-containing resist middle layer film on the resist underlayer film;
   (II-3) forming a resist upper layer film on the silicon atom-containing resist middle layer film using a composition for forming a resist upper layer film;
   (II-4) subjecting the resist upper layer film to patten exposure and then development with a developer, to form a circuit pattern on the resist upper layer film;
   (II-5) transferring a pattern by dry etching to the silicon atom-containing resist middle layer film using a resist upper layer film on which the circuit pattern is formed as a mask; and
   (II-6) transferring a pattern by dry etching to the resist underlayer film using a silicon atom-containing resist middle layer film to which the pattern is transferred as a mask.
[13]: A patterning process on a substrate to be processed, the process comprising the steps of:
   (III-1) applying the composition for forming a resist underlayer film according to any one of [1] to [10] to the substrate to be processed, and thereafter performing heat treatment, to form a resist underlayer film;
   (III-2) forming an inorganic hard mask selected from a silicon oxide film, a silicon nitride film, and a silicon oxynitride film, on the resist underlayer film;
   (III-3) forming an organic antireflective film on the inorganic hard mask;
   (III-4) forming a resist upper layer film on the organic antireflective film using a composition for forming a resist upper layer film;
   (III-5) subjecting the resist upper layer film to patten exposure and then development with a developer, to form a circuit pattern on the resist upper layer film;
   (III-6) transferring a pattern by dry etching to the organic antireflective film and the inorganic hard mask using a resist upper layer film on which the circuit pattern is formed as a mask; and
   (III-7) transferring a pattern by dry etching to the resist underlayer film using an inorganic hard mask to which the pattern is transferred as a mask.
[14]: The patterning process according to any one of [11] to [13], the process further comprising a step of transferring a pattern, by wet etching with alkaline hydrogen peroxide water, to the substrate to be processed using a resist underlayer film to which the pattern is transferred as a mask, after the step (I-4), the step (II-6), or the step (III-7).
[15]: The patterning process according to any one of [11] to [13], the process further comprising a step of performing a ion implantation using a resist underlayer film to which the pattern is transferred as a mask, to perform pattern-processing of the substrate to be processed, after the step (I-4), the step (II-6), or the step (III-7).
[16]: The patterning process according to any one of [11] to [13], wherein a composition for forming a resist underlayer film having a dry etching rate higher than a dry etching rate of the resist upper layer film is used as the composition for forming a resist underlayer film.
[17]: The patterning process according to any one of any one of [11] to [13], wherein a substrate which has a structure body or a stepped section having a height of 30 nm or more is used as the substrate to be processed.
[18]: A process for forming a resist underlayer film for use in a process for manufacturing a semiconductor device, the process comprising
   spin-coating a substrate to be processed, with the composition for forming a resist underlayer film according to any one of [1] to [10], and
   heat-treating the substrate coated with the composition for forming a resist underlayer film, at a temperature of 100°C or more and 300°C or less for a period in a range of 10 to 600 seconds, to form a resist underlayer film.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A composition for forming a resist underlayer film, the composition comprising:
(A) a polymer compound having a structural unit (a1) represented by the following formula (A-1) and at least one structural unit (a2) selected from structural units represented by the following formulae (A-2) to (A-4);
(B) a crosslinking agent represented by the following formula (B-1); and
(C) an organic solvent; 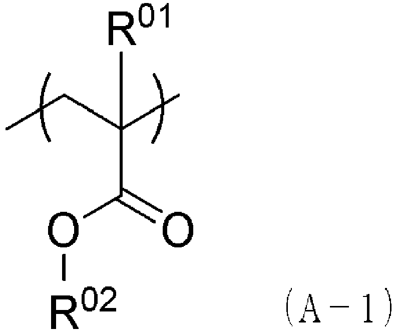 wherein R⁰¹ is a hydrogen atom or a methyl group, and R⁰² is a monovalent organic group containing a group selected from groups represented by the following formulae (R₂-1) to (R₂-3); 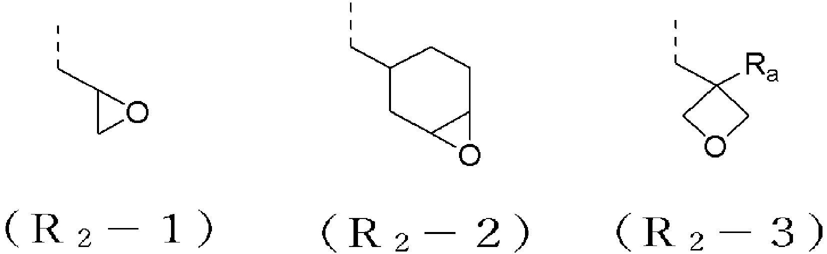 wherein Rₐ is a hydrogen atom or an alkyl group having 1 to 10 carbon atoms, and a dotted line represents a bond; 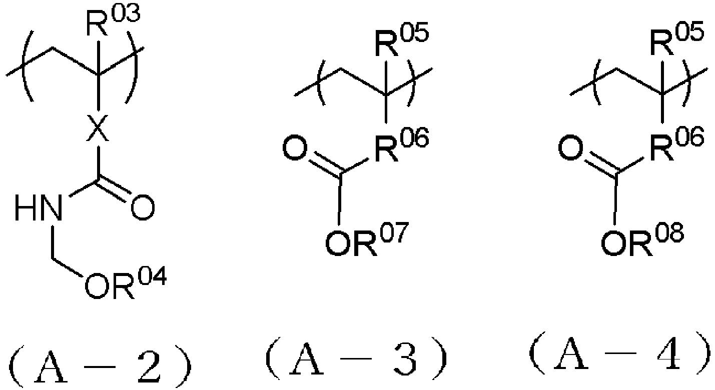 wherein, in the formula (A-2), X is an aromatic ring having 6 to 20 carbon atoms or a single bond, R⁰³ is a hydrogen atom or a methyl group, and R⁰⁴ is a hydrogen atom or a monovalent alkyl group having 1 to 10 carbon atoms and, when R⁰⁴ is the alkyl group, a hydrogen atom constituting the alkyl group is optionally replaced by a hydroxyl group; in the formula (A-3), R⁰⁵ is a hydrogen atom or a methyl group, R⁰⁶ is a single bond or a divalent linkage group containing an ester group and having 2 to 10 carbon atoms, and R⁰⁷ is a tertiary alkyl group having 4 to 20 carbon atoms or a tertiary alkenyl group having 5 to 20 carbon atoms; and in the formula (A-4), R⁰⁵ and R⁰⁶ have the same meanings as those in the formula (A-3), and R⁰⁸ is a hydrogen atom or a monovalent primary alkyl group having 1 to 10 carbon atoms; 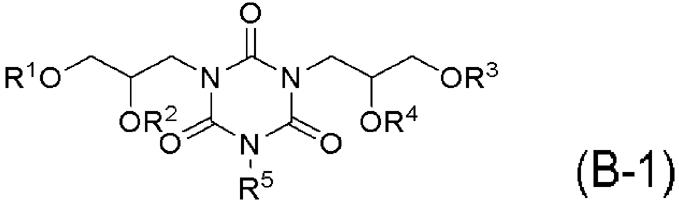 wherein R⁵ represents a methyl group, an ethyl group, a propyl group, an allyl group, a propargyl group or a group represented by the following (B-2), and R¹ and R³ each represent a benzoyl group, a toluoyl group, a naphthoyl group or an anthranoyl group; and R² and R⁴ each represent a hydrogen atom, an acetyl group, an acryloyl group or a methacryloyl group; and 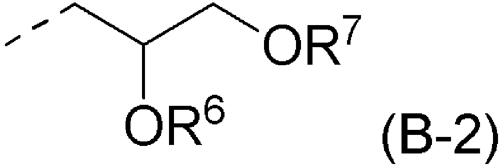 wherein R⁷ represents a benzoyl group, a toluoyl group, a naphthoyl group or an anthranoyl group; and R⁶ represents a hydrogen atom, an acetyl group, an acryloyl group or a methacryloyl group and, when R² and R⁴ are hydrogen atoms, R⁶ is also a hydrogen atom.

2. The composition for forming a resist underlayer film according to claim 1, wherein two or more of R¹, R³, and R⁷ in the formula (B-1) are each a naphthoyl group or an anthranoyl group.

3. The composition for forming a resist underlayer film according to claim 1 or 2, wherein any of R², R⁴, and R⁵ in the formula (B-1) has an unsaturated bond which is not aromatic.

4. The composition for forming a resist underlayer film according to any one of claims 1 to 3, wherein a content of the (B) crosslinking agent in the composition for forming a resist underlayer film is in a range of 1 to 50 parts by mass based on 100 parts by mass of the (A) polymer compound.

5. The composition for forming a resist underlayer film according to any one of claims 1 to 4, wherein the (A) polymer compound has a structural unit (a1) represented by the formula (A-1) and at least two structural units (a2) selected from structural units represented by the formulae (A-2) to (A-4).

6. The composition for forming a resist underlayer film according to any one of claims 1 to 5, wherein a content rate of the structural unit (a1) is 20% by mol or more and 90% by mol or less and a content rate of a total amount of the structural units (a2) is 10% by mol or more and 80% by mol or less relative to all repeating units in the (A) polymer compound.

7. The composition for forming a resist underlayer film according to any one of claims 1 to 6, wherein a weight average molecular weight of the (A) polymer compound is 1,000 to 20,000.

8. The composition for forming a resist underlayer film according to any one of claims 1 to 7, wherein a dispersity represented by weight average molecular weight/number average molecular weight of the (A) polymer compound is 3.0 or less.

9. The composition for forming a resist underlayer film according to any one of claims 1 to 8, wherein the composition contains at least one selected from (D) an acid generator and (E) a surfactant.

10. The composition for forming a resist underlayer film according to any one of claims 1 to 9, wherein the composition for forming a resist underlayer film provides a resist underlayer film exhibiting resistance to ammonia-containing hydrogen peroxide water.

11. A patterning process on a substrate to be processed, the process comprising the steps of:
(I-1) applying the composition for forming a resist underlayer film according to any one of claims 1 to 10 to the substrate to be processed, and thereafter performing heat treatment, to form a resist underlayer film;
(I-2) forming a resist upper layer film on the resist underlayer film using a composition for forming a resist upper layer film;
(I-3) subjecting the resist upper layer film to patten exposure and then development with a developer, to form a circuit pattern on the resist upper layer film; and
(I-4) transferring a pattern by dry etching to the resist underlayer film using a resist upper layer film on which the circuit pattern is formed as a mask, or
a patterning process on a substrate to be processed, the process comprising the steps of:
(II-1) applying the composition for forming a resist underlayer film according to any one of claims 1 to 10 to the substrate to be processed, and thereafter performing heat treatment, to form a resist underlayer film;
(II-2) forming a silicon atom-containing resist middle layer film on the resist underlayer film;
(II-3) forming a resist upper layer film on the silicon atom-containing resist middle layer film using a composition for forming a resist upper layer film;
(II-4) subjecting the resist upper layer film to patten exposure and then development with a developer, to form a circuit pattern on the resist upper layer film;
(II-5) transferring a pattern by dry etching to the silicon atom-containing resist middle layer film using a resist upper layer film on which the circuit pattern is formed as a mask; and
(II-6) transferring a pattern by dry etching to the resist underlayer film using a silicon atom-containing resist middle layer film to which the pattern is transferred as a mask, or
a patterning process on a substrate to be processed, the process comprising the steps of:
(III-1) applying the composition for forming a resist underlayer film according to any one of claims 1 to 10 to the substrate to be processed, and thereafter performing heat treatment, to form a resist underlayer film;
(III-2) forming an inorganic hard mask selected from a silicon oxide film, a silicon nitride film, and a silicon oxynitride film, on the resist underlayer film;
(III-3) forming an organic antireflective film on the inorganic hard mask;
(III-4) forming a resist upper layer film on the organic antireflective film using a composition for forming a resist upper layer film;
(III-5) subjecting the resist upper layer film to patten exposure and then development with a developer, to form a circuit pattern on the resist upper layer film;
(III-6) transferring a pattern by dry etching to the organic antireflective film and the inorganic hard mask using a resist upper layer film on which the circuit pattern is formed as a mask; and
(III-7) transferring a pattern by dry etching to the resist underlayer film using an inorganic hard mask to which the pattern is transferred as a mask.

12. The patterning process according to claim 11, the process further comprising a step of transferring a pattern, by wet etching with alkaline hydrogen peroxide water, to the substrate to be processed using a resist underlayer film to which the pattern is transferred as a mask, after the step (I-4), the step (II-6), or the step (III-7).

13. The patterning process according to claim 11, the process further comprising a step of performing a ion implantation using a resist underlayer film to which the pattern is transferred as a mask, to perform pattern-processing of the substrate to be processed, after the step (I-4), the step (II-6), or the step (III-7).

14. The patterning process according to claim 11,
wherein a composition for forming a resist underlayer film having a dry etching rate higher than a dry etching rate of the resist upper layer film is used as the composition for forming a resist underlayer film, and/or
the patterning process according to claim 11,
wherein a substrate which has a structure body or a stepped section having a height of 30 nm or more is used as the substrate to be processed.

15. A process for forming a resist underlayer film for use in a process for manufacturing a semiconductor device, the process comprising
spin-coating a substrate to be processed, with the composition for forming a resist underlayer film according to any one of claims 1 to 10, and
heat-treating the substrate coated with the composition for forming a resist underlayer film, at a temperature of 100°C or more and 300°C or less for a period in a range of 10 to 600 seconds, to form a resist underlayer film.
